(19) **Europäisches Patentamt / European Patent Office / Office européen des brevets**

(11) **EP 4 542 893 A1**

(12) **EUROPEAN PATENT APPLICATION**
published in accordance with Art. 153(4) EPC

(43) Date of publication:
**23.04.2025 Bulletin 2025/17**

(21) Application number: **23834681.1**

(22) Date of filing: **28.06.2023**

(51) International Patent Classification (IPC):
**H04L 1/00** (2006.01)

(52) Cooperative Patent Classification (CPC):
**H04L 1/00; H04L 5/00**

(86) International application number:
**PCT/CN2023/103235**

(87) International publication number:
**WO 2024/007913 (11.01.2024 Gazette 2024/02)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **08.07.2022 CN 202210806852**

(71) Applicant: **Huawei Technologies Co., Ltd.
Shenzhen, Guangdong 518129 (CN)**

(72) Inventors:
• **LIU, Xiaoqing
Shenzhen, Guangdong 518129 (CN)**

• **LIU, Jianghua
Shenzhen, Guangdong 518129 (CN)**
• **YU, Zheng
Shenzhen, Guangdong 518129 (CN)**
• **ZHANG, Yongping
Shenzhen, Guangdong 518129 (CN)**
• **ZHANG, Zhening
Shenzhen, Guangdong 518129 (CN)**

(74) Representative: **Maiwald GmbH
Engineering
Elisenhof
Elisenstrasse 3
80335 München (DE)**

(54) **SIGNAL TRANSMISSION METHOD AND COMMUNICATION APPARATUS**

(57) This application provides a signal transmission method and a communication apparatus, to indicate, to a receive device (for example, a terminal device), a code length of a mask (for example, a TD-OCC or an FD-OCC) corresponding to a reference signal (for example, a downlink DMRS). The code length of the mask is included in a first value set, and the first value set includes one or more of the following values: 2, 3, 4, 6, and 8. In this way, it is ensured that the receive device is definite about the length of the mask used for the reference signal, so that the receive device can use a proper hardware implementation method (for example, a reference signal decoding or filtering method), to obtain a better demodulation effect when different reference signal ports are multiplexed, and improve reference signal transmission efficiency.

Method 600

Network device ——— Terminal device

S610: Send first information, where the first information includes a first field, the first field is used to determine a code length of a first mask, the code length of the first mask is included in a first value set, and the first value set includes one or more of the following values: 2, 3, 4, 6, and 8

S620: Determine a reference signal based on the first mask

S630: Send the reference signal

S640: Receive, based on the code length of the first mask used for the reference signal, the reference signal on a port corresponding to a port number of the reference signal

FIG. 6

## Description

This application claims priority to Chinese Patent Application No. 202210806852.4, filed with the China National Intellectual Property Administration on July 8, 2022 and entitled "SIGNAL TRANSMISSION METHOD AND COMMUNICATION APPARATUS", which is incorporated herein by reference in its entirety.

## TECHNICAL FIELD

This application relates to the communication field, and more specifically, to a signal transmission method and a communication apparatus.

## BACKGROUND

One objective of demodulation reference signal (demodulation reference signal, DMRS) enhancement proposed in a multiple-input multiple-output (multiple-input multiple-output, MIMO) topic of 3rd Generation Partnership Project Release-18 (3GPP Rel-18) is: A quantity of orthogonal DMRS ports is increased to 24 without increasing DMRS overheads. For each DMRS type, both a maximum quantity of orthogonal ports for a single-symbol DMRS and a maximum quantity of orthogonal ports for a double-symbol DMRS are doubled.

For example, before DMRS port extension, an orthogonal cover code (orthogonal cover code, OCC) with a length of 2 is used. For a single-symbol type-1 DMRS, multiplexing of a maximum of four orthogonal ports, namely, a port (port number) 1000 to a port 1003, is supported. For a double-symbol type-1 DMRS, multiplexing of a maximum of eight orthogonal ports, namely, a port 1000 to a port 1007, is supported. For a single-symbol type-2 DMRS, multiplexing of a maximum of six orthogonal ports, namely, a port 1000 to a port 1005, is supported. For a double-symbol type-2 DMRS, multiplexing of a maximum of 12 orthogonal ports, namely, a port 1000 to a port 1011, is supported.

After an OCC with a length of 4 is used for DMRS port extension, for the single-symbol type-1 DMRS, multiplexing of a maximum of eight orthogonal ports, including the original port 1000 to port 1003 and four new ports obtained through extension, is supported. For the double-symbol type-1 DMRS, multiplexing of a maximum of 16 orthogonal ports, including the original port 1000 to port 1007 and eight new ports obtained through extension, is supported. For the single-symbol type-2 DMRS, multiplexing of a maximum of 12 orthogonal ports, including the original port 1000 to port 1005 and six new ports obtained through extension, is supported. For the double-symbol type-2 DMRS, multiplexing of a maximum of 24 orthogonal ports, including the original port 1000 to port 1011 and 12 new ports obtained through extension, is supported.

For a device (for example, a terminal device) that supports both the OCC with the code length of 2 and the OCC with the code length of 4, for the double-symbol type-1 DMRS, if the terminal device determines that final DMRS port numbers are 1000 to 1007, the terminal device does not know whether a code length of an OCC corresponding to the DMRS ports 1000 to 1007 is 2 or 4. Consequently, a behavior of the terminal device is not definite. For example, the terminal device does not determine a hardware implementation method (for example, a DMRS decoding or filtering method) to be used to parse a DMRS. Consequently, the DMRS may fail to be parsed, and communication efficiency is affected.

## SUMMARY

This application provides a signal transmission method and a communication apparatus, to ensure that a receive device is definite about a length of a mask used for a reference signal when the receive device supports masks with different code lengths, so that the receive device can use a proper hardware implementation method (for example, a reference signal decoding or filtering method), to obtain a better demodulation effect when different reference signal ports are multiplexed, and improve reference signal transmission efficiency.

According to a first aspect, a signal transmission method is provided. The method includes: A terminal device receives first information. The first information includes a first field, the first field is used to determine a code length of a first mask, the code length of the first mask is included in a first value set, and the first value set includes one or more of the following values: 2, 3, 4, 6, and 8. The terminal device determines a reference signal based on the first mask. The terminal device receives or sends the reference signal.

According to the signal transmission method provided in the first aspect, the code length of the mask corresponding to the reference signal is indicated to the terminal device, to ensure that the terminal device is definite about the length of the mask used for the reference signal, so that a receive device may use a proper hardware implementation method (for example, a reference signal decoding or filtering method), to obtain a better demodulation effect when different reference signal ports are multiplexed, and improve reference signal transmission efficiency.

For example, the first mask is an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The code length of the first mask that is indicated by the first information is a value in the first value set.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

In a possible implementation of the first aspect, the first field is further used to determine a reference signal port number; or the first information further includes a second field, and the second field is used to determine a reference signal port number. The method further includes: The terminal device determines the reference signal port number based on the first field or the second field. In this implementation, the terminal device can be definite about a code length of an FD-OCC used for a DMRS and a DMRS port number, to use a proper hardware implementation method (for example, a reference signal decoding or filtering method). In this way, a better demodulation effect is obtained when different DMRSs are multiplexed, and reference signal transmission efficiency is improved. In addition, dynamic signaling is saved, and utilization of communication resources is improved.

In a possible implementation of the first aspect, the first field or the second field indicates an offset value of the reference signal port number, where the offset value belongs to a second value set, and the second value set includes one or more of the following values: 0, 4, 6, 8, and 12; or a value set to which a port number of the reference signal belongs. In this implementation, the value set to which the reference signal port number belongs is indicated to the terminal device, so that a length (quantity of bits) of dynamic signaling (for example, the first information) can be reduced, to reduce signaling overheads. The offset value of the reference signal port number is indicated to the terminal device, so that a quantity of pieces of antenna port correspondence (mapping) information that needs to be stored by the terminal device can be reduced, to reduce a storage amount and processing complexity that are of the terminal device. In addition, the length (quantity of bits) of the dynamic signaling (for example, the first information) may be further reduced, to reduce the signaling overheads.

In a possible implementation of the first aspect, offset values of reference signal port numbers corresponding to at least two bit states in a bit status of the first field are the same; or port numbers of reference signals corresponding to at least two bit states in a bit status of the first field belong to a same value set.

For example, for a type-2 DMRS, an offset value of the DMRS port number belongs to the second value set, and the second value set includes one or more of the following values: 0, 6, and 12. For example, the second value set is {0, 12}. Alternatively, the second value set is {0, 6}, or the second value set is {6, 12}, or the second value set is {0, 6, 12}.

For example, for a type-1 DMRS, an offset value of the DMRS port number belongs to the second value set, and the second value set includes one or more of the following values: 0, 4, and 8. For example, the second value set is {0, 4}. Alternatively, the second value set is {0, 8}, or the second value set is {4, 8}, or the second value set is {0, 4, 8}.

For example, the offset value being 0 indicates no offset. To be specific, the port number is a DMRS port number indicated by an antenna port field.

In a possible implementation of the first aspect, the bit status of the first field includes at least one of the following bit states: a first bit state, indicating that the code length of the first mask is a first code length, and the offset value of the reference signal port number is a first offset value; a second bit state, indicating that the code length of the first mask is a second code length, and the offset value of the reference signal port number is a first offset value; or a third bit state, indicating that the code length of the first mask is a second code length, and the offset value of the reference signal port number is a second offset value.

For example, for the type-1 DMRS, the first code length is 2, the second code length is 4, the first offset value is 0, and the second offset value is 8.

For example, for the type-2 DMRS, the first code length is 2, the second code length is 4, the first offset value is 0, and the second offset value is 12.

In a possible implementation of the first aspect, the bit status of the first field includes at least one of the following bit states: a first bit state, indicating that the code length of the first mask is a first code length, and the port number of the reference signal belongs to a third value set; a second bit state, indicating that the code length of the first mask is a second code length, and the port number of the reference signal belongs to a third value set; or a third bit state, indicating that the code length of the first mask is a second code length, and the port number of the reference signal belongs to a fourth value set.

For example, for the type-1 DMRS, the first code length is 2, the second code length is 4, the third value set is 1000 to 1007, and the fourth value set is 1008 to 1015.

For example, for the type-2 DMRS, the first code length is 2, the second code length is 4, the third value set is 1000 to 1011, and the fourth value set is 1012 to 1023.

In a possible implementation of the first aspect, the third value set and the fourth value set satisfy at least one of the following: a quantity of number values included in the third value set is the same as a quantity of number values included in the fourth value set; a number value in the fourth value set is determined based on a number value in the third value set and a first value, where the first value belongs to a fifth value set; or configuration type of a reference signal corresponding to the third value set is the same as a configuration type of a reference signal corresponding to the fourth value set. For example, the fifth value set includes one or more of the following values: 4, 8, 6, and 12.

For example, for the type-2 DMRS, the third value set is 1000 to 1011, and the fourth value set is 1012 to 1023. Both the quantity of number values included in the third value set and the quantity of number values included in the fourth value set are 12. The number value in the fourth value set is obtained by adding 12 to the number value in the third value set. Both the configuration type of reference signal corresponding to the third value set and the configuration type of reference signal corresponding to the fourth value set are type-2.

In a possible implementation, the fifth value set is predefined. For example, when the configuration type of the reference signal is the type-1 DMRS, the fifth value set is {4, 8} or {8}. For another example, when the configuration type of the reference signal is the type-2 DMRS, the fifth value set is {6, 12} or {12}.

In another possible implementation, the fifth value set may be configured by using a higher layer parameter. For example, when the configuration type of the reference signal is the type-1 DMRS, the fifth value set is {4, 8}. When the reference signal is configured as a single-symbol type-1 DMRS, the fifth value set is {4, 8}. When the reference signal is configured as a double-symbol type-1 DMRS, the fifth value set is {8}.

For another example, when the configuration type of the reference signal is the type-2 DMRS, the fifth value set is {6, 12}. When the reference signal is configured as a single-symbol type-2 DMRS, the fifth value set is {6, 12}. When the reference signal is configured as a double-symbol type-2 DMRS, the fifth value set is {12}.

In a possible implementation of the first aspect, when the configuration type of the reference signal is a first configuration type, the fifth value set includes 8. The first configuration type is type-1 or an enhanced configuration type. When the configuration type of the reference signal is a second configuration type (type-2 DMRS), the fifth value set includes 12. The second configuration type is type-2 or an enhanced configuration type.

In a possible implementation of the first aspect, the first information further includes an antenna port field, and the antenna port field indicates a first physical resource. The bit status of the first field further includes a fourth bit state. The fourth bit state indicates: No terminal device other than the terminal device performs data or signal transmission on the first physical resource. In this implementation, the terminal device can determine whether another terminal device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the first aspect, at least one of the first bit state, the second bit state, or the third bit state further indicates: Another terminal device other than the terminal device performs data or signal transmission on the first physical resource. In this implementation, the terminal device can determine whether another terminal device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the first aspect, the bit status of the first field further includes a fifth bit state, and the fifth bit state indicates: A quantity of data streams corresponding to the reference signal is 3 or 4, and the code length of the first mask is the first code length or the second code length. Alternatively, the fifth bit state of the first field indicates: A quantity of data streams corresponding to the reference signal is 3 or 4. In this case, the code length of the first mask is predefined or is configured by using a higher layer parameter. For example, the code length of the first mask is the first code length. Alternatively, the code length of the first mask is the second code length.

In a possible implementation of the first aspect, at least one of the first bit state, the second bit state, and the third bit state further indicates: A quantity of data streams corresponding to the reference signal is 1 or 2.

In a possible implementation of the first aspect, the first information further includes an antenna port field. When the bit status of the first field is the fifth bit state, a length of the antenna port field is m; or when the bit status of the first field is one of the first bit state, the second bit state, or the third bit state, a length of the antenna port field is n, where m and n are positive integers, and m is less than n. In this implementation, the length of the antenna port field can be reduced, and communication resources can be saved.

In a possible implementation of the first aspect, the first information further indicates a first physical resource, and a bit status of the first field further includes a sixth bit state and/or a seventh bit state. The sixth bit state indicates that the code length of the first mask is a first code length or a second code length, and no terminal device other than the terminal device performs data or signal transmission on the first physical resource. The seventh bit state indicates that the code length of the first mask is the first code length or the second code length, and another terminal device other than the terminal device performs data or signal transmission on the first physical resource. In this implementation, the receive device can determine whether another device sends a reference signal on a physical resource other than a physical resource occupied by a DMRS port, to determine a quantity of orthogonal DMRS ports that currently need to be distinguished, and use a more proper filter to obtain a better channel estimation effect. The indicating that the code length of the first mask is a first code length or a second code length may be understood as that the code length of the first mask is predefined or is configured by using a higher layer parameter when the sixth bit state and/or the seventh bit state do/does not indicate the code length of the first mask. Alternatively, it may be understood that the sixth bit state and/or the seventh bit state indicate/indicates that the code length of the first mask is one of the first code length and the second code length.

In a possible implementation of the first aspect, a bit status of the first field further includes an eighth bit state and/or a ninth bit state. The eighth bit state indicates that a quantity of data streams corresponding to the reference signal is 3, and the code length of the first mask is a second code length. The ninth bit state indicates that the quantity of data streams corresponding to the reference signal is 4, and the code length of the first mask is the second code length. In this implementation, when the length of the FD-OCC is 4 and the quantity of data streams is 3 or 4, DMRS ports may be consistent with DMRS ports used when the length of the FD-OCC is 2 and the quantity of data streams is 3 or 4, to ensure good backward compatibility.

In a possible implementation of the first aspect, the bit status of the first field further includes a tenth bit state and/or an eleventh bit state. The tenth bit state indicates that the code length of the first mask is the first code length, a quantity of ports of the reference signal is 3 or 4, and time and/or frequency positions of reference signal resources corresponding to the ports of the reference signal are different. The eleventh bit state indicates that the code length of the first mask is the second code length, the quantity of ports of the reference signal is 3 or 4, and the time and/or frequency positions of the reference signal resources corresponding to the ports of the reference signal are the same. In this implementation, when the length of the FD-OCC is 4 and the quantity of data streams is greater than or equal to 3, DMRS ports are indicated as ports in a same CDM group, to ensure that the DMRS ports of the terminal device are allocated to the same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

In a possible implementation of the first aspect, the bit status of the first field further includes a twelfth bit state and/or a thirteenth bit state. The twelfth bit state indicates that the code length of the first mask is the first code length, a quantity of ports of the reference signal greater than 4, and time and/or frequency positions of reference signal resources corresponding to the ports of the reference signal are different. The thirteenth bit state indicates that the code length of the first mask is the second code length, the quantity of ports of the reference signal is greater than 4, and the time and/or frequency positions of the reference signal resources corresponding to the ports of the reference signal are the same. In this implementation, it is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

According to a second aspect, a signal transmission method is provided. The method includes: A network device sends first information. The first information includes a first field, the first field is used to determine a code length of a first mask, the code length of the first mask is included in a first value set, and the first value set includes one or more of the following values: 2, 3, 4, 6, and 8. The network device determines a reference signal based on the first mask. The network device receives or sends the reference signal.

According to the signal transmission method provided in the second aspect, the code length of the mask corresponding to the reference signal is indicated to a receive device, to ensure that the receive device is definite about the length of the mask used for the reference signal, so that the receive device can use a proper hardware implementation method (for example, a reference signal decoding or filtering method), to obtain a better demodulation effect when different reference signal ports are multiplexed, and improve reference signal transmission efficiency.

For example, the first mask is an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The code length of the first mask that is indicated by the first information is a value in the first value set.

For example, the reference signal may be a downlink DMRS or an uplink DMRS. For example, if the reference signal is the downlink DMRS, a terminal device receives the reference signal. If the reference signal is the uplink DMRS, a terminal device sends the reference signal.

In a possible implementation of the second aspect, the first field is further used to determine a reference signal port number; or the first information further includes a second field, and the second field is used to determine a reference signal port number. The method further includes: The network device determines the reference signal port number based on the first field or the second field. In this implementation, the terminal device can be definite about a code length of an FD-OCC used for a DMRS and a DMRS port number, to use a proper hardware implementation method (for example, a reference signal decoding or filtering method). In this way, a better demodulation effect is obtained when different DMRSs are multiplexed, and reference signal transmission efficiency is improved. In addition, dynamic signaling is saved, and utilization of communication resources is improved.

In a possible implementation of the second aspect, the first field or the second field indicates an offset value of the reference signal port number, where the offset value belongs to a second value set, and the second value set includes one or more of the following values: 0, 4, 6, 8, and 12; or a value set to which a port number of the reference signal belongs. In this implementation, the value set to which the reference signal port number belongs is indicated to the terminal device, so that a length (quantity of bits) of dynamic signaling (for example, the first information) can be reduced, to reduce signaling overheads. The offset value of the reference signal port number is indicated to the terminal device, so that a quantity of pieces of antenna port correspondence (mapping) information that needs to be stored by the network device can be reduced, to reduce a storage amount and processing complexity that are of the terminal device. In addition, the length (quantity of bits) of the dynamic signaling (for example, the first information) may be further reduced, to reduce the signaling overheads.

In a possible implementation of the second aspect, offset values of reference signal port numbers corresponding to at least two bit states in a bit status of the first field are the same; or port numbers of reference signals corresponding to at least two bit states in a bit status of the first field belong to a same value set.

For example, for a type-2 DMRS, an offset value of the DMRS port number belongs to the second value set, and the second value set includes one or more of the following values: 0, 6, and 12. For example, the second value set is {0, 12}. Alternatively, the second value set is {0, 6}, or the second value set is {6, 12}, or the second value set is {0, 6, 12}.

For example, for a type-1 DMRS, an offset value of the DMRS port number belongs to the second value set, and the second value set includes one or more of the following values: 0, 4, and 8. For example, the second value set is {0, 4}. Alternatively, the second value set is {0, 8}, or the second value set is {4, 8}, or the second value set is {0, 4, 8}.

For example, the offset value being 0 indicates no offset. To be specific, the port number is a currently indicated number, or the port number is a number defined in a protocol table.

In a possible implementation of the second aspect, the bit status of the first field includes at least one of the following bit states: a first bit state, indicating that the code length of the first mask is a first code length, and the offset value of the reference signal port number is a first offset value; a second bit state, indicating that the code length of the first mask is a second code length, and the offset value of the reference signal port number is a first offset value; or a third bit state, indicating that the code length of the first mask is a second code length, and the offset value of the reference signal port number is a second offset value.

For example, for the type-1 DMRS, the first code length is 2, the second code length is 4, the first offset value is 0, and the second offset value is 8.

For example, for the type-2 DMRS, the first code length is 2, the second code length is 4, the first offset value is 0, and the second offset value is 12.

In a possible implementation of the second aspect, the bit status of the first field includes at least one of the following bit states: a first bit state, indicating that the code length of the first mask is a first code length, and the port number of the reference signal belongs to a third value set; a second bit state, indicating that the code length of the first mask is a second code length, and the port number of the reference signal belongs to a third value set; or a third bit state, indicating that the code length of the first mask is a second code length, and the port number of the reference signal belongs to a fourth value set.

In a possible implementation of the second aspect, the third value set and the fourth value set satisfy at least one of the following: a quantity of number values included in the third value set is the same as a quantity of number values included in the fourth value set; a number value in the fourth value set is determined based on a number value in the third value set and a first value, where the first value belongs to a fifth value set; or configuration type of a reference signal corresponding to the third value set is the same as a configuration type of a reference signal corresponding to the fourth value set.

For example, for the type-2 DMRS, the third value set is 1000 to 1011, and the fourth value set is 1012 to 1023. Both the quantity of number values included in the third value set and the quantity of number values included in the fourth value set are 12. The number value in the fourth value set is obtained by adding 12 to the number value in the third value set. Both the configuration type of reference signal corresponding to the third value set and the configuration type of reference signal corresponding to the fourth value set are type-2.

In a possible implementation of the second aspect, when the configuration type of the reference signal is a first configuration type (type-1 DMRS), the fifth value set includes 8. The first configuration type is type-1 or an enhanced configuration type. When the configuration type of the reference signal is a second configuration type (type-2 DMRS), the fifth value set includes 12. The second configuration type is type-2 or an enhanced configuration type.

In a possible implementation of the second aspect, the first information further includes an antenna port field, and the antenna port field indicates a first physical resource. The bit status of the first field further includes a fourth bit state. The fourth bit state indicates: No terminal device other than the terminal device performs data or signal transmission on the first physical resource. In this implementation, the receive device can determine whether another device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the second aspect, at least one of the first bit state, the second bit state, or the third bit state further indicates: Another terminal device other than the terminal device performs data or signal transmission on the first physical resource. In this implementation, the receive device can determine whether another device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the second aspect, the bit status of the first field further includes a fifth bit state, and the fifth bit state indicates: A quantity of data streams corresponding to the reference signal is 3 or 4, and the code length of the first mask is the first code length or the second code length. Alternatively, the fifth bit state of the first field indicates: A quantity of data streams corresponding to the reference signal is 3 or 4. In this case, the code length of the first mask is predefined or is configured by using a higher layer parameter. For example, the code length of the first mask is the first code length. Alternatively, the code length of the first mask is the second code length.

In a possible implementation of the second aspect, at least one of the first bit state, the second bit state, and the third bit state further indicates: A quantity of data streams corresponding to the reference signal is 1 or 2.

In a possible implementation of the second aspect, the first information further includes an antenna port field. When the bit status of the first field is the fifth bit state, a length of the antenna port field is m; or when the bit status of the first field is one of the first bit state, the second bit state, or the third bit state, a length of the antenna port field is n, where m and n are positive integers, and m is less than n. In this implementation, the length of the antenna port field can be reduced, and communication resources can be saved.

In a possible implementation of the second aspect, the first information further indicates a first physical resource, and a bit status of the first field further includes a sixth bit state and/or a seventh bit state. The sixth bit state indicates that the code length of the first mask is a first code length or a second code length, and no terminal device other than the terminal device performs data or signal transmission on the first physical resource. The seventh bit state indicates that the code length of the first mask is the first code length or the second code length, and another terminal device other than the terminal device performs data or signal transmission on the first physical resource. In this implementation, the receive device can determine whether another device sends a reference signal on a physical resource other than a physical resource occupied by a DMRS port, to determine a quantity of orthogonal DMRS ports that currently need to be distinguished, and use a more proper filter to obtain a better channel estimation effect. The indicating that the code length of the first mask is a first code length or a second code length may be understood as that the code length of the first mask is predefined or is configured by using a higher layer parameter when the sixth bit state and/or the seventh bit state do/does not indicate the code length of the first mask. Alternatively, it may be understood that the sixth bit state and/or the seventh bit state indicate/indicates that the code length of the first mask is one of the first code length and the second code length.

In a possible implementation of the second aspect, a bit status of the first field further includes an eighth bit state and/or a ninth bit state. The eighth bit state indicates that a quantity of data streams corresponding to the reference signal is 3, and the code length of the first mask is a second code length. The ninth bit state indicates that the quantity of data streams corresponding to the reference signal is 4, and the code length of the first mask is the second code length. In this implementation, when the length of the FD-OCC is 4 and the quantity of data streams is 3 or 4, the DMRS port may be consistent with a DMRS port used when the length of the FD-OCC is 2 and the quantity of data streams is 3 or 4, to ensure good backward compatibility.

In a possible implementation of the second aspect, the bit status of the first field further includes a tenth bit state and/or an eleventh bit state. The tenth bit state indicates that the code length of the first mask is the first code length, a quantity of ports of the reference signal is 3 or 4, and time and/or frequency positions of reference signal resources corresponding to the ports of the reference signal are different. The eleventh bit state indicates that the code length of the first mask is the second code length, the quantity of ports of the reference signal is 3 or 4, and the time and/or frequency positions of the reference signal resources corresponding to the ports of the reference signal are the same. In this implementation, when the length of the FD-OCC is 4 and the quantity of data streams is greater than or equal to 3, DMRS ports are indicated as ports in a same CDM group, to ensure that the DMRS ports of the terminal device are allocated to the same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

In a possible implementation of the second aspect, the bit status of the first field further includes a twelfth bit state and/or a thirteenth bit state. The twelfth bit state indicates that the code length of the first mask is the first code length, a quantity of ports of the reference signal greater than 4, and time and/or frequency positions of reference signal resources corresponding to the ports of the reference signal are different. The thirteenth bit state indicates that the code length of the first mask is the second code length, the quantity of ports of the reference signal is greater than 4, and the time and/or frequency positions of the reference signal resources corresponding to the ports of the reference signal are the same. In this implementation, it is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

According to a third aspect, a signal transmission method is provided. The method includes: A terminal device receives DCI. The DCI includes a third field, and the third field is used to determine a quantity of ports of a reference signal and a reference signal resource corresponding to the port of the reference signal. The terminal device sends the reference signal on the reference signal resource.

When the quantity of ports of the reference signal is 3 or 4, time and frequency positions of the reference signal resources corresponding to the ports of the reference signal are the same; or when the quantity of ports of the reference signal is greater than 4, time and frequency positions of the reference signal resources corresponding to the ports of the reference signal are the same.

Alternatively, the quantity of ports of the reference signal is 3 or 4, and time or frequency positions of the reference signal resources corresponding to the ports of the reference signal are the same; or the quantity of ports of the reference signal is greater than 4, and time or frequency positions of the reference signal resources corresponding to the ports of the reference signal are the same.

It may be understood that the reference signal resource corresponding to the port of the reference signal is a time and/or frequency resource for sending or receiving the reference signal.

According to the signal transmission method provided in the third aspect, it is ensured that DMRS ports of the terminal device are in a same CDM group (that is, the time and/or frequency positions of the reference signal resources are the same). This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

In a possible implementation of the third aspect, the third field is further used to determine a code length of a first mask, the code length of the first mask is included in a first value set, and the first value set includes one or more of the following values: 2, 3, 4, 6, and 8. In this implementation, it is ensured that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

For example, the third field may be an antenna port field.

According to a fourth aspect, a signal transmission method is provided. The method includes: A network device sends downlink control information DCI. The DCI includes a third field, and the third field is used to determine a quantity of ports of a reference signal and a reference signal resource corresponding to the port of the reference signal. The network device sends or receives the reference signal based on the DCI. When the quantity of ports of the reference signal is 3 or 4, time and frequency positions of the reference signal resources corresponding to the ports of the reference signal are the same; or when the quantity of ports of the reference signal is greater than 4, time and frequency positions of the reference signal resources corresponding to the ports of the reference signal are the same.

Alternatively, the quantity of ports of the reference signal is 3 or 4, and time or frequency positions of the reference signal resources corresponding to the ports of the reference signal are the same; or the quantity of ports of the reference signal is greater than 4, and time or frequency positions of the reference signal resources corresponding to the ports of the reference signal are the same.

It may be understood that the reference signal resource corresponding to the port of the reference signal is a time and/or frequency resource for sending or receiving the reference signal.

According to the signal transmission method provided in the fourth aspect, it is ensured that DMRS ports of a receive device are in a same CDM group (that is, the time and/or frequency positions of the reference signal resources are the same). This helps reduce complexity of implementing DMRS orthogonality by the receive device, and save frequency domain resources. In addition, this can better satisfy orthogonality between the ports allocated to the receive device, and help the receive device reduce, through precoding, orthogonality damage caused by a non-ideal factor.

In a possible implementation of the fourth aspect, the third field is further used to determine a code length of a first mask, the code length of the first mask is included in a first value set, and the first value set includes one or more of the following values: 2, 3, 4, 6, and 8. In this implementation, it is ensured that the receive device is definite about the length of the mask used for the reference signal, so that the receive device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, a terminal device receives the reference signal. If the reference signal is the uplink DMRS, a terminal device sends the reference signal.

For example, the third field may be an antenna port field.

According to a fifth aspect, a signal transmission method is provided. The method includes: A terminal device receives DCI. The DCI includes a fourth field and an antenna port field, the fourth field is used to determine that a quantity of data streams corresponding to a reference signal is 3 or 4, and the antenna port field is used to determine a port number of the reference signal. The terminal device receives or sends the reference signal on a port corresponding to the port number of the reference signal.

According to signal transmission method provided in the fifth aspect, the fourth field indicates that the quantity of data streams corresponding to the reference signal is 3 or 4, and the antenna port field indicates only the port number of the reference signal when the quantity of data streams is 3 or 4. In this way, overheads of the antenna port field can be reduced, and utilization of communication resources can be improved.

In a possible implementation of the fifth aspect, the fourth field is further used to determine a code length of a first mask, the code length of the first mask is included in a first value set, and the first value set includes one or more of the following values: 2, 3, 4, 6, and 8. In this implementation, it is ensured that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

According to a sixth aspect, a signal transmission method is provided. The method includes: A network device sends downlink control information DCI. The DCI includes a fourth field and an antenna port field, the fourth field is used to determine that a quantity of data streams corresponding to a reference signal is 3 or 4, and the antenna port field is used to determine a port number of the reference signal when the quantity of data streams is 3 or 4. The network device sends or receives the reference signal based on the DCI.

According to the signal transmission method provided in the sixth aspect, the fourth field indicates that the quantity of data streams corresponding to the reference signal is 3 or 4, and the antenna port field indicates only the port number of the reference signal when the quantity of data streams is 3 or 4. In this way, overheads of the antenna port field can be reduced, and utilization of communication resources can be improved.

In a possible implementation of the sixth aspect, the fourth field is further used to determine a code length of a first mask, the code length of the first mask is included in a first value set, and the first value set includes one or more of the following values: 2, 3, 4, 6, and 8. In this implementation, it is ensured that a receive device is definite about the length of the mask used for the reference signal, so that the receive device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, a terminal device receives the reference signal. If the reference signal is the uplink DMRS, a terminal device sends the reference signal.

According to a seventh aspect, a signal transmission method is provided. The method includes: A terminal device receives downlink control information DCI. The DCI includes a fifth field and an antenna port field, the antenna port field indicates a reference signal port number and a first physical resource, and the fifth field indicates: No terminal device other than the terminal device performs data or signal transmission on the first physical resource or another terminal device other than the terminal device performs data or signal transmission on the first physical resource. The terminal device receives the reference signal on the first physical resource.

According to the signal transmission method provided in the seventh aspect, the terminal device determines, based on the fifth field, that no terminal device other than the terminal device performs data or signal transmission on the physical resource or that the another terminal device other than the terminal device performs data or signal transmission on the physical resource, so that the terminal device can determine whether another terminal device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the seventh aspect, the fifth field includes a first bit state and/or a second bit state. The first bit state indicates that no terminal device other than the terminal device performs data or signal transmission on the first physical resource. The second bit state indicates that the another terminal device other than the terminal device performs data or signal transmission on the first physical resource. It may be understood that, that the terminal device receives or sends the reference signal on the first physical resource means that the terminal device receives or sends the reference signal on all physical resources of the first physical resource, or the terminal device receives or sends the reference signal on some of the physical resources of the first physical resource.

In a possible implementation of the seventh aspect, the fifth field is further used to determine a code length of a first mask, the code length of the first mask is included in a first value set, and the first value set includes one or more of the following values: 2, 3, 4, 6, and 8. In this implementation, it is ensured that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

According to an eighth aspect, a signal transmission method is provided. The method includes: A network device sends downlink control information DCI. The DCI includes a fifth field and an antenna port field, the antenna port field indicates a reference signal port number and a first physical resource, and the fifth field indicates: No terminal device other than a terminal device performs data or signal transmission on the first physical resource or another terminal device other than the terminal device performs data or signal transmission on the first physical resource. The network device sends the reference signal on the first physical resource.

According to the signal transmission method provided in the eighth aspect, that no device other than the device performs data or signal transmission on the physical resource or that the another device other than the device performs data or signal transmission on the physical resource is indicated to a receive device, so that the receive device can determine whether another device sends a reference signal on a physical resource other than a physical resource occupied by a DMRS port, to determine a quantity of orthogonal DMRS ports that currently need to be distinguished, and use a more proper filter to obtain a better channel estimation effect.

In a possible implementation of the eighth aspect, the fifth field includes a first bit state and/or a second bit state. The first bit state indicates that no device other than the device performs data or signal transmission on the first physical resource. The second bit state indicates that the another device other than the device performs data or signal transmission on the first physical resource. It may be understood that, that the network device receives or sends the reference signal on the first physical resource means that the network device receives or sends the reference signal on all physical resources of the first physical resource, or the network device receives or sends the reference signal on some of the physical resources of the first physical resource.

In a possible implementation of the eighth aspect, the fifth field is further used to determine a code length of a first mask, the code length of the first mask is included in a first value set, and the first value set includes one or more of the following values: 2, 3, 4, 6, and 8. In this implementation, it is ensured that a receive device is definite about the length of the mask used for the reference signal, so that the receive device can use a proper hardware implementation method (for example, a reference signal decoding or filtering method), to obtain a better demodulation effect when different reference signal ports are multiplexed, and improve reference signal transmission efficiency.

For example, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

The first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

According to a ninth aspect, a signal transmission method is provided. The method includes: A terminal device receives third information. The third information indicates that a type of a reference signal is one of a first type and a second type. The terminal device determines a first physical resource based on the type of the reference signal. On a same physical resource, a first-type reference signal and a second-type reference signal correspond to a same reference signal sequence value. The terminal device receives or sends the reference signal on the first physical resource.

According to the signal transmission method provided in the ninth aspect, it can be effectively ensured that the first-type reference signal and the second-type reference signal are multiplexed on a same time resource, to improve flexibility of system scheduling. This helps multiplexing of a terminal device applicable to Release-18 and a terminal device applicable to another protocol release, and improves backward compatibility of the reference signal.

In a possible implementation of the ninth aspect, a total quantity of reference signal ports supported by the first-type reference signal is a, and a total quantity of reference signal ports supported by the second-type reference signal is b, where both a and b are positive integers, and a is greater than b.

For example, the reference signal may be a downlink DMRS or an uplink DMRS. For example, if the reference signal is the downlink DMRS, the terminal device receives the reference signal. If the reference signal is the uplink DMRS, the terminal device sends the reference signal.

In a possible implementation of the ninth aspect, the terminal device may determine a mapping relationship between the reference signal and a physical resource according to a first rule. The first rule is applicable to the first type and the second type. The first rule includes a first parameter, a second parameter, and a third parameter. The first parameter, the second parameter, and the third parameter for the first type are the same as those for the second type. For example, the first parameter is a parameter $k'$, and a candidate value of $k'$ corresponding to the first type is the same as a candidate value of $k'$ corresponding to the second type. For example, the candidate values of $k'$ are 0 and 1.

In a possible implementation of the ninth aspect, the first type is an enhanced DMRS, and the second type is a type-1 DMRS. Alternatively, the first type and the second type are a same reference signal type. For example, the first type and the second type each are a type-1 DMRS.

In a possible implementation of the ninth aspect, a reference signal port number corresponding to the first rule is different from a reference signal port number corresponding to the second rule.

According to a tenth aspect, a communication apparatus is provided. The apparatus includes: units configured to perform the steps in any one of the first aspect or the possible implementations of the first aspect; or units configured to perform steps in any one of the third aspect or the possible implementations of the third aspect; or units configured to perform steps in any one of the fifth aspect or the possible implementations of the fifth aspect, or units configured to perform steps in any one of the seventh aspect or the possible implementations of the seventh aspect; or units configured to perform the steps in any one of the ninth aspect or the possible implementations of the ninth aspect.

According to an eleventh aspect, a communication apparatus is provided. The apparatus includes: units configured to perform the steps in any one of the second aspect or the possible implementations of the second aspect; or units configured to perform the steps in any one of the fourth aspect or the possible implementations of the fourth aspect; units configured to perform the steps in any one of the sixth aspect or the possible implementations of the sixth aspect; or units configured to perform the steps in any one of the eighth aspect or the possible implementations of the eighth aspect.

According to a twelfth aspect, a communication apparatus is provided. The apparatus includes at least one processor and a memory. The at least one processor is configured to perform: the method according to any one of the first aspect or the possible implementations of the first aspect; or the method according to any one of the third aspect or the possible implementations of the third aspect; or the method according to any one of the fifth aspect or the possible implementations of the fifth aspect; or the method according to any one of the seventh aspect or the possible implementations of the seventh aspect; or the method according to any one of the ninth aspect or the possible implementations of the ninth aspect.

According to a thirteenth aspect, a communication apparatus is provided. The apparatus includes at least one processor and a memory. The at least one processor is configured to perform: the method according to any one of the second aspect or the possible implementations of the second aspect; or the method according to any one of the fourth aspect or the possible implementations of the fourth aspect; or the method according to any one of the sixth aspect or the possible implementations of the sixth aspect; or the method according to any one of the eighth aspect or the possible implementations of the eighth aspect.

According to a fourteenth aspect, a communication apparatus is provided. The apparatus includes at least one processor and an interface circuit. The at least one processor is configured to perform: the method according to any one of the first aspect or the possible implementations of the first aspect; or the method according to any one of the third aspect or the possible implementations of the third aspect; or the method according to any one of the fifth aspect or the possible implementations of the fifth aspect; or the method according to any one of the seventh aspect or the possible implementations of the seventh aspect; or the method according to any one of the ninth aspect or the possible implementations of the ninth aspect.

According to a fifteenth aspect, a communication apparatus is provided. The apparatus includes at least one processor and an interface circuit. The at least one processor is configured to perform: the method according to any one of the second aspect or the possible implementations of the second aspect; or the method according to any one of the fourth aspect or the possible implementations of the fourth aspect; or the method according to any one of the sixth aspect or the possible implementations of the sixth aspect; or the method according to any one of the eighth aspect or the possible implementations of the eighth aspect.

According to a sixteenth aspect, a terminal device is provided. The terminal device includes the communication apparatus according to the ninth aspect, or the terminal device includes the communication apparatus according to the eleventh aspect, or the terminal device includes the communication apparatus according to the thirteenth aspect.

According to a seventeenth aspect, a network device is provided. The network device includes the communication apparatus according to the tenth aspect, or the terminal device includes the communication apparatus according to the twelfth aspect, or the terminal device includes the communication apparatus according to the fourteenth aspect.

According to an eighteenth aspect, a computer program product is provided. The computer program product includes a computer program. When the computer program is executed by a processor, the method according to any one of the first aspect or the possible implementations of the foregoing aspects is performed.

According to a nineteenth aspect, a computer-readable storage medium is provided. The computer-readable storage medium stores a computer program. When the computer program is executed, the method according to any one of the foregoing aspects or the possible implementations of the foregoing aspects is performed.

According to a twentieth aspect, a communication system is provided. The communication system includes the foregoing terminal device and the foregoing network device.

According to a twenty-first aspect, a chip is provided. The chip includes a processor, configured to: invoke a computer program from a memory and run the computer program, to enable a communication device mounted with the chip to perform the method according to any one of the foregoing aspects or the possible implementations of the foregoing aspects.

## BRIEF DESCRIPTION OF DRAWINGS

FIG. 1 is a diagram of time-frequency resources to which a DMRS sequence of a single-symbol type-1 DMRS is mapped;
FIG. 2 is a diagram of time-frequency resources to which a DMRS sequence of a double-symbol type-1 DMRS is mapped;
FIG. 3 is a diagram of time-frequency resources to which a DMRS sequence of a single-symbol type-2 DMRS is mapped;

FIG. 4 is a diagram of time-frequency resources to which a DMRS sequence of a double-symbol type-2 DMRS is mapped;

FIG. 5 is a diagram of an architecture of a communication system applicable to an embodiment of this application;

FIG. 6 is a schematic interaction diagram of a signal transmission method according to an embodiment of this application;

FIG. 7 is a schematic interaction diagram of another signal transmission method according to an embodiment of this application;

FIG. 8 is a schematic interaction diagram of another signal transmission method according to an embodiment of this application;

FIG. 9 is a schematic interaction diagram of another signal transmission method according to an embodiment of this application;

FIG. 10 is a schematic interaction diagram of another signal transmission method according to an embodiment of this application;

FIG. 11 is a schematic block diagram of a communication apparatus according to an embodiment of this application;

FIG. 12 is a schematic block diagram of another communication apparatus according to an embodiment of this application;

FIG. 13 is a schematic block diagram of still another communication apparatus according to an embodiment of this application;

FIG. 14 is a schematic block diagram of another communication apparatus according to an embodiment of this application;

FIG. 15 is a schematic block diagram of a terminal device according to an embodiment of this application; and

FIG. 16 is a schematic block diagram of a network device according to an embodiment of this application.

## DESCRIPTION OF EMBODIMENTS

The following describes technical solutions of this application with reference to accompanying drawings.

In the descriptions of embodiments of this application, "/" means "or" unless otherwise specified. For example, A/B may represent A or B. The term "and/or" in this specification describes only an association relationship between associated objects and represents that three relationships may exist. For example, A and/or B may represent the following three cases: Only A exists, both A and B exist, and only B exists. In addition, in the descriptions in embodiments of this application, "a plurality of" means two or more.

The terms "first" and "second" mentioned below are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of embodiments, unless otherwise specified, "a plurality of" means two or more.

The technical solutions in embodiments of this application may be applied to various communication systems, for example, a global system for mobile communications (global system for mobile communications, GSM), a code division multiple access (code division multiple access, CDMA) system, a wideband code division multiple access (wideband code division multiple access, WCDMA) system, a general packet radio service (general packet radio service, GPRS), a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a worldwide interoperability for microwave access (worldwide interoperability for microwave access, WiMAX) communication system, a 5th generation (5th generation, 5G) system, a new radio (new radio, NR) system, or another type of future communication system.

A terminal device in embodiments of this application may also be referred to as user equipment, an access terminal, a subscriber unit, a subscriber station, a mobile station, a remote station, a remote terminal, a mobile device, a user terminal, a terminal, a wireless communication device, a user agent, or a user apparatus. The terminal device may alternatively be a cellular phone, a cordless phone, a session initiation protocol (Session Initiation Protocol, SIP) phone, a wireless local loop (wireless local loop, WLL) station, a personal digital assistant (personal digital assistant, PDA), a handheld device having a wireless communication function, a computing device or another processing device connected to a wireless modem, a vehicle-mounted device, a wearable device, a terminal device in a future 5G network, a terminal device in a future evolved public land mobile network (public land mobile network, PLMN), or the like. This is not limited in embodiments of this application.

A network device in embodiments of this application may be a device configured to communicate with the terminal device. The network device may be a base transceiver station (base transceiver station, BTS) in a global system for mobile communications (global system for mobile communications, GSM) or a code division multiple access (code division multiple access, CDMA) system; may be a NodeB (NodeB, NB) in a wideband code division multiple access (wideband code division multiple access, WCDMA) system; may be an evolved NodeB (evolved NodeB, eNB or eNodeB) in an LTE system; or may be a radio controller in a cloud radio access network (cloud radio access network, CRAN) scenario. Alternatively, the network device may be a relay station, an access point, a vehicle-mounted device, a wearable device, a network device in a future 5G network, a network device in a future evolved PLMN network or another type of future communication system, or the like. This is not limited in embodiments of this application.

In embodiments of this application, the terminal device or the network device includes a hardware layer, an operating system layer running above the hardware layer, and an application layer running above the operating system layer. The hardware layer includes hardware such as a central processing unit (central processing unit, CPU), a memory management unit (memory management unit, MMU), and a memory (also referred to as a main memory). The operating system may be any one or more computer operating systems that implement service processing through a process (process), for example, a Linux operating system, a Unix operating system, an Android operating system, an iOS operating system, or a Windows operating system. The application layer includes applications such as a browser, an address book, word processing software, and instant messaging software. In addition, a specific structure of an execution body of a method provided in embodiments of this application is not particularly limited in embodiments of this application, provided that a program that records code of the method provided in embodiments of this application can be run to perform communication according to the method provided in embodiments of this application. For example, the execution body of the method provided in embodiments of this application may be the terminal device or the network device, or a functional module that can invoke and execute the program in the terminal device or the network device.

In addition, aspects or features of this application may be implemented as a method, an apparatus, or a product that uses standard programming and/or engineering technologies. The term "product" used in this application covers a computer program that can be accessed from any computer-readable component, carrier, or medium. For example, a computer-readable medium may include but is not limited to a magnetic storage component (for example, a hard disk, a floppy disk, or a magnetic tape), an optical disc (for example, a compact disc (compact disc, CD) or a digital versatile disc (digital versatile disc, DVD)), a smart card, and a flash memory component (for example, an erasable programmable read-only memory (erasable programmable read-only memory, EPROM), a card, a stick, or a key drive). In addition, various storage media described in this specification may represent one or more devices and/or other machine-readable media that are configured to store information. The term "machine-readable media" may include but is not limited to a radio channel and various other media that can store, contain, and/or carry instructions and/or data.

One objective of demodulation reference signal (demodulation reference signal, DMRS) enhancement proposed in a multiple-input multiple-output (multiple-input multiple-output, MIMO) topic of 3rd Generation Partnership Project Release-18 (3GPP Rel-18) is: A quantity of orthogonal DMRS ports is increased to 24 without increasing DMRS overheads. For each DMRS type, both a maximum quantity of orthogonal ports for a single-symbol DMRS and a maximum quantity of orthogonal ports for a double-symbol DMRS are doubled.

In an NR system, based on a mapping manner of a DMRS on a frequency domain resource, there are the following two DMRS types: a type-1 (configuration type 1) DMRS and a type-2 (configuration type 2) DMRS (configured by using a higher layer parameter dmrs-Type). In embodiments of this application, the DMRS type may also be referred to as a DMRS configuration type.

For the type-1 (configuration type 1) DMRS, in frequency domain, a DMRS sequence is mapped to one subcarrier at an interval of one subcarrier (or the DMRS sequence is mapped to one of every two subcarriers).

For the type-2 (configuration type 2) DMRS, in frequency domain, a DMRS sequence is mapped to two contiguous subcarriers at an interval of four subcarriers (or the DMRS sequence is mapped to two contiguous subcarriers in every six subcarriers).

Based on a quantity of orthogonal frequency division multiplexing (orthogonal frequency division multiplexing, OFDM) symbols occupied by one DMRS sequence on a time domain resource, DMRSs are classified into a single-symbol DMRS and a double-symbol DMRS (determined based on a higher layer parameter maxLength and/or associated DCI). Based on positions of DMRSs on time domain resources, the DMRSs are classified into a front-loaded (front-loaded) DMRS and an additional (additional) DMRS. A frequency domain mapping manner and a sequence generation manner of the front-loaded DMRS are completely the same as those of the additional DMRS.

Based on the foregoing classification, maximum quantities of orthogonal DMRS ports supported in current NR protocol releases (Release-15, Release-16, and Release-17) are shown in Table 1.

**Table 1 Maximum quantities of orthogonal DMRS ports supported in the current NR protocols**

|  | Type-1 DMRS | Type-2 DMRS |
|---|---|---|
| Single-symbol | 4 | 6 |
| Double-symbol | 8 | 12 |

To be specific, for the single-symbol type-1 DMRS, the maximum quantity of supported orthogonal DMRS ports is 4. For the double-symbol type-1 DMRS, the maximum quantity of supported orthogonal DMRS ports is 8. For the single-symbol type-2 DMRS, the maximum quantity of supported orthogonal DMRS ports is 6. For the double-symbol type-2 DMRS, the maximum quantity of supported orthogonal DMRS ports is 12. In embodiments of this application, the quantity of orthogonal DMRS ports may be understood as a quantity of orthogonal DMRS sequences.

The following specifically describes a mapping manner of each type of DMRS and a method for calculating a maximum quantity of orthogonal DMRS ports.

First, a theoretical basis: a multiplexing technology, for implementing orthogonality between a plurality of ports of a DMRS is briefly described.

In embodiments of this application, the multiplexing technology may be understood as a technology in which a plurality of signals from a plurality of channels are combined on a transmission path of a transmit end, and the plurality of channels are demultiplexed at a receive end to restore each signal. Channel transmission efficiency can be effectively improved by using the multiplexing technology. For example, by using the multiplexing technology, the plurality of signals may be combined at the transmit end (for example, a mixer used by a broadcasting and television front end) for transmission on a dedicated physical channel. Then, the receive end separates a combined signal.

The multiplexing technology in embodiments of this application mainly includes frequency division multiplexing (frequency division multiplexing, FDM), time division multiplexing (time division multiplexing, TDM), and code division multiplexing (code division multiplexing, CDM).

For the FDM, carrier bandwidth is divided into subchannels of different frequency bands, and each user may simultaneously perform transmission of a respective signal on different subchannels. Therefore, all users using the FDM occupy different bandwidth resources at same time.

For the TDM, a channel is divided into different time segments based on time, and each user occupies same frequency bandwidth at different time.

For the CDM, each user may perform communication on a same frequency band at same time. Because the users use different specially selected code points, no interference is caused between the users. For example, an orthogonal cover code (orthogonal cover code, OCC) or the like may be used to implement the code division multiplexing.

Currently, in the current NR protocols, the FDM, a frequency division orthogonal cover code (frequency division orthogonal cover code, FD-OCC), and a time division orthogonal cover code (time division orthogonal cover code, TD-OCC) are jointly used to multiplex orthogonal ports of the DMRS. The following separately describes multiplexing of the type-1 DMRS and multiplexing of the type-2 DMRS.

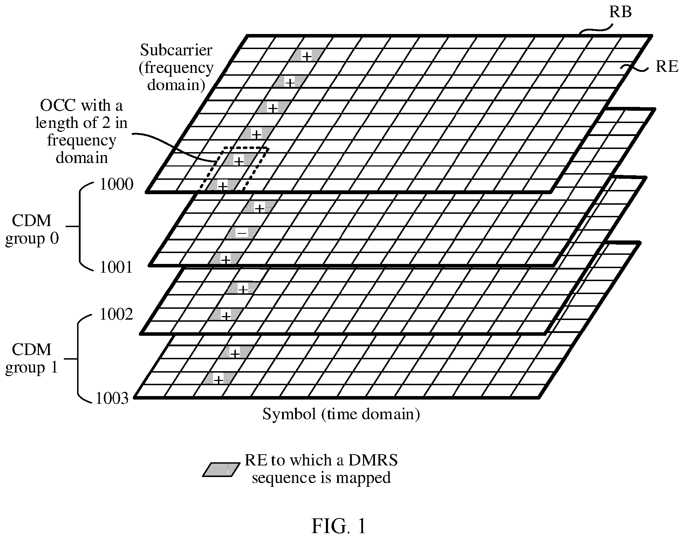

For the single-symbol type-1 DMRS, as shown in FIG. 1, in frequency domain, a DMRS sequence is mapped to one subcarrier at an interval of one subcarrier (or the DMRS sequence is mapped to one of every two subcarriers). In time domain, the DMRS sequence is mapped to one symbol. Therefore, a maximum of two orthogonal DMRS ports may be multiplexed in frequency domain in an FDM manner.

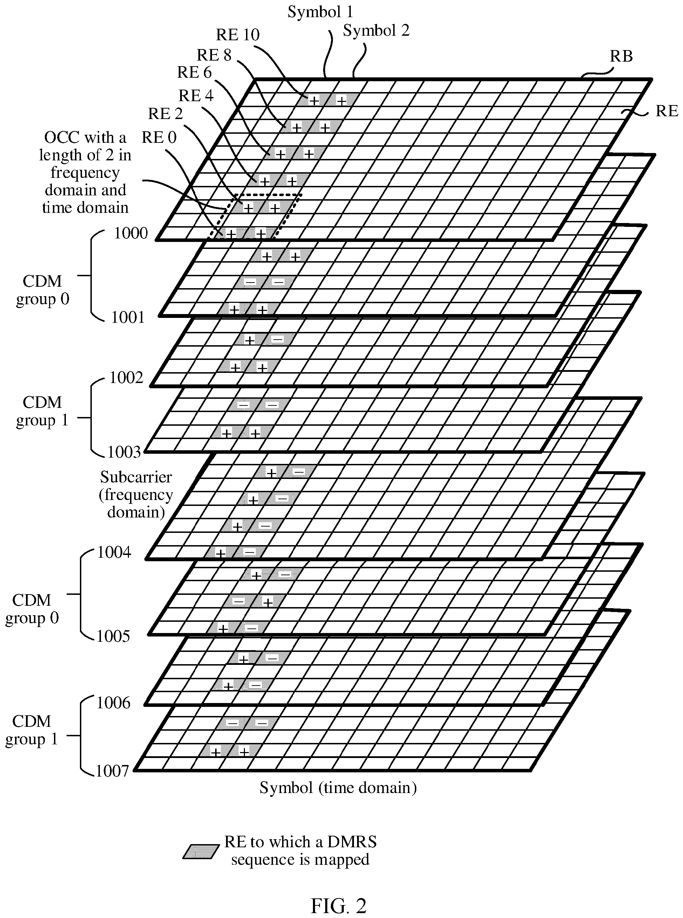

For the double-symbol type-1 DMRS, as shown in FIG. 2, in frequency domain, a DMRS sequence is mapped to one subcarrier at an interval of one subcarrier (or the DMRS sequence is mapped to one of every two subcarriers). In time domain, the DMRS sequence is mapped to two symbols. Therefore, a maximum of four orthogonal DMRS ports may be multiplexed in frequency domain in the FDM manner.

It should be understood that, in embodiments of this application, DMRS sequences mapped to same time and frequency resources belong to a same CDM group (CDM group). In other words, one CDM group indicates one physical resource (time-frequency resource) or one group of physical resources, and different CDM groups correspond to different physical resources.

For example, as shown in FIG. 1, a DMRS sequence mapped to a port 1000 (namely, a port number being 1000) and a DMRS sequence mapped to a port 1001 occupy same time-frequency resources. In other words, the port 1000 (which may also be referred to as a DMRS port 1000) and the port 1001 (which may also be referred to as a DMRS port 1001) belong to a same CDM group: a CDM group 0. Similarly, a port 1002 and a port 1003 belong to a CDM group 1. In other words, two CDM groups are supported in the mapping manner.

For another example, as shown in FIG. 2, a port 1000, a port 1001, a port 1004, and a port 1005 belong to a same CDM group: a CDM group 0, and a port 1002, a port 1003, a port 1006, and a port 1007 belong to a same CDM group: a CDM group 1. In other words, two CDM groups are supported in the mapping manner.

Because different CDM groups correspond to different frequency domain resources, orthogonal multiplexing of DMRS ports included in the different CDM groups may be implemented in the FDM manner. For example, orthogonal multiplexing of the port 1000 and the port 1002, orthogonal multiplexing of the port 1001 and the port 1003, orthogonal multiplexing of the port 1004 and the port 1006, orthogonal multiplexing of the port 1005 and the port 1007, or the like may be implemented in the FDM manner.

Because a same CDM group corresponds to same frequency domain resources, orthogonality of a plurality of ports is implemented in a code division multiplexing manner between different DMRS ports in the same CDM group (namely, a case in which different DMRS sequences are mapped to same time-frequency resources) are orthogonal in a code division multiplexing manner.

It should be understood that, in embodiments of this application, the DMRS sequence may be a sequence that is not multiplied by a mask, or a sequence obtained after being multiplied by the mask.

Specifically, in code domain, the current protocol versions (Release-15, Release-16, and Release-17) support an OCC with a length of 2. Therefore, on same time-frequency resources, a maximum of two orthogonal DMRS ports can be multiplexed in the code division multiplexing manner.

For example, for the single-symbol type-1 DMRS, as shown in FIG. 1, values of an OCC code sequence that is of the port 1000 and that is mapped to corresponding resource elements (resource elements, REs) or subcarriers included in one resource block (resource block, RB) are sequentially {+1, +1, +1, +1, +1, +1}, and values of an OCC that is of the port 1001 and that is mapped to corresponding REs or subcarriers included in one RB are sequentially {+1, -1, +1, -1, +1, -1}. For the port 1000 and the port 1001 in an integer quantity of RBs, DMRS sequences are orthogonal in code domain.

For the double-symbol type-1 DMRS, as shown in FIG. 2, on same time-frequency resources, a maximum of four orthogonal DMRS ports may be multiplexed in a joint manner of the FD-OCC and the TD-OCC. For example, for the four ports 1000, 1001, 1004, and 1005 corresponding to the CDM group 0, values of a mask sequence that is of each port and that is mapped to corresponding REs in one RB are shown in FIG. 2.

**Table 2: Values of the mask sequence of the double-symbol type-1 DMRS**

| | Port 1000 | | Port 1001 | | Port 1004 | | Port 1005 | |
|---|---|---|---|---|---|---|---|---|
| | Symbol 1 | Symbol 2 | Symbol 1 | Symbol 2 | Symbol 1 | Symbol 2 | Symbol 1 | Symbol 2 |
| Subcarrier 0 | +1 | +1 | +1 | +1 | +1 | -1 | +1 | -1 |
| Subcarrier 2 | +1 | +1 | -1 | -1 | +1 | -1 | -1 | +1 |
| Subcarrier 4 | +1 | +1 | +1 | +1 | +1 | -1 | +1 | -1 |
| Subcarrier 6 | +1 | +1 | -1 | -1 | +1 | -1 | -1 | +1 |
| Subcarrier 8 | +1 | +1 | +1 | +1 | +1 | -1 | +1 | -1 |
| Subcarrier 10 | +1 | +1 | -1 | -1 | +1 | -1 | -1 | +1 |

It should be understood that the mask sequence shown in Table 2 includes the FD-OCC and the TD-OCC. A subcarrier corresponds to an FD-OCC sequence value on a frequency domain resource, and an OFDM symbol corresponds to a TD-OCC sequence value on a time domain resource. For example, as shown in Table 2, the DMRS sequence on the port 1000 remains orthogonal to that on the port 1001 by using the FD-OCC, and the DMRS sequence on the port 1000 remains orthogonal to that on the port 1004 by using the TD-OCC.

In conclusion, for the single-symbol type-1 DMRS, multiplexing of a maximum of four orthogonal ports, namely, the port 1000 to the port 1003, is supported by using the FDM and the FD-OCC. For the double-symbol type-1 DMRS, multiplexing of a maximum of eight orthogonal ports, namely, the port 1000 to the port 1007, is supported by using the FDM, the FD-OCC, and the TD-OCC.

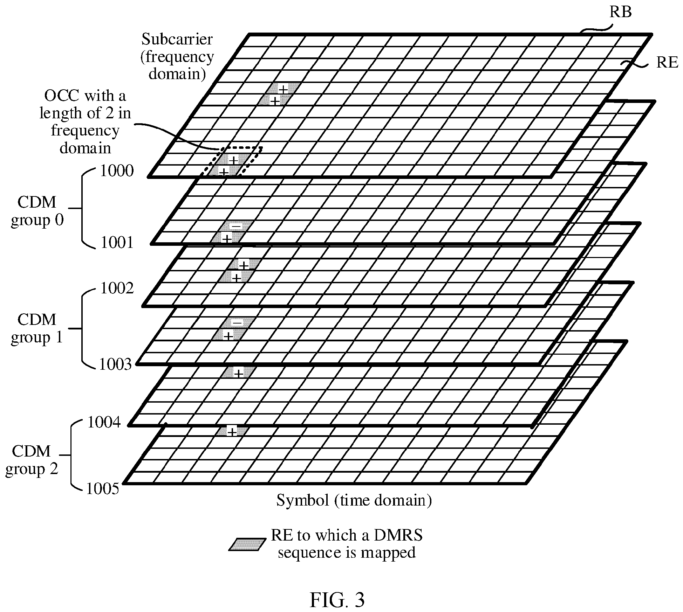

For the single-symbol type-2 DMRS, as shown in FIG. 3, in frequency domain, a DMRS sequence is mapped to two contiguous subcarriers at an interval of four subcarriers (or the DMRS sequence is mapped to two contiguous subcarriers in every six subcarriers). In time domain, the DMRS sequence is mapped to one symbol. In frequency domain, a maximum of three orthogonal DMRS ports may be multiplexed in the FDM manner. In other words, three CDM groups are supported. For example, as shown in FIG. 3, a port 1000 and a port 1001 belong to a same CDM group: a CDM group 0, a port 1002 and a port 1003 belong to a same CDM group: a CDM group 1, and a port 1004 and a port 1005 belong to a same CDM group: a CDM group 2. In other words, the mapping manner supports the three CDM groups.

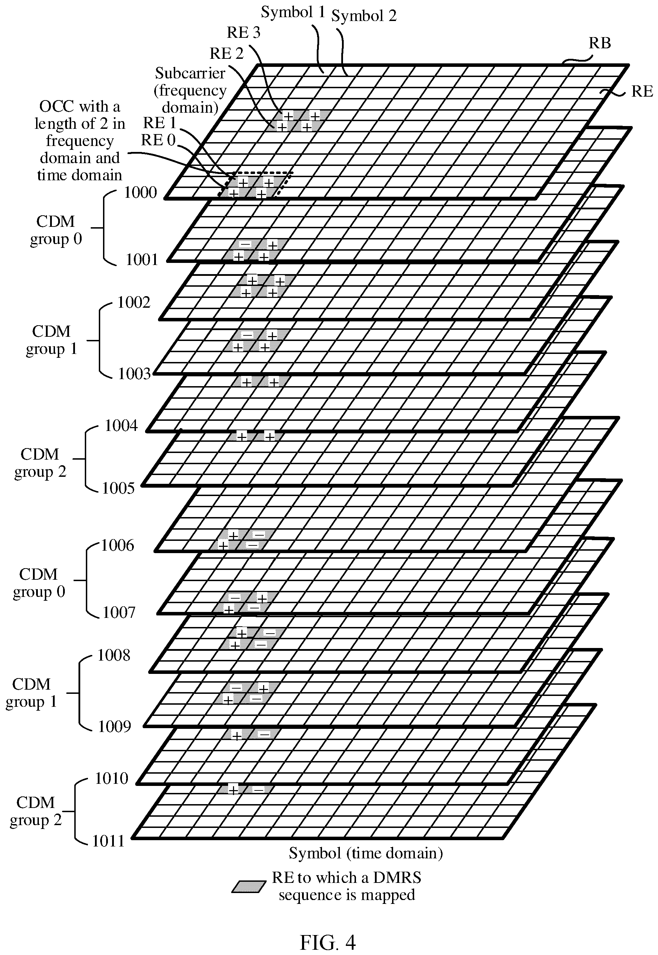

For the double-symbol type-2 DMRS, as shown in FIG. 4, a DMRS sequence is mapped to two contiguous subcarriers at an interval of four subcarriers (or the DMRS sequence is mapped to two contiguous subcarriers in every six subcarriers). In time domain, the DMRS sequence is mapped to two symbols. In frequency domain, a maximum of three orthogonal DMRS ports may also be multiplexed in the FDM manner. In other words, three CDM groups are supported. For example, as shown in FIG. 4, a port 1000, a port 1001, a port 1006, and a port 1007 belong to a same CDM group: a CDM group 0, a port 1002, a port 1003, a port 1008, and a port 1009 belong to a same CDM group: a CDM group 1, and a port 1004, a port 1005, a port 1010, and a port 1011 belong to a same CDM group: a CDM group 2. In other words, the mapping manner supports the three CDM groups.

In code domain, the current protocol versions (Release-15, Release-16, and Release-17) support an OCC with a length of 2. Therefore, on same time-frequency resources, a maximum of two orthogonal DMRS ports can be multiplexed in the code division multiplexing manner.

For example, for the single-symbol type-2 DMRS, as shown in FIG. 3, values of an OCC that is of the port 1000 and that is mapped to corresponding REs or subcarriers included in one RB are sequentially {+1, +1, +1, +1}, and values of an OCC that is of the port 1001 and that is mapped to corresponding REs or subcarriers included in one RB are sequentially {+1, -1, +1, - 1}. For the port 1000 and the port 1001 in an integer quantity of RBs, DMRS sequences are orthogonal in code domain.

For the double-symbol type-4 DMRS, as shown in FIG. 4, on same time-frequency resources, a maximum of four orthogonal DMRS ports may be multiplexed in the joint manner of the FD-OCC and the TD-OCC. For example, for the four ports 1000, 1001, 1006, and 1007 corresponding to the CDM group 0, a mask sequence that is of each port and that is mapped to corresponding REs in one RB is shown in Table 3.

**Table 3: Values of the mask sequence of the double-symbol type-2 DMRS**

| | Port 1000 | | Port 1001 | | Port 1006 | | Port 1007 | |
|---|---|---|---|---|---|---|---|---|
| | Symbol 1 | Symbol 2 | Symbol 1 | Symbol 2 | Symbol 1 | Symbol 2 | Symbol 1 | Symbol 2 |
| Subcarrier 0 | +1 | +1 | +1 | +1 | +1 | -1 | +1 | -1 |
| Subcarrier 1 | +1 | +1 | -1 | +1 | +1 | -1 | -1 | +1 |
| Subcarrier 2 | +1 | +1 | +1 | +1 | +1 | -1 | +1 | -1 |
| Subcarrier 3 | +1 | +1 | -1 | +1 | +1 | -1 | -1 | +1 |

It should be understood that the mask sequence shown in Table 3 includes the FD-OCC and the TD-OCC. A frequency domain resource corresponds to an FD-OCC sequence value in a unit of a subcarrier, and a time domain resource corresponds to a TD-OCC sequence value in a unit of an OFDM symbol. For example, as shown in Table 3, the DMRS sequence on the port 1000 remains orthogonal to that on the port 1001 by using the FD-OCC, and the DMRS sequence on the port 1000 remains orthogonal to that on the port 1006 by using the TD-OCC.

In conclusion, for the single-symbol type-2 DMRS, multiplexing of a maximum of six orthogonal ports, namely, the port 1000 to the port 1005, is supported by using the FDM and the FD-OCC. For the double-symbol type-2 DMRS, multiplexing of a maximum of 12 orthogonal ports, namely, the port 1000 to the port 1011, is supported in by using the FDM, the FD-OCC, and the TD-OCC.

The following specifically describes a mapping relationship between the DMRS port and the OCC code.

Assuming that $r$(m) represents the DMRS sequence, and $\beta_{\text{PDSCH}}^{\text{DMRS}}$ represents a transmission power scaling factor, mapping from the DMRS sequence to the physical resource, that is, mapping from the DMRS sequence to a $(k,l)_{p,u}$ th RE, may satisfy Formula (1):

$$a_{k,l}^{(p,\mu)} = \beta_{\text{PDSCH}}^{\text{DMRS}} w_{\text{f}}\left(k'\right) w_{\text{t}}\left(l'\right) r\left(2n+k'\right) \quad (1)$$

In Formula (1), $a_{k,l}^{(p,\mu)}$ represents a DMRS signal obtained by mapping the DMRS sequence to the $(k,l)_{p,u}$ th RE, $k$ represents a frequency domain resource index, $l$ represents a time domain resource index, $w_{\text{f}}(k')$ represents a value of an FD-OCC code sequence, namely, a frequency domain mask sequence value, and $w_{\text{t}}(l')$ represents a value of a TD-OCC code sequence, namely, a time domain mask sequence value. A value of $k'$ is 0 or 1. $l = \bar{l} + l'$, and a value of n is 0, 1, 2, .... In other words, the value of n may be an integer.

$k$ may satisfy Formula (2):

$$k = \begin{cases} 4n + 2k' + \Delta & \text{type-1} \\ 6n + k' + \Delta & \text{type-2} \end{cases} \quad (2)$$

In Formula (2), type-1 represents a type-1 DMRS, and type-2 represents a type-2 DMRS. $\Delta$ represents a quantity of subcarriers.

For values of all parameters in Formula (1), different types of DMRSs may be determined based on different tables. In addition, an RE (or a subcarrier) to which a DMRS is mapped needs to be included in a common resource block (common resource block, CRB) allocated for data transmission. For example, an RE to which a downlink DMRS is mapped is included in a CRB allocated for physical downlink shared channel (physical downlink shared channel, PDSCH) transmission. For another example, an RE to which an uplink DMRS is mapped is included in a CRB allocated for physical uplink shared channel (physical uplink shared channel, PUSCH) transmission.

For example, Table 4 shows port mapping parameters of a downlink type-1 DMRS. *p* represents a downlink DMRS port number.

**Table 4: Port mapping parameters of the type-1 DMRS for the PDSCH**

| *p* | Number of the CDM group | *Δ* | $w_f(k')$ | | $w_t(l')$ | |
|---|---|---|---|---|---|---|
| | | | *k'* =0 | *k'* =1 | *l'* =0 | *l'* =1 |
| 1000 | 0 | 0 | +1 | +1 | +1 | +1 |
| 1001 | 0 | 0 | +1 | -1 | +1 | +1 |
| 1002 | 1 | 1 | +1 | +1 | +1 | +1 |
| 1003 | 1 | 1 | +1 | -1 | +1 | +1 |
| 1004 | 0 | 0 | +1 | +1 | +1 | -1 |
| 1005 | 0 | 0 | +1 | -1 | +1 | -1 |
| 1006 | 1 | 1 | +1 | +1 | +1 | -1 |
| 1007 | 1 | 1 | +1 | -1 | +1 | -1 |

Table 5 shows port mapping parameters of a downlink type-2 DMRS. *p* represents a downlink DMRS port number.

**Table 5: Port mapping parameters of the type-2 DMRS for the PDSCH**

| *p* | Number of the CDM group | *Δ* | $w_f(k')$ | | $w_t(l')$ | |
|---|---|---|---|---|---|---|
| | | | *k'* =0 | *k'* =1 | *l'* =0 | *l'* =1 |
| 1000 | 0 | 0 | +1 | +1 | +1 | +1 |
| 1001 | 0 | 0 | +1 | -1 | +1 | +1 |
| 1002 | 1 | 2 | +1 | +1 | +1 | +1 |
| 1003 | 1 | 2 | +1 | -1 | +1 | +1 |
| 1004 | 2 | 4 | +1 | +1 | +1 | +1 |
| 1005 | 2 | 4 | +1 | -1 | +1 | +1 |
| 1006 | 0 | 0 | +1 | +1 | +1 | -1 |
| 1007 | 0 | 0 | +1 | -1 | +1 | -1 |
| 1008 | 1 | 2 | +1 | +1 | +1 | -1 |
| 1009 | 1 | 2 | +1 | -1 | +1 | -1 |
| 1010 | 2 | 4 | +1 | +1 | +1 | -1 |
| 1011 | 2 | 4 | +1 | -1 | +1 | -1 |

It should be understood that, for a reference point of *k*, if a corresponding physical downlink control channel (physical downlink control channel, PDCCH) is associated with a control resource set (CORESET) 0 and a Type0-PDCCH (Type0-PDCCH) common search space, and corresponds to a system information radio network temporary identifier (system information radio network temporary identity, SI-RNTI), the reference point of *k* is a subcarrier 0 in a resource block with a lowest number in the CORESET 0. Otherwise, the reference point of *k* is a subcarrier 0 of a CRB 0.

It may be understood that the DMRS sequence is a long sequence generated on entire carrier bandwidth, and an RE to which a DMRS is mapped is determined based on a CRB allocated for PDSCH transmission.

It should be further understood that a mapping manner of an uplink DMRS port is similar to a mapping manner of a downlink DMRS port. In the foregoing table, mapping of an uplink DMRS port number may be obtained by subtracting 1000 from the downlink DMRS port number.

The following specifically describes a DMRS port indication manner.

As shown in Table 4 and Table 5, different DMRS ports correspond to different DMRS mapping parameters, and the network device needs to indicate a DMRS port by using an antenna port field (Antenna port(s)) included in downlink control information (downlink control formation, DCI). In this way, the terminal device may determine a port used for DMRS transmission and a corresponding mapping parameter.

The antenna port field includes an indication of "a quantity of CDM groups without data (number of CDM group(s) without data)", indicating a quantity of CDM groups that are not used by the terminal device to perform data transmission, or a CDM group on which data cannot be multiplexed. Further, the "quantity of CDM groups without data" indicates a quantity of CDM groups that are not used by the terminal device to perform data transmission on a corresponding symbol. A value indicated by the "quantity of CDM groups without data" may be 1, 2, or 3. If the value indicated by the "quantity of CDM groups without data" is 1, it indicates that the CDM group 0 has no data. If the value indicated by the "quantity of CDM groups without data" is 2, it indicates that the CDM group 0 and the CDM group 1 have no data. If the value indicated by the "quantity of CDM groups without data" is 3, it indicates the CDM group 0, the CDM group 1, and the CDM group 2 have no data.

For DMRSs that are of different types and that occupy different symbol lengths, correspondences between DMRS ports and mapping parameters are different. Therefore, the antenna port field in the DCI may be defined in a plurality of tables, to correspond to the DMRSs that are of different types and that occupy different symbol lengths. A specific indication method is as follows.

For example, when the DMRS type is configured as type1 (dmrs-Type=1 or dmrs-Type is not configured), and a longest symbol occupied by a longest DMRS is configured as one symbol (maxLength=1 or maxLength is not configured), an indication relationship of the antenna port field is shown in Table 6.

**Table 6: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 0 |
| 1 | 1 | 1 |
| 2 | 1 | 0 and 1 |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 to 15 | Reserved (Reserved) | Reserved (Reserved) |

In Table 6, the value (value) of the antenna port field is a decimal value corresponding to a bit state of the antenna port field. For example, when the value of the antenna port field is 0, the DMRS port (namely, the port number) indicated by the antenna port field is 0, and a CDM group without data is the CDM group 0. To be specific, a current terminal device (a terminal device that receives DCI including the antenna port field) performs transmission of a DMRS on a time-frequency resource corresponding to the CDM group 0 through the port 0, and does not perform data transmission on the time-frequency resource corresponding to the CDM group 0. When the value of the antenna port field is 3, the DMRS port indicated by the antenna port field is 0, and CDM groups without data are the CDM group 0 and the CDM group 1. To be specific, the current terminal device performs transmission of the DMRS on the time-frequency resource corresponding to the CDM group 0 through the port 0, a time-frequency resource corresponding to the CDM group 1 is reserved (that is, the current terminal device does not perform data transmission on the time-frequency resource), and both the CDM group 0 and the CDM group 1 may be used for scheduling of another terminal device. The current terminal device does not perform data transmission on time-frequency resources corresponding to the CDM group 0 and the CDM group 1.

For the type-1 DMRS, there are a maximum of two CDM groups. Therefore, the CDM group indication in Table 6 has only two candidate values: 1 and 2. For the single-symbol type-1 DMRS, a maximum of four DMRS ports can be multiplexed. Therefore, candidate values of DMRS ports indicated in Table 6 are 0 to 3.

When a quantity of data streams is 4 or less, there is only one codeword (codeword). When the quantity of data streams is greater than 4, there are two codewords. Therefore, Table 6 further includes information about a quantity of codewords. In embodiments of this application, the quantity of data streams is the same as a quantity of DMRS ports indicated by the antenna port field.

It should be understood that, in embodiments of this application, for the downlink DMRS, DMRS port numbers are 1000 to 1023, and for the uplink DMRS, DMRS port numbers are 0 to 23. However, in an antenna port indication table, DMRS port indexes are only 0 to 23. During downlink scheduling, the DMRS port index indicated by the DCI needs to be increased by 1000, to obtain an actual DMRS port number.

When the DMRS type is configured as type1 (dmrs-Type=1 or dmrs-Type is not configured), and a longest symbol occupied by a DMRS is configured as two symbols (maxLength=2 or maxLength is configured as len2), an indication relationship of the antenna port field is shown in Table 7.

**Table 7: Antenna port indication table (dmrs-Type=1 and maxLength=2)**

| One codeword (one codeword) Codeword 0 is enabled (codeword 0 enable), and codeword 1 is disabled (codeword 1 disable) | | | | Two codewords (one codeword) Codeword 0 is enabled (codeword 0 enable), and codeword 1 is enabled (codeword 1 enable) | | | |
|---|---|---|---|---|---|---|---|
| Value (value) | Quantity of CDM groups without data (number of CDM group(s) without data) | DMRS port (DMRS port(s)) | Quantity of front-loaded symbols (number of front-loaded symbols) | Value (value) | Quantity of CDM groups without data (number of CDM group(s) without data) | DMRS port (DMRS port(s)) | Quantity of front-loaded symbols (number of front-loaded symbols) |
| 0 | 1 | 0 | 1 | 0 | 2 | 0 to 4 | 2 |
| 1 | 1 | 1 | 1 | 1 | 2 | 0, 1, 2, 3, 4, and 6 | 2 |
| 2 | 1 | 0 and 1 | 1 | 2 | 2 | 0, 1, 2, 3, 4, 5, and 6 | 2 |
| 3 | 2 | 0 | 1 | 3 | 2 | 0, 1, 2, 3, 4, 5, 6, and 7 | 2 |
| 4 | 2 | 1 | 1 | 4 to 31 | Reserved (Reserved) | Reserved (Reserved) | Reserved (Reserved) |
| 5 | 2 | 2 | 1 | | | | |
| 6 | 2 | 3 | 1 | | | | |
| 7 | 2 | 0 and 1 | 1 | | | | |
| 8 | 2 | 2 and 3 | 1 | | | | |
| 9 | 2 | 0 to 2 | 1 | | | | |
| 10 | 2 | 0 to 3 | 1 | | | | |
| 11 | 2 | 0 and 2 | 1 | | | | |
| 12 | 2 | 0 | 2 | | | | |
| 13 | 2 | 1 | 2 | | | | |
| 14 | 2 | 2 | 2 | | | | |
| 15 | 2 | 3 | 2 | | | | |
| 16 | 2 | 4 | 2 | | | | |
| 17 | 2 | 5 | 2 | | | | |
| 18 | 2 | 6 | 2 | | | | |

(continued)

| One codeword (one codeword) Codeword 0 is enabled (codeword 0 enable), and codeword 1 is disabled (codeword 1 disable) | | | | Two codewords (one codeword) Codeword 0 is enabled (codeword 0 enable), and codeword 1 is enabled (codeword 1 enable) | | | |
|---|---|---|---|---|---|---|---|
| Value (value) | Quantity of CDM groups without data (number of CDM group(s) without data) | DMRS port (DMRS port(s)) | Quantity of front-loaded symbols (number of front-loaded symbols) | Value (value) | Quantity of CDM groups without data (number of CDM group(s) without data) | DMRS port (DMRS port(s)) | Quantity of front-loaded symbols (number of front-loaded symbols) |
| 19 | 2 | 7 | 2 | | | | |
| 20 | 2 | 0 and 1 | 2 | | | | |
| 21 | 2 | 2 and 3 | 2 | | | | |
| 22 | 2 | 4 and 5 | 2 | | | | |
| 23 | 2 | 6 and 7 | 2 | | | | |
| 24 | 2 | 0 and 4 | 2 | | | | |
| 25 | 2 | 2 and 6 | 2 | | | | |
| 26 | 2 | 0, 1, and 4 | 2 | | | | |
| 27 | 2 | 2, 3, and 6 | 2 | | | | |
| 28 | 2 | 0, 1, 4, and 5 | 2 | | | | |
| 29 | 2 | 2, 3, 6, and 7 | 2 | | | | |
| 30 | 2 | 0, 2, 4, and 6 | 2 | | | | |
| 31 | Reserved (Reserved ) | Reserved (Reserved ) | Reserved (Reserved) | | | | |

The indication method shown in Table 7 is similar to the indication method shown in Table 6. The higher layer parameter is configured as maxLength=2, indicating that a quantity of DMRS symbols may be 1 or 2. Content indicated by values 0 to 11 of the antenna port field in Table 7 is completely the same as that indicated by values 0 to 11 of the antenna port field in Table 6. For the double-symbol type-1 DMRS, only a maximum of eight DMRS ports can be multiplexed. Therefore, candidate values of DMRS port numbers indicated in Table 7 are 0 to 7. In addition, Table 7 further includes information about the quantity of codewords.

When the DMRS type is configured as type2 (dmrs-Type=2 or dmrs-Type is configured as type2), and a longest symbol occupied by a DMRS is configured as one symbol (maxLength=1 or maxLength is not configured), an indication relationship of the antenna port field is shown in Table 8.

**Table 8: Antenna port indication table (dmrs-Type=2 and maxLength=1)**

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
|---|---|---|---|---|---|
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 0 | 1 | 0 | 0 | 2 | 0 to 4 |
| 1 | 1 | 1 | 1 | 2 | 0 to 5 |
| 2 | 1 | 0 and 1 | 2 to 31 | Reserved (Reserved) | Reserved (Reserved) |
| 3 | 2 | 0 | | | |

(continued)

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
|---|---|---|---|---|---|
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 4 | 2 | 1 | | | |
| 5 | 2 | 2 | | | |
| 6 | 2 | 3 | | | |
| 7 | 2 | 0 and 1 | | | |
| 8 | 2 | 2 and 3 | | | |
| 9 | 2 | 0 to 2 | | | |
| 10 | 2 | 0 to 3 | | | |
| 11 | 3 | 0 | | | |
| 12 | 3 | 1 | | | |
| 13 | 3 | 2 | | | |
| 14 | 3 | 3 | | | |
| 15 | 3 | 4 | | | |
| 16 | 3 | 5 | | | |
| 17 | 3 | 0 and 1 | | | |
| 18 | 3 | 2 and 3 | | | |
| 19 | 3 | 4 and 5 | | | |
| 20 | 3 | 0 to 2 | | | |
| 21 | 3 | 3 to 5 | | | |
| 22 | 3 | 0 to 3 | | | |
| 23 | 2 | 0 and 2 | | | |
| 24 to 31 | Reserved (Reserved) | Reserved (Reserved) | | | |

The indication method shown in Table 8 is similar to the indication method shown in Table 6. The higher layer parameter is configured as maxLength=1 and dmrs-Type=1. For the single-symbol type-2 DMRS, a maximum of six DMRS ports can be multiplexed. Therefore, candidate values of DMRS ports indicated in Table 8 are 0 to 5. In addition, Table 8 further includes information about the quantity of codewords.

When the DMRS type is configured as type2 (dmrs-Type=2 or dmrs-Type is configured as type2), and a longest symbol occupied by a DMRS is configured as two symbols (maxLength=2 or maxLength is configured as len2), an indication relationship of the antenna port field is shown in Table 9.

**Table 9: Antenna port indication table (dmrs-Type=2 and maxLength=2)**

| One codeword (one codeword) Codeword 0 is enabled (codeword 0 enable), and codeword 1 is disabled (codeword 1 disable) | | | | Two codewords (one codeword) Codeword 0 is enabled (codeword 0 enable), and codeword 1 is enabled (codeword 1 enable) | | | |
|---|---|---|---|---|---|---|---|
| Value (value) | Quantity of CDM groups without data (number of CDM group(s) without data) | DMRS port (DMRS port(s)) | Quantity of front-loaded symbols (number of front-loaded symbols) | Value (value) | Quantity of CDM groups without data (number of CDM group(s) without data) | DMRS port (DMRS port(s)) | Quantity of front-loaded symbols (number of front-loaded symbols) |
| 0 | 1 | 0 | 1 | 0 | 3 | 0 to 4 | 1 |
| 1 | 1 | 1 | 1 | 1 | 3 | 0 to 5 | 1 |
| 2 | 1 | 0 and 1 | 1 | 2 | 2 | 0, 1, 2, 3, and 6 | 2 |
| 3 | 2 | 0 | 1 | 3 | 2 | 0, 1, 2, 3, 6, and 8 | 2 |
| 4 | 2 | 1 | 1 | 4 | 2 | 0, 1, 2, 3, 6, 7, and 8 | 2 |
| 5 | 2 | 2 | 1 | 5 | 2 | 0, 1, 2, 3, 6, 7, 8, and 9 | 2 |
| 6 | 2 | 3 | 1 | 6 to 63 | Reserved (Reserved) | Reserved (Reserved) | Reserved (Reserved) |
| 7 | 2 | 0 and 1 | 1 | | | | |
| 8 | 2 | 2 and 3 | 1 | | | | |
| 9 | 2 | 0 to 2 | 1 | | | | |
| 10 | 2 | 0 to 3 | 1 | | | | |
| 11 | 3 | 0 | 1 | | | | |
| 12 | 3 | 1 | 1 | | | | |
| 13 | 3 | 2 | 1 | | | | |
| 14 | 3 | 3 | 1 | | | | |
| 15 | 3 | 4 | 1 | | | | |
| 16 | 3 | 5 | 1 | | | | |
| 17 | 3 | 0 and 1 | 1 | | | | |
| 18 | 3 | 2 and 3 | 1 | | | | |
| 19 | 3 | 4 and 5 | 1 | | | | |
| 20 | 3 | 0 to 2 | 1 | | | | |
| 21 | 3 | 3 to 5 | 1 | | | | |
| 22 | 3 | 0 to 3 | 1 | | | | |
| 23 | 2 | 0 and 2 | 1 | | | | |
| 24 | 3 | 0 | 2 | | | | |
| 25 | 3 | 1 | 2 | | | | |
| 26 | 3 | 2 | 2 | | | | |
| 27 | 3 | 3 | 2 | | | | |
| 28 | 3 | 4 | 2 | | | | |
| 29 | 3 | 5 | 2 | | | | |

(continued)

| One codeword (one codeword)<br>Codeword 0 is enabled (codeword 0 enable), and<br>codeword 1 is disabled (codeword 1 disable) | | | | Two codewords (one codeword)<br>Codeword 0 is enabled (codeword 0 enable), and<br>codeword 1 is enabled (codeword 1 enable) | | | |
|---|---|---|---|---|---|---|---|
| Value (value) | Quantity of CDM groups without data (number of CDM group(s) without data) | DMRS port (DMRS port(s)) | Quantity of front-loaded symbols (number of front-loaded symbols) | Value (value) | Quantity of CDM groups without data (number of CDM group(s) without data) | DMRS port (DMRS port(s)) | Quantity of front-loaded symbols (number of front-loaded symbols) |
| 30 | 3 | 6 | 2 | | | | |
| 31 | 3 | 7 | 2 | | | | |
| 32 | 3 | 8 | 2 | | | | |
| 33 | 3 | 9 | 2 | | | | |
| 34 | 3 | 10 | 2 | | | | |
| 35 | 3 | 11 | 2 | | | | |
| 36 | 3 | 0 and 1 | 2 | | | | |
| 37 | 3 | 2 and 3 | 2 | | | | |
| 38 | 3 | 4 and 5 | 2 | | | | |
| 39 | 3 | 6 and 7 | 2 | | | | |
| 40 | 3 | 8 and 9 | 2 | | | | |
| 41 | 3 | 10 and 11 | 2 | | | | |
| 42 | 3 | 0, 1, and 6 | 2 | | | | |
| 43 | 3 | 2, 3, and 8 | 2 | | | | |
| 44 | 3 | 4, 5, and 10 | 2 | | | | |
| 45 | 3 | 0, 1, 6, and 7 | 2 | | | | |
| 46 | 3 | 2, 3, 8, and 9 | 2 | | | | |
| 47 | 3 | 4, 5, 10, and 11 | 2 | | | | |
| 48 | 1 | 0 | 2 | | | | |
| 49 | 1 | 1 | 2 | | | | |
| 50 | 1 | 6 | 2 | | | | |
| 51 | 1 | 7 | 2 | | | | |
| 52 | 1 | 0 and 1 | 2 | | | | |
| 53 | 1 | 6 and 7 | 2 | | | | |
| 54 | 2 | 0 and 1 | 2 | | | | |
| 55 | 2 | 2 and 3 | 2 | | | | |
| 56 | 2 | 6 and 7 | 2 | | | | |
| 57 | 2 | 8 and 9 | 2 | | | | |
| 58 to 63 | Reserved (Reserved) | Reserved (Reserved) | Reserved (Reserved) | | | | |

For the double-symbol type-2 DMRS, a maximum of 12 DMRS ports can be multiplexed. Therefore, candidate values of DMRS ports indicated in Table 9 are 0 to 11. In addition, Table 9 further includes information about the quantity of codewords.

It should be understood that DMRS port multiplexing and indication shown in Table 2 to Table 9 are applicable to a case in which the FD-OCC is 2.

To increase the quantity of orthogonal DMRS ports, the length of the FD-OCC code may be increased. In an implementation, the length of the FD-OCC code is extended from 2 (namely, FD-OCC-2) to 4 (namely, FD-OCC-4). In this case, a quantity of orthogonal DMRS ports that can be multiplexed in each CDM group is extended from 2 to 4. In this case, maximum quantities of orthogonal DMRS ports supported by the type-1 DMRS and the type-2 DMRS are shown in Table 10.

**Table 10: Maximum quantities of orthogonal DMRS ports supported by FD-OCC-4**

|  | Type-1 DMRS | Type-2 DMRS |
|---|---|---|
| Single-symbol | 8 | 12 |
| Double-symbol | 16 | 24 |

Correspondingly, indication of the DMRS ports complies with a principle that original ports are peers of new ports, and DMRS ports in a same CDM group are preferentially allocated to a same terminal device. The mapping relationship between the original DMRS ports (that is, DMRS ports corresponding to the FD-OCC code with the length of 2) and the FD-OCC code remains unchanged. On this basis, the new DMRS ports are obtained through extension.

For example, in a possible implementation, Table 11 shows a DMRS sequence port mapping parameter relationship corresponding to the FD-OCC with the length of 4. For the type-1 DMRS, when the length of the FD-OCC code is 2, the DMRS ports are 1000 to 1007. After the length of the FD-OCC code is extended to 4, based on the DMRS ports (that is, the DMRS ports corresponding to the FD-OCC code with the length of 2) 1000 to 1007, new DMRS ports (that is, DMRS ports corresponding to the FD-OCC code with the length of 4 except the DMRS ports 1000 to 1007) are 1008 to 1015. The DMRS ports 1008 to 1011 are new ports for the single-symbol DMRS, and the DMRS ports 1012 to 1015 are new DMRS ports for the double-symbol DMRS.

**Table 11: DMRS sequence port mapping parameters corresponding to the FD-OCC with the length of 4**

| $p$ | Number of the CDM group | $\Delta$ | $w_f(k')$ | | | | $w_t(l')$ | |
|---|---|---|---|---|---|---|---|---|
| | | | $k'=0$ | $k'=1$ | $k'=2$ | $k'=3$ | $l'=0$ | $l'=1$ |
| 1000 | 0 | 0 | +1 | +1 | +1 | +1 | +1 | +1 |
| 1001 | 0 | 0 | +1 | -1 | +1 | -1 | +1 | +1 |
| 1002 | 1 | 1 | +1 | +1 | +1 | +1 | +1 | +1 |
| 1003 | 1 | 1 | +1 | -1 | +1 | -1 | +1 | +1 |
| 1004 | 0 | 0 | +1 | +1 | +1 | +1 | +1 | -1 |
| 1005 | 0 | 0 | +1 | -1 | +1 | -1 | +1 | -1 |
| 1006 | 1 | 1 | +1 | +1 | +1 | +1 | +1 | -1 |
| 1007 | 1 | 1 | +1 | -1 | +1 | -1 | +1 | -1 |
| 1008 | 0 | 0 | +1 | +j | -1 | -j | +1 | +1 |
| 1009 | 0 | 0 | +1 | -j | -1 | +j | +1 | +1 |
| 1010 | 1 | 1 | +1 | +j | -1 | -j | +1 | +1 |
| 1011 | 1 | 1 | +1 | -j | -1 | +j | +1 | +1 |
| 1012 | 0 | 0 | +1 | +j | -1 | -j | +1 | -1 |
| 1013 | 0 | 0 | +1 | -j | -1 | +j | +1 | -1 |
| 1014 | 1 | 1 | +1 | +1 | -1 | -1 | +1 | -1 |
| 1015 | 1 | 1 | +1 | -j | -1 | +j | +1 | -1 |

The new DMRS ports shown in Table 11 are numbered in the following manner: For the single-symbol type-1 DMRS, the original DMRS ports (that is, the DMRS ports corresponding to the FD-OCC code with the length of 2) are 1000 to 1003. After the length of the FD-OCC code is extended to 4, based on the DMRS ports 1000 to 1007, the new DMRS ports (that is, the DMRS ports corresponding to the FD-OCC code with the length of 4 except the DMRS ports 1000 to 1007) are 1008 to 1011. For the double-symbol type-1 DMRS, after the length of the FD-OCC code is extended to 4, based on the DMRS ports 1000 to 1007, the new DMRS ports (that is, the DMRS ports corresponding to the FD-OCC code with the length of 4 except the DMRS ports 1000 to 1007) are 1008 to 1015.

Optionally, in embodiments of this application, for the type-1 DMRS, after the length of the FD-OCC code is extended to 4, a mapping relationship between a physical resource and a DMRS sequence corresponding to the DMRS ports 1000 to 1007 is the same as that between the physical resource and a DMRS sequence corresponding to the DMRS ports 1008 to 1015.

Optionally, the foregoing DMRS ports (the DMRS ports 1000 to 1007 and the DMRS ports 1008 to 1015) may be numbered in a unified manner, or may be separately numbered. For example, if the DMRS ports are numbered in a unified manner, it indicates that the DMRS ports are numbered in a unified manner in a same DMRS sequence port mapping parameter table, for example, Table 11. For another example, if some of the DMRS ports are separately numbered, it indicates that the DMRS ports 1000 to 1007 and the DMRS ports 1008 to 1015 are numbered in different DMRS sequence port mapping parameter tables. One of the DMRS sequence port mapping parameter tables, for example, Table 12, corresponds to the DMRS ports 1000 to 1007. The other DMRS sequence port mapping parameter table, for example, Table 13, corresponds to the DMRS ports 1008 to 1015. This is not limited in embodiments of this application.

**Table 12: DMRS sequence port mapping parameters corresponding to the FD-OCC with the length of 4 (I)**

| $p$ | Number of the CDM group | $\Delta$ | $w_f(k')$ | | | | $w_t(l')$ | |
|---|---|---|---|---|---|---|---|---|
| | | | $k'=0$ | $k'=1$ | $k'=2$ | $k'=3$ | $l'=0$ | $l'=1$ |
| 1000 | 0 | 0 | +1 | +1 | +1 | +1 | +1 | +1 |
| 1001 | 0 | 0 | +1 | -1 | +1 | -1 | +1 | +1 |
| 1002 | 1 | 1 | +1 | +1 | +1 | +1 | +1 | +1 |
| 1003 | 1 | 1 | +1 | -1 | +1 | -1 | +1 | +1 |
| 1004 | 0 | 0 | +1 | +1 | +1 | +1 | +1 | -1 |
| 1005 | 0 | 0 | +1 | -1 | +1 | -1 | +1 | -1 |
| 1006 | 1 | 1 | +1 | +1 | +1 | +1 | +1 | -1 |
| 1007 | 1 | 1 | +1 | -1 | +1 | -1 | +1 | -1 |

**Table 13: DMRS sequence port mapping parameters corresponding to the FD-OCC with the length of 4 (II)**

| $p$ | Number of the CDM group | $\Delta$ | $w_f(k')$ | | | | $w_t(l')$ | |
|---|---|---|---|---|---|---|---|---|
| | | | $k'=0$ | $k'=1$ | $k'=2$ | $k'=3$ | $l'=0$ | $l'=1$ |
| 1008 | 0 | 0 | +1 | +j | -1 | -j | +1 | +1 |
| 1009 | 0 | 0 | +1 | -j | -1 | +j | +1 | +1 |
| 1010 | 1 | 1 | +1 | +j | -1 | -j | +1 | +1 |
| 1011 | 1 | 1 | +1 | -j | -1 | +j | +1 | +1 |
| 1012 | 0 | 0 | +1 | +j | -1 | -j | +1 | -1 |
| 1013 | 0 | 0 | +1 | -j | -1 | +j | +1 | -1 |
| 1014 | 1 | 1 | +1 | +1 | -1 | -1 | +1 | -1 |
| 1015 | 1 | 1 | +1 | -j | -1 | +j | +1 | -1 |

Optionally, in another possible implementation, for the single-symbol type-1 DMRS, when the length of the FD-OCC code is 2, the DMRS ports are 1000 to 1003. After the length of the FD-OCC code is extended to 4, based on the original DMRS ports (that is, the DMRS ports corresponding to the FD-OCC code with the length of 2) 1000 to 1003, the new DMRS ports (that is, the DMRS ports corresponding to the FD-OCC code with the length of 4 except the DMRS ports 1000 to 1003) may be 1004 to 1007. For the double-symbol type-1 DMRS, when the length of the FD-OCC code is 2, the DMRS ports are 1000 to 1007. After the length of the FD-OCC code is extended to 4, based on the original DMRS ports (that is, the DMRS ports corresponding to the FD-OCC code with the length of 2) 1000 to 1007, the new DMRS ports (that is, the DMRS ports corresponding to the FD-OCC code with the length of 4 except the DMRS ports 1000 to 1007) may be 1008 to 1015. In other words, the new DMRS ports may be numbered in a manner different from that shown in Table 11.

For the type-2 DMRS, when the length of the FD-OCC code is 2, the DMRS ports for the single-symbol type-2 DMRS are 1000 to 1005, and the DMRS ports for the double-symbol type-2 DMRS are 1000 to 1011.

After the length of the OCC code is extended to 4, based on the DMRS ports 1000 to 1011, the new DMRS ports (that is, the DMRS ports corresponding to the FD-OCC code with the length of 4 except the DMRS ports 1000 to 1011) are 1012 to 1023. The DMRS ports 1012 to 1017 are new ports for the single-symbol DMRS, and the DMRS ports 1012 to 1023 are new DMRS ports for the double-symbol DMRS.

In embodiments of this application, for the type-2 DMRS, after the length of the FD-OCC code is extended to 4, a mapping relationship between a physical resource and a DMRS sequence corresponding to the DMRS ports 1000 to 1011 is the same as that between the physical resource and a DMRS sequence corresponding to the DMRS ports 1012 to 1023.

Optionally, the DMRS ports (the DMRS ports 1000 to 1011 and the DMRS ports 1012 to 1023) may be numbered in a unified manner, or may be separately numbered. For example, if the DMRS ports are numbered in a unified manner, it indicates that the DMRS ports are numbered in a unified manner in a same DMRS sequence port mapping parameter table. If some of the DMRS ports are separately numbered, it indicates that the DMRS ports 1000 to 1011 and the DMRS ports 1012 to 1023 are numbered in different DMRS sequence port mapping parameter tables. One of the DMRS sequence port mapping parameter tables corresponds to the DMRS ports 1000 to 1011, and the other DMRS sequence port mapping parameter table corresponds to the DMRS ports 1012 to 1023. This is not limited in embodiments of this application.

In another possible implementation, when the length of the FD-OCC code is 2, the DMRS ports for the single-symbol type-2 DMRS are 1000 to 1005. After the length of the OCC code is extended to 4, based on the DMRS ports 1000 to 1005, new DMRS ports (that is, DMRS ports corresponding to the FD-OCC code with the length of 4 except the DMRS ports 1000 to 1005) may be 1006 to 1011. When the length of the FD-OCC code is 2, the DMRS ports for the double-symbol type-2 DMRS are 1000 to 1011. After the length of the FD-OCC code is extended to 4, based on the DMRS ports 1000 to 1011, new DMRS ports (that is, DMRS ports corresponding to the FD-OCC code with the length of 4 except the DMRS ports 1000 to 1011) may be 1012 to 1023. In other words, for the type-2 DMRS, the DMRS ports may also be numbered in different manners.

Based on the foregoing mapping manners, the DMRS ports may be indicated by adding an offset value to a table (for example, Table 6 to Table 9) corresponding to the FD-OCC with the length of 2. For the type-1 DMRS, the offset value is 0 or 8. For the type-2 DMRS, the offset value is 0 or 12.

For example, Table 14 shows a port indication relationship table of the type-1 DMRS after the length of the FD-OCC is extended to 4.

**Table 14: Antenna port indication table (dmrs-Type=1 and maxLength=1) corresponding to the FD-OCC with the length of 4**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 8 |
| 1 | 1 | 9 |
| 2 | 1 | 8 and 9 |
| 3 | 2 | 8 |
| 4 | 2 | 9 |
| 5 | 2 | 10 |
| 6 | 2 | 11 |
| 7 | 2 | 8 and 9 |
| 8 | 2 | 10 and 11 |
| 9 | 2 | 8 to 10 |
| 10 | 2 | 8 to 11 |
| 11 | 2 | 8 and 10 |

(continued)

| One codeword (one codeword) | | |
|---|---|---|
| Codeword 0 is enabled (codeword 0 enable), and codeword 1 is disabled (codeword 1 disable) | | |
| Value (value) | Quantity of CDM groups without data (number of CDM group(s) without data) | DMRS port (DMRS port(s)) |
| 12 to 15 | Reserved (Reserved) | Reserved (Reserved) |

The terminal device determines the value (value) of the antenna port field based on the antenna port field in the DCI, and may further determine a DMRS port number indicated by the field. Further, based on an offset value (for example, 8) indicated by the higher layer signaling, the terminal device may determine a final DMRS port number.

Based on the foregoing content, it can be learned that: When the code length of the FD-OCC is 2, the DMRS ports for the type-1 DMRS are 1000 to 1007. When the code length of the FD-OCC is 4, the DMRS ports for the type-1 DMRS are 1000 to 1015.

When the code length of the FD-OCC is 2, the DMRS ports for the type-2 DMRS are 1000 to 1012. When the code length of the FD-OCC is 4, the DMRS ports for the type-1 DMRS are 1000 to 1023.

Alternatively, for the single-symbol type-1 DMRS, when the code length of the FD-OCC is 2, the DMRS ports are 1000 to 1003; and when the code length of the FD-OCC is 4, the DMRS ports are 1000 to 1007. For the single-symbol type-2 DMRS, when the code length of the FD-OCC is 2, the DMRS ports are 1000 to 1005; and when the length of the FD-OCC code is 4, the DMRS ports are 1000 to 1011.

For a terminal device that supports both the FD-OCC with the code length of 2 and the FD-OCC with the code length of 4, for the type-1 DMRS, if the terminal device determines that final DMRS port numbers are 1000 to 1007, the terminal device does not know whether the code length of the FD-OCC corresponding to the DMRS ports 1000 to 1007 is 2 or 4. Consequently, a behavior of the terminal device is definite. For example, the terminal device does not determine a hardware implementation method (for example, a DMRS decoding or filtering method) to be used to demodulate the DMRS. As a result, DMRS parsing performance may be degraded, and communication efficiency is affected.

For a terminal device that supports both the FD-OCC with the code length of 2 and the FD-OCC with the code length of 4, for the type-2 DMRS, if the terminal device determines that final DMRS port numbers are 1000 to 1011, the terminal device does not know whether the code length of the FD-OCC corresponding to the DMRS ports 1000 to 1007 is 2 or 4. Consequently, a behavior of the terminal device is definite. As a result, DMRS parsing performance may be degraded, and communication efficiency is affected.

After the code length of the FD-OCC is extended from 2 to 4, for the single-symbol type-1 DMRS and the single-symbol type-2 DMRS, in a scenario in which the quantity of data streams is 3 or 4 (a rank 3 or a rank 4), that is, when the quantity of DMRS ports is 3 or 4, DMRS ports in only two CDM groups can be indicated based on the foregoing antenna port indication tables.

Table 14 is used as an example. A value of an antenna port field corresponding to the rank 3 (that is, the quantity of DMRS ports being 3 or the quantity of data streams being 3) is 9. In this case, indicated DMRS ports are 8, 9, and 10, that is, downlink DMRS port numbers are 1008, 1009, and 1010. It can be learned from Table 11 that the ports 1008 and 1009 belong to the CDM group 0, and the port 1010 belongs to the CDM group 1.

Table 6 is used as another example. A value of an antenna port field corresponding to the rank 4 (that is, the quantity of DMRS ports being 4 or the quantity of data streams being 4) is 10. In this case, indicated DMRS ports are 0, 1, 2, and 3, that is, downlink DMRS port numbers are 1000, 1001, 1002, and 1003. It can be learned from Table 11 that the ports 1000 and 1001 belong to the CDM group 0, and the ports 1002 and 1003 belong to the CDM group 1.

Table 8 is used as another example. A value of an antenna port field corresponding to the rank 4 (that is, the quantity of DMRS ports being 4 or the quantity of data streams being 4) is 22. In this case, indicated DMRS ports are 0, 1, 2, and 3, that is, downlink DMRS port numbers are 1000, 1001, 1002, and 1003. It can be learned from Table 5 that the ports 1000 and 1001 belong to the CDM group 0, and the ports 1002 and 1003 belongs to the CDM group 1.

After the code length of the FD-OCC is extended from 2 to 4, for the double-symbol type-1 DMRS and the double-symbol type-2 DMRS, in a scenario in which the quantity of data streams is greater than 4, that is, when the quantity of DMRS ports is greater than 4, DMRS ports in only two CDM groups can be indicated based on the foregoing antenna port indication tables.

Table 7 is used as another example. A value of an antenna port field corresponding to a rank 6 (that is, the quantity of DMRS ports being 6 or the quantity of data streams being 6) is 1. In this case, indicated DMRS ports are 0, 1, 2, 3, 4, and 6, that is, downlink DMRS port numbers are 1000, 1001, 1002, 1003, 1004, and 1006. It can be learned from Table 4 that the ports 1000, 1001, and 1004 belong to the CDM group 0, and the ports 1002, 1003, and 1006 belong to the CDM group 1.

Table 9 is used as another example. A value of an antenna port field corresponding to a rank 5 (that is, the quantity of DMRS ports being 5 or the quantity of data streams being 5) is 2. In this case, indicated DMRS ports are 0, 1, 2, 3, and 6, that is, downlink DMRS port numbers are 1000, 1001, 1002, 1003, and 1006. It can be learned from Table 5 that the ports 1000, 1001, and 1006 belong to the CDM group 0, and the ports 1002 and 1003 belong to the CDM group 1.

Therefore, based on a current indication manner, for the single-symbol type-1 DMRS and the single-symbol type-2 DMRS, when the quantity of data streams is 3 or 4, it cannot indicate that DMRS ports are in a single CDM group. To be specific, for the terminal device, a DMRS corresponding to the quantity of streams being 3 or 4 is not communicated on the DMRS port included in the single CDM group (that is, not communicated on a same time-frequency resource). Consequently, complexity of implementing DMRS orthogonality by the terminal device is high, a time-frequency resource is wasted, orthogonality between DMRS ports allocated to the terminal device cannot be well satisfied, and communication efficiency is affected.

For the double-symbol type-1 DMRS and the double-symbol type-2 DMRS, when the quantity of data streams is greater than 4, it cannot indicate that DMRS ports are in a single CDM group. To be specific, for the terminal device, a DMRS corresponding to more than four streams is not communicated on DMRS ports included in the single CDM group (that is, not communicated on same time-frequency resources). Consequently, complexity of implementing DMRS orthogonality by the terminal device is also high, a time-frequency resource is wasted, orthogonality between DMRS ports allocated to the terminal device cannot be well satisfied, and communication efficiency is affected.

Based on this, a signal transmission method is provided in this application. A code length of a mask corresponding to a reference signal is indicated to a receive device, to ensure that the receive device is definite about the length of the mask used for the reference signal when supporting masks with different lengths, so that the receive device may use a proper hardware implementation method (for example, a reference signal decoding or filtering method), to obtain a better demodulation effect when different reference signal ports are multiplexed, and improve reference signal transmission efficiency.

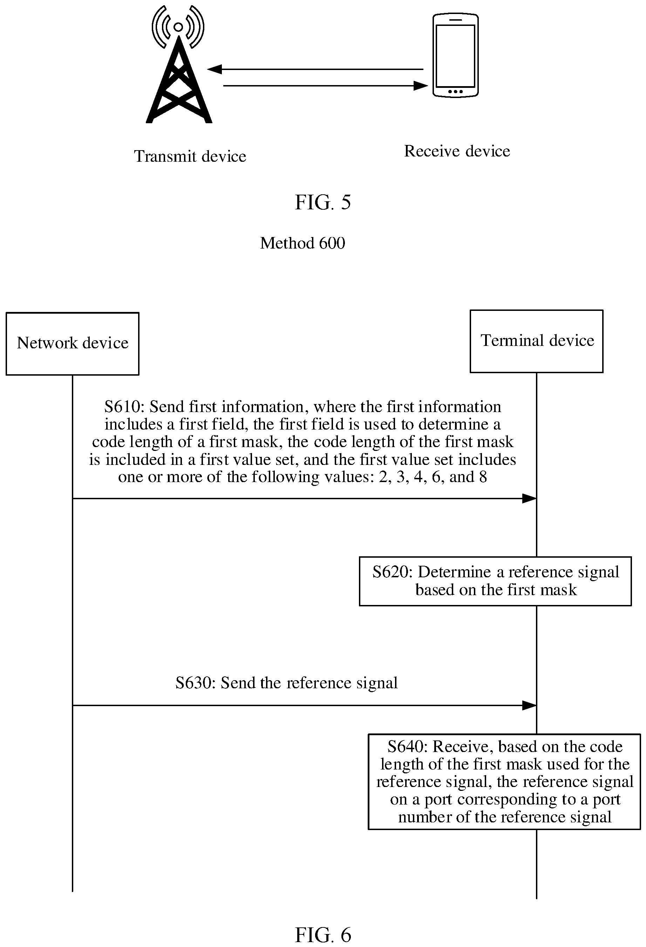

For example, FIG. 5 is a diagram of a communication system applicable to an embodiment of this application. As shown in FIG. 5, the communication system includes a receive device and a transmit device. The receive device may indicate, to the transmit device by using the signal transmission method provided in this application, a code length of a mask corresponding to a reference signal. In the example shown in FIG. 5, the transmit device is a network device, and the receive device is a terminal device.

It may be understood that the receive end and the transmit end do not limit receiving and sending of the reference signal. For example, for a downlink reference signal, the receive device is a terminal device, and the transmit device is a network device. For another example, for an uplink reference signal, the receive device is a network device, and the transmit device is a terminal device.

It may be understood that, in another application scenario of this application, the transmit device may alternatively be a terminal device, and the receive device may be a network device. Alternatively, both the receive device and the transmit device are different network devices. Alternatively, both the receive device and the transmit device are different terminal devices. This is not limited herein in this embodiment of this application.

It should be understood that the communication system shown in FIG. 5 may further include more network nodes, for example, a terminal device, a network device, or a transmission reception point (transmission reception point, TRP). The network device or the terminal device included in the communication system shown in FIG. 5 may be the network device or the terminal device in the foregoing various forms. Details are not described one by one in the figures in embodiments of this application.

It should be further understood that, in this embodiment of this application, the "reference signal" may include an uplink reference signal and a downlink reference signal.

For example, the uplink reference signal may include a sounding reference signal (sounding reference signal, SRS), a DMRS of uplink information, a phase tracking signal (phase-tracking reference signal, PTRS), or a positioning reference signal. The "uplink information" may be a physical uplink shared channel (physical uplink shared channel, PUSCH), data carried on the PUSCH, a physical uplink control channel (physical uplink control channel, PUCCH), or data carried on the PUCCH. This is not specifically limited in this application. For example, the uplink reference signal may be a DMRS of the PUSCH, a DMRS of the PUCCH, or a PTRS of the PUSCH.

For example, the downlink reference signal may include a channel state information reference signal (channel state information reference signal, CSI-RS) or a DMRS of downlink information. The "downlink information" may be a physical downlink shared channel (physical downlink shared channel, PDSCH), data carried on the PDSCH, a physical downlink control channel (physical downlink control channel, PDCCH), data carried on the PDCCH, or a physical broadcast channel (physical broadcast channel, PBCH). This is not specifically limited in this application. For example, the downlink reference signal may be a DMRS of the PDSCH, a DMRS of the PDCCH, a DMRS of the PBCH, a PTRS of the PDSCH, or the like.

In this embodiment of this application, the mask may include an orthogonal code and a non-orthogonal code. The code length of the mask may be a code length of the orthogonal code or a code length of the non-orthogonal code. For example, the code length of the mask may be a code length of an OCC or a code length of a cyclic shift (cyclic shift, CS) code. The OCC may be a TD-OCC or an FD-OCC.

It should be understood that, in this embodiment of this application, a mask of a reference signal port may be understood as a mask of a reference signal, a mask of a reference signal sequence, or a mask corresponding to the reference signal port.

For ease of describing the solutions of this application, in the following specific examples, an example in which the reference signal is a downlink DMRS and the mask is an FD-OCC is used for description. However, it should be understood that this should not constitute any limitation on this embodiment of this application, and the solutions provided in this application are also applicable to another reference signal and/or another mask.

With reference to FIG. 6, the following describes in detail the signal transmission method provided in this application. FIG. 6 is a schematic interaction diagram of a signal transmission method 600 according to an embodiment of this application. The method 600 may be applied to the scenario shown in FIG. 5, and certainly may also be used in another communication scenario. This is not limited herein in this embodiment of this application.

It should be further understood that, in the example shown in FIG. 6, an example in which a terminal device is a receive device of a DMRS and a network device is a transmit device of the DMRS is used. However, in another embodiment of this application, the transmit device of the DMRS may alternatively be a terminal device, and the receive device of the DMRS is a network device.

It should be further understood that in the following example, the method is described by using an example in which the method is performed by a terminal device and a network device. By way of example, and not a limitation, the method may alternatively be performed by chips, chip systems, processors, or the like used in the terminal device and the network device.

As shown in FIG. 6, the method 600 shown in FIG. 6 may include S610 to S640. The following describes the steps in the method 600 in detail with reference to FIG. 6.

S610: The network device sends first information to the terminal device, where the first information includes a first field, the first field is used to determine a code length of a first mask, the code length of the first mask is included in a first value set, and the first value set includes one or more of the following values: 2, 3, 4, 6, and 8.

In a possible implementation, the first information may be higher layer information or downlink control information. For example, the first information is RRC, the first information is a medium access control (medium access control, MAC) control element (control element, CE), or the first information is radio link control (radio link control, RLC) signaling. For another example, the first information may be DCI. A specific form of the first information is not limited in this embodiment of this application.

In some possible implementations, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code. This is not limited herein in this embodiment of this application.

In some implementations, the code length of the first mask is one of 2, 3, 4, 6, and 8.

For example, if the code length of the first mask is any one of 2, 3, 4, 6, and 8, the first field needs at least 3 bits, and different bit states of the first field represent different code lengths, or different decimal values corresponding to the bits of the first field represent different code lengths.

In some implementations, if the first value set may be {2, 4}, the code length of the first mask may be 2 or 4.

For example, it is assumed that the first mask is the FD-OCC, a reference signal is a downlink DMRS (unless otherwise specified in the following, a rule of the downlink DMRS is applicable to an uplink DMRS), and the code length of the FD-OCC is 2 or 4. In this case, a length of the first field in the first information may be 1 bit, and a mapping relationship between a bit state of the first field and the code length of the FD-OCC may be shown in Table 15.

**Table 15**

| Bit state of the first field | Code length of the FD-OCC |
|---|---|
| 0 | 2 |
| 1 | 4 |

It should be understood that Table 15 is merely an example. In another implementation of this application, the mapping relationship between the bit state of the first field and the code length of the FD-OCC may alternatively be different from that in Table 15. For example, a bit state "1" of the first field indicates that the code length of the FD-OCC is 2, and a bit state "0" of the first field indicates that the code length of the FD-OCC is 4.

In a possible implementation, mask length candidate sets corresponding to different types of DMRSs may be different, or first value sets corresponding to the different types of DMRSs are different. For example, a first value set corresponding to a type-1 DMRS is {2, 3}, and a first value set corresponding to a type-2 DMRS is {2, 4}. For another example, a first value set corresponding to a type-1 DMRS is {2, 6}, and a first value set corresponding to a type-2 DMRS is {2, 4}. For still another example, a first value set corresponding to an enhanced DMRS is {2, 4, 6}.

In a possible implementation, if types of DMRSs are different, the bit state of the first field may correspond to different code lengths. For example, the type of the DMRS is type1, and the bit state "1" of the first field indicates that the code length of the FD-OCC is 3. The type of the DMRS is type2, and the bit state "1" of the first field indicates that the code length of the FD-OCC is 4. The types of the DMRSs are type1 and type2, and the bit state "0" of the first field indicates that the code length of the FD-OCC is 2.

It should be further understood that, in another implementation of this application, the mapping relationship between the first field and the code length of the FD-OCC may alternatively be another mapping relationship. For example, the mapping relationship may be a mapping relationship between the decimal value corresponding to the bits of the first field and the code length of the FD-OCC. This is not limited herein in this embodiment of this application.

In some possible implementations, before the network device sends the first information to the terminal device, or after the network device sends the first information to the terminal device, the terminal device may report one or more of the following information to the network device: whether the terminal device supports enhancement of different types of DMRSs in different manners, whether the terminal device supports multi-user scheduling, a maximum quantity of multiplexing users supported by the terminal device, a maximum quantity of multiplexing data streams supported by the terminal device, and whether the terminal device supports multi-user scheduling with another type of terminal device.

Whether the terminal device supports multi-user scheduling may be whether the terminal device supports multi-user scheduling in a same CDM group, or whether the terminal device supports multi-user scheduling in different CDM groups. The maximum quantity of multiplexing users supported by the terminal device refers to a maximum quantity of multiplexing users supported by the terminal device in a same CDM group, or a maximum quantity of multiplexing users supported by the terminal device in different CDM groups. The maximum quantity of multiplexing data streams supported by the terminal device refers to a quantity of DMRS ports multiplexed by a terminal device when the terminal device supports multi-user scheduling. The DMRS multiplexed by the terminal device may be multiplexed in a time division multiplexing manner, a frequency division multiplexing manner, or a code division multiplexing manner. Whether the terminal device supports multi-user scheduling with another type of terminal device means whether multiplexing may be performed between users supporting different quantities of DMRS ports. The multi-user scheduling may be performed in a same CDM group or in different CDM groups, for example, whether a new UE supports multiplexing with an old UE, or whether an enhanced UE supports multiplexing with a UE available before the enhancement, where for example, whether a UE in Release-18 supports multiplexing with a UE in another protocol release.

S620: The terminal device determines a reference signal based on the first mask.

In some implementations, after receiving the first information, the terminal device may determine, based on the first information, the code length of the first mask used for the reference signal, then determine the first mask based on a specific type of the first mask and the code length of the first mask, and determine the reference signal or a receiving manner of the reference signal based on the first mask.

Alternatively, in some other possible implementations, after receiving the first information, the terminal device may determine the first mask based on the first information, and determine the reference signal or the receiving manner of the reference signal based on the determined first mask.

In some possible implementations, that the terminal device determines the first mask based on the first information may be understood as: The terminal device determines a specific type of the first mask and/or the code length of the first mask based on the first information.

In some possible implementations, a type of the first mask may be predefined or preconfigured. For example, the type of the first mask may be a TD-OCC, an FD-OCC, or a superposition of the TD-OCC and the FD-OCC.

For example, if the reference signal is a DMRS, as shown in Table 15, and the bit state of the first field in the first information is "1", it may be determined that an FD-OCC with a length of 4 is used for different DMRSs, to implement multiplexing of a plurality of orthogonal DMRS ports. In this way, a demodulation scheme or a filtering scheme used when the DMRS is received is determined.

S630: The network device sends the reference signal to the terminal device.

For example, if the reference signal is a DMRS, the network device may send the DMRS to the terminal device on a time and/or frequency resource corresponding to the DMRS through a DMRS port.

In a possible implementation, the terminal device may determine, based on the higher layer parameter RRC and/or the DCI, the time and/or frequency resource corresponding to the DMRS.

Optionally, the frequency domain resource corresponding to the DMRS may be determined based on a frequency domain resource corresponding to data associated with the DMRS. For example, a resource block corresponding to the DMRS is the same as a resource block of a PDSCH associated with the DMRS. Specifically, the terminal device may determine, based on the higher layer parameter RRC and/or a frequency domain resource allocation (frequency domain resource assignment, FDRA) field in the DCI, the frequency domain resource corresponding to the DMRS.

Optionally, the time domain resource corresponding to the DMRS may be determined based on a time domain resource corresponding to data associated with the DMRS. For example, a slot corresponding to the DMRS is the same as a slot of the PDSCH associated with the DMRS. Specifically, the terminal device may determine, based on the higher layer parameter RRC and/or a frequency domain resource allocation (time domain resource assignment, TDRA) field in the DCI, the time domain resource corresponding to the DMRS.

In another possible implementation, the first information may further include information about the time and/or frequency resource corresponding to the DMRS. For example, the first information may further include the TDRA field and/or the FDRA field.

It may be understood that the time domain resource corresponding to the DMRS, for example, an OFDM symbol occupied by the DMRS, is further related to whether the DMRS is single-symbol or double-symbol. The frequency resource corresponding to the DMRS, for example, an RE occupied by the DMRS, is further related to a type of the DMRS (a type-1 DMRS or a type-2 DMRS).

S640: The terminal device receives, based on the code length of the first mask used for the reference signal, the reference signal on a port corresponding to a port number of the reference signal.

In some implementations, the first information may further indicate a DMRS port number. For example, the first information includes an antenna port field, and the terminal device determines, based on the antenna port field, the DMRS port number indicated by the field. Further, the port number of the received DMRS is determined based on an offset value indicated by the higher layer signaling or the first information. A code length (for example, 2 or 4) of an FD-OCC used for each DMRS port of the terminal device is determined with reference to the first field.

In some possible implementations, the terminal device may further report, to the network device, an FD-OCC length supported by the terminal device. For example, the terminal device may send information to the network device. The information indicates that the OCC length supported by the terminal device is 2. For example, the terminal device may send information to the network device. The information indicates that the OCC lengths supported by the terminal device are 2 and 4.

For example, for the type-1 DMRS, it is assumed that the terminal device determines, based on the antenna port field, that DMRS ports are 1000 and 1001. Because the DMRS ports 1000 and 1001 may correspond to the FD-OCC with the length of 2, or may correspond to the FD-OCC with the length of 4. The terminal device determines, based on the first field, that the code length of the FD-OCC used for the DMRS port is 2 or 4, that is, determines whether the DMRS port 1000 and the DMRS port 1001 correspond to the FD-OCC with the length of 2 or the FD-OCC with the length of 4. In this way, the terminal device may use a proper hardware implementation method (for example, a DMRS decoding or filtering method), to obtain a better demodulation effect when CDM multiplexing is performed on different DMRS ports.

Based on the signal transmission method provided in this application, the code length of the mask corresponding to the reference signal is indicated to the receive device (for example, the terminal device), to ensure that the receive device is definite about the length of the mask used for the reference signal when supporting masks with different code lengths, so that the receive device may use the proper hardware implementation method (for example, the reference signal decoding or filtering method), to obtain a better demodulation effect when different reference signal ports are multiplexed, and improve reference signal transmission efficiency.

Optionally, in some possible implementations of this application, the first field further indicates a reference signal port number; or the first information further includes a second field, and the second field indicates a reference signal port number.

In this embodiment of this application, indicating a reference signal port number may be understood as indicating a reference signal port, indicating an antenna port number, or indicating an antenna port.

In this embodiment of this application, the reference signal port number may be understood as a label or an identifier of the reference signal port.

In some possible implementations, the first field or the second field indicates an offset value of the reference signal port number, or a value set to which the port number of the reference signal belongs.

Descriptions are provided separately below. A case in which the first field or the second field indicates the offset value of the reference signal port number is described first.

When the first field or the second field indicates the offset value of the reference signal port number, the terminal device may determine a final DMRS port number based on the DMRS port number indicated by the antenna port field in the DCI sent by the network device and the offset value (for example, the offset value is added to the DMRS port number indicated by the antenna port field, and the offset value may be a positive integer or a negative integer; or the offset value is subtracted from the DMRS port number indicated by the antenna port field, and the offset value may be a positive integer).

It should be understood that, in this embodiment of this application, the first information may be DCI sent by the network device, or the DCI sent by the network device and the first information may be different signaling or information. For example, the DCI that includes the antenna field and that is sent by the network device to the terminal device and DCI including the first information may be different DCI.

For example, it is assumed that the reference signal is a downlink DMRS. When the code length of the FD-OCC for the DMRS port is 2, for a single-symbol type-1 DMRS, port numbers are 1000 to 1003, and a corresponding antenna port indication (mapping) relationship (dmrs-Type=1 and maxLength=1) is shown in Table 16.

**Table 16: Antenna port indication table (dmrs-Type=1 and maxLength=1)**

| One codeword (one codeword) | | |
| --- | --- | --- |
| Codeword 0 is enabled (codeword 0 enable), and codeword 1 is disabled (codeword 1 disable) | | |
| Value (value) | Quantity of CDM groups without data (number of CDM group(s) without data) | DMRS port (DMRS port(s)) |
| 0 | 1 | 0 |
| 1 | 1 | 1 |
| 2 | 1 | 0 and 1 |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 to 15 | Reserved (Reserved) | Reserved (Reserved) |

It is assumed that after the code length of the FD-OCC is extended to 4, for the single-symbol type-1 DMRS, DMRS ports numbers are 1000 to 1003 and 1008 to 1011. An antenna port indication table corresponding to the port numbers 1000 to 1003 is the same as Table 16. For the DMRS ports 1008 to 1011, a corresponding antenna port indication relationship (dmrs-Type=1 and maxLength=1) is shown in Table 17.

**Table 17: Antenna port indication table (dmrs-Type=1 and maxLength=1) corresponding to the FD-OCC with the code length of 4**

| One codeword (one codeword) | | |
| --- | --- | --- |
| Codeword 0 is enabled (codeword 0 enable), and codeword 1 is disabled (codeword 1 disable) | | |
| Value (value) | Quantity of CDM groups without data (number of CDM group(s) without data) | DMRS port (DMRS port(s)) |
| 0 | 1 | 8 |
| 1 | 1 | 9 |
| 2 | 1 | 8 and 9 |
| 3 | 2 | 8 |
| 4 | 2 | 9 |
| 5 | 2 | 10 |
| 6 | 2 | 11 |
| 7 | 2 | 8 and 9 |
| 8 | 2 | 10 and 11 |
| 9 | 2 | 8 to 10 |
| 10 | 2 | 8 to 11 |
| 11 | 2 | 8 and 10 |

(continued)

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 12 to 15 | Reserved (Reserved) | Reserved (Reserved) |

It can be learned from Table 16 and Table 17 that, for the single-symbol type-1 DMRS, the DMRS port number shown in Table 17 may be determined based on the DMRS port number in the corresponding row in Table 16, and an offset value of the DMRS port number is 8. For example, when the value of the antenna port field in Table 16 is 2, the corresponding DMRS ports are 1000 and 1001; and when the value of the antenna port field in Table 17 is 2, the corresponding DMRS ports are 1008 and 1009. When the value of the antenna port field in Table 16 is 9, the corresponding DMRS ports are 1000 to 1002; and when the value of the antenna port field in Table 17 is 9, the corresponding DMRS ports are 1008 and 1010.

Therefore, for the single-symbol type-1 DMRS, when the length of the FD-OCC is 4, the antenna port indication table in Table 16 may be used. When the length of the FD-OCC is 2, the antenna port indication table in Table 16 may also be used. In other words, for the single-symbol type-1 DMRS, only the antenna port indication table in Table 16 may be defined in a protocol, to indicate one or both of the following two cases.

Case 1: When the length of the FD-OCC is 4, if the antenna port field in the DCI corresponds to (or indicates) a row (namely, a value) in the antenna port indication table shown in Table 16, the offset value is 0 or 8. The offset value 0 indicates a case in which when the length of the FD-OCC is 4, the value of the DMRS port number ranges from 1000 to 1003. The offset value 8 indicates a case in which when the length of the FD-OCC is 4, the value of the DMRS port number ranges from 1008 to 1011. It may be understood that the offset value 0 corresponds to Table 16, and the offset value 8 corresponds to Table 17.

For example, the antenna port field in the DCI corresponds to (or indicates) the value 2 in the antenna port indication table shown in Table 16, and the offset value of the reference signal port number indicated by the first field or the second field is 0. In this case, the DMRS ports indicated by the antenna port field are 1000 and 1001. For another example, the antenna port field in the DCI corresponds to (or indicates) the value 2 in the antenna port indication table shown in Table 16, and the offset value of the reference signal port number indicated by the first field or the second field is 8. In this case, the indicated DMRS ports are 1008 and 1009. In other words, the terminal device determines the final DMRS port number based on the DMRS port number indicated by the antenna port field in the DCI and the offset value (for example, the offset value 8 is added to the DMRS port number indicated by the antenna port field).

Case 2: When the length of the FD-OCC is 2, if the antenna port field in the DCI corresponds to (or indicates) only a row (namely, a value) in the antenna port indication table shown in Table 16, the offset value is a default value, and the default value is 0.

For example, the antenna port field in the DCI corresponds to (or indicates) the value 2 in the antenna port indication table shown in Table 16, and the corresponding DMRS ports are 1000 and 1001. In this case, the DMRS ports indicated by the antenna port field are 1000 and 1001. In other words, the terminal device obtains the final DMRS port number based on the DMRS port number indicated by the antenna port field in the DCI.

In some other implementations, for the single-symbol type-1 DMRS, when the length of the FD-OCC is 2, the DMRS ports are 1000 to 1003. After the length of the FD-OCC code is extended to 4, the DMRS port numbers include 1000 to 1003 and 1004 to 1007. An antenna port indication table corresponding to the port numbers 1000 to 1003 is the same as Table 16. For the DMRS ports 1004 to 1007, the final DMRS port number may be determined based on the DMRS port indicated in Table 16 and an offset value (for example, the offset value 4 is added to the DMRS port number indicated by the antenna port field). In other words, for the single-symbol type-1 DMRS, only the antenna port indication table in Table 16 may be defined in a protocol, to indicate one or both of the following two cases.

Case 1: When the length of the FD-OCC is 4, if the antenna port field in the DCI corresponds to (or indicates) one or more of the DMRS port numbers 1000 to 1003, the offset value is 0 or 4. The offset value 0 indicates a case in which when the length of the FD-OCC is 4, the value of the DMRS port number ranges from 1000 to 1003. The offset value 4 indicates a case in which when the length of the FD-OCC is 4, the value of the DMRS port number ranges from 1004 to 1007. It may be understood that the offset value 0 corresponds to Table 16.

Case 2: When the length of the FD-OCC is 2, the antenna port field in the DCI can indicate only one or more of the DMRS port numbers 1000 to 1003. In this case, the offset value is a default value, and the default value is 0.

Similarly, when the code length of the FD-OCC used for the DMRS is 2, ports for a double-symbol type-1 DMRS are numbered 1000 to 1007. After the code length of the FD-OCC is extended to 4, it is assumed that DMRS ports for the double-symbol type-1 DMRS are numbered 1000 to 1007 and 1008 to 1015. An antenna port indication table corresponding to the port numbers 1000 to 1007 is the same as an antenna port indication table corresponding to the FD-OCC with the code length of 2 (for example, Table 7). For the DMRS ports 1008 to 1015, the final DMRS port number may be determined based on the DMRS port indicated in Table 7 and an offset value (for example, the offset value 8 is added to the DMRS port number indicated by the antenna port field). In other words, for the double-symbol type-1 DMRS, only the antenna port indication table in Table 7 may be defined in a protocol, to indicate one or both of the following two cases.

Case 1: When the length of the FD-OCC is 4, if the antenna port field in the DCI corresponds to (or indicates) one or more of the DMRS port numbers 1000 to 1007, the offset value is 0 or 8. The offset value 0 indicates a case in which when the length of the FD-OCC is 4, the value of the DMRS port number ranges from 1000 to 1007. The offset value 8 indicates a case in which when the length of the FD-OCC is 4, the value of the DMRS port number ranges from 1008 to 1015. It may be understood that the offset value 0 corresponds to Table 7.

Case 2: When the length of the FD-OCC is 2, the antenna port field in the DCI can indicate only one or more of the DMRS port numbers 1000 to 1007. In this case, the offset value is 0, or there is no offset value.

In conclusion, for the type-1 DMRS, the offset value of the reference signal port number indicated by the first field or the second field may be 8 or 0, and the offset value is an offset value relative to one or more of the DMRS port numbers 1000 to 1007. Alternatively, for the type-1 DMRS, the offset value of the reference signal port number indicated by the first field or the second field may be 4, and the offset value is an offset value relative to one or more of the DMRS port numbers 1000 to 1003.

In other words, for the type-1 DMRS, the offset value of the DMRS port number belongs to a second value set, and the second value set includes one or more of the following values: 0, 4, and 8.

In a possible implementation, for the type-1 DMRS, when the length of the FD-OCC is 3, the offset value may be one of 0, 2, and 4. For example, the offset value is 0 or 4. For the type-2 DMRS, when the length of the FD-OCC is 6, the offset value may be one of 0, 8, and 16. For example, the offset value is 0 or 16. For a new-type DMRS, for example, a comb-4 DMRS, when the length of the FD-OCC is 3, the offset value is one or more of 0, 8, and 16. For example, the offset value is 0 or 16.

In a possible implementation, the second value set may be configured by using a higher layer parameter, indicated by DCI, or predefined. For example, the second value set is {0, 8}. For another example, the second value set is {0, 4}. For still another example, the second value set is {0, 16}.

In another possible implementation, the second value set may be configured by using a higher layer parameter. For example, when the DMRS is the type-1 DMRS, the second value set is {0, 8}. For another example, when the DMRS is the type-1 DMRS, the second value set is {0, 4} or {0, 8}. When the DMRS is the single-symbol type-1 DMRS, the second value set is {0, 4}. When the DMRS is the double-symbol type-1 DMRS, the second value set is {0, 8}.

Optionally, in some possible implementations of this application, the terminal device may determine the length of the mask and the DMRS port based on the first field.

For example, for the type-1 DMRS, a correspondence between different bit states of the first field, the length of the FD-OCC, and the offset value of the port number may be shown in Table 18.

**Table 18**

| Bit state of the first field | Length of the FD-OCC | Offset value |
|---|---|---|
| 00 | 2 | 0 |
| 01 | 4 | 0 |
| 10 | 4 | 8 |
| 11 | Reserved (Reserved) | Reserved (Reserved) |

For example, it is assumed that the antenna port field in the DCI sent by the network device corresponds to (or indicates) the value 2 in the antenna port indication table shown in Table 16, the corresponding DMRS ports are 1000 and 1001, and the bit state of the first field is "01". In this case, the terminal device may determine that the offset value of the reference signal port number is 0. In a possible implementation, the terminal device may determine the DMRS port numbers indicated by the antenna port field in the DCI as final DMRS port numbers: 1000 and 1001. Alternatively, in another possible implementation, the offset value 0 may be added to the DMRS port numbers indicated by the antenna port field in the DCI, to obtain final DMRS port numbers 1000 and 1001. In addition, it may be further determined that the code length of the FD-OCC used for the DMRS ports 1000 and 1001 is 4.

It can be learned from Table 18 that offset values of reference signal port numbers corresponding to at least two bit states in a bit status of the first field are the same. For example, the offset values of the reference signal port numbers corresponding to the bit state "01" and the bit state "00" are the same, and are both 0.

It can be further learned from Table 18 that a first bit state "00" of the first field indicates that the code length of the FD-OCC is a first code length (for example, 2), and the offset value of the DMRS port number is a first offset value (for example, 0).

A second bit state "01" of the first field indicates that the code length of the FD-OCC is a second code length (for example, 4), and the offset value of the DMRS port number is the first offset value (for example, 0).

A third bit state "10" of the first field indicates that the code length of the FD-OCC is the second code length (for example, 4), and the offset value of the DMRS port number is a second offset value (for example, 8).

In a possible implementation, the first code length and the second code length may be configured by using a higher layer parameter, or may be predefined. For example, the first code length is 2, and the second code length is 4. Alternatively, the second code length is 6, the second code length is 3, the second code length is related to the DMRS type, or the second code length is related to a frequency resource mapping manner of the DMRS. This is not limited herein in this embodiment of this application.

It should be understood that Table 18 is merely an example. In another implementation of this application, a mapping relationship between the bit state of the first field, the code length of the FD-OCC, and the offset value may alternatively be different from that in Table 18. For example, the bit state "10" of the first field corresponds to the FD-OCC with the code length of 2 and the offset value 0; and the bit state "00" of the first field corresponds to the FD-OCC with the code length of 4 and the offset value 8.

It should be further understood that, in another implementation of this application, the mapping relationship between the first field, the code length of the FD-OCC, and the offset value may alternatively be another mapping relationship. For example, the mapping relationship may be a mapping relationship between the decimal value corresponding to the bits of the first field, the code length of the FD-OCC, and the offset value. This is not limited herein in this embodiment of this application.

Similarly, when the code length of the FD-OCC used for the DMRS is 2, for the single-symbol type-2 DMRS, the port numbers are 1000 to 1005. After the code length of the FD-OCC is extended to 4, it is assumed that, for the single-symbol type-2 DMRS, the DMRS ports numbers are 1000 to 1005 and 1012 to 1017. An antenna port indication table corresponding to the port numbers 1000 to 1005 is the same as an antenna port indication table corresponding to the FD-OCC with the code length of 2 (as shown in Table 8). For the DMRS ports 1012 to 1017, the final DMRS port number may be determined based on the DMRS port indicated in Table 8 and the offset value (for example, the offset value 12 is added to the DMRS port numbers indicated by the antenna port field). In other words, for the single-symbol type-2 DMRS, only the antenna port indication table in Table 8 may be defined in the protocol, to indicate one or both of the following two cases.

Case 1: When the length of the FD-OCC is 4, if the antenna port field in the DCI corresponds to (or indicates) one or more of the DMRS port numbers 1000 to 1005, the offset value is 0 or 12. The offset value 0 indicates a case in which when the length of the FD-OCC is 4, the value of the DMRS port number ranges from 1000 to 1005. The offset value 12 indicates a case in which when the length of the FD-OCC is 4, the value of the DMRS port number ranges from 1012 to 1017. It may be understood that the offset value 0 corresponds to Table 8.

Case 2: When the length of the FD-OCC is 2, the antenna port field in the DCI can indicate only one or more of the DMRS port numbers 1000 to 1005. In this case, the offset value is 0, or there is no offset value.

In some other implementations, for the single-symbol type-2 DMRS, when the length of the FD-OCC is 2, the DMRS ports are 1000 to 1005. After the length of the FD-OCC code is extended to 4, the DMRS ports include 1000 to 1005 and 1006 to 1011. An antenna port indication table corresponding to the port numbers 1000 to 1005 is the same as Table 8. For the DMRS ports 1006 to 1011, the final DMRS port number may be determined based on the DMRS port indicated in Table 8 and the offset value (for example, the offset value 6 is added to the DMRS port number indicated by the antenna port field). In other words, for the single-symbol type-2 DMRS, only the antenna port indication table in Table 8 may be defined in the protocol, to indicate one or both of the following two cases.

Case 1: When the length of the FD-OCC is 4, if the antenna port field in the DCI corresponds to (or indicates) one or more of the DMRS port numbers 1000 to 1005, the offset value is 0 or 6. The offset value 0 indicates a case in which when the length of the FD-OCC is 4, the value of the DMRS port number ranges from 1000 to 1005. The offset value 6 indicates a case in which when the length of the FD-OCC is 4, the value of the DMRS port number ranges from 1006 to 1011. It may be understood that the offset value 0 corresponds to Table 8.

Case 2: When the length of the FD-OCC is 2, the antenna port field in the DCI can indicate only one or more of the DMRS port numbers 1000 to 1005. In this case, the offset value is 0, or there is no offset value.

Similarly, when the code length of the FD-OCC used for the DMRS is 2, for the double-symbol type-2 DMRS, the port numbers are 1000 to 1011. After the code length of the FD-OCC is extended to 4, for the double-symbol type-2 DMRS, the DMRS port numbers are 1000 to 1011 and 1012 to 1023. An antenna port indication table corresponding to the port numbers 1000 to 1011 is the same as an antenna port indication table corresponding to the FD-OCC with the code length of 2 (Table 9). For the DMRS ports 1012 to 1023, the final DMRS port number may be determined based on the DMRS port indicated in Table 9 and the offset value (for example, the offset value 12 is added to the DMRS port number indicated by the antenna port field). In other words, for the double-symbol type-2 DMRS, only the antenna port indication table in Table 9 may be defined in the protocol, to indicate one or both of the following two cases.

Case 1: When the length of the FD-OCC is 4, if the antenna port field in the DCI corresponds to (or indicates) one or more of the DMRS port numbers 1000 to 1011, the offset value is 0 or 12. The offset value 0 indicates a case in which when the length of the FD-OCC is 4, the value of the DMRS port number ranges from 1000 to 1011. The offset value 12 indicates a case in which when the length of the FD-OCC is 4, the value of the DMRS port number ranges from 1012 to 1023. It may be understood that the offset value 0 corresponds to Table 9.

Case 2: When the length of the FD-OCC is 2, the antenna port field in the DCI can indicate only one or more of the DMRS port numbers 1000 to 1011. In this case, the offset value is 0, or there is no offset value.

In conclusion, for the type-2 DMRS, the offset value of the reference signal port number indicated by the first field or the second field may be 12 or 0, and the offset value is an offset value relative to one or more of the DMRS port numbers 1000 to 1011. Alternatively, for the type-2 DMRS, the offset value of the reference signal port number indicated by the first field or the second field may be 6, and the offset value is an offset value relative to one or more of the DMRS port numbers 1000 to 1005.

In other words, for the type-2 DMRS, the offset value of the DMRS port number belongs to a second value set, and the second value set includes one or more of the following values: 0, 6, and 12.

In a possible implementation, the second value set may be predefined. For example, the second value set is {0, 12}. For another example, the second value set is {0, 6}.

In another possible implementation, the second value set may be configured by using a higher layer parameter, or indicated by DCI. For example, when the DMRS is the type-2 DMRS, the second value set is {0, 12}. For another example, when the DMRS is the type-2 DMRS, the second value set is {0, 6} or {0, 12}. When the DMRS is the single-symbol type-2 DMRS, the second value set is {0, 6}. When the DMRS is the double-symbol type-2 DMRS, the second value set is {0, 12}.

For example, for the type-2 DMRS, a correspondence between different bit states of the first field, the length of the FD-OCC, and the offset value of the port number may be shown in Table 19.

**Table 19**

| Bit state of the first field | Length of the FD-OCC | Offset value |
| --- | --- | --- |
| 00 | 2 | 0 |
| 01 | 4 | 0 |
| 10 | 4 | 12 |
| 11 | Reserved (Reserved) | Reserved (Reserved) |

For example, it is assumed that DMRS ports corresponding to (or indicated by) the antenna port field in the DCI sent by the network device are 1002 and 1003. If the bit state of the first field is "01", the terminal device may determine that the offset value of the reference signal port number is 0. The terminal device may obtain final DMRS port numbers 1002 and 1003 based on the DMRS port numbers indicated by the antenna port field in the DCI and the offset value (for example, the offset value 0 is added to the DMRS port numbers indicated by the antenna port field), and may further determine that the code length of the FD-OCC used for the DMRS port numbers 1002 and 1003 is 4.

It can be learned from Table 19 that offset values of reference signal port numbers corresponding to at least two bit states in the bit status of the first field are the same. For example, the offset values of the reference signal port numbers corresponding to the bit state "01" and the bit state "00" are the same, and are both 12.

It can be further learned from Table 19 that a first bit state "00" of the first field indicates that the code length of the FD-OCC is a first code length (for example, 2), and the offset value of the DMRS port number is a first offset value (for example, 0).

A second bit state "01" of the first field indicates that the code length of the FD-OCC is a second code length (for example, 4), and the offset value of the DMRS port number is the first offset value (for example, 0).

A third bit state "10" of the first field indicates that the code length of the FD-OCC is the second code length (for example, 4), and the offset value of the DMRS port number is a second offset value (for example, 12).

In a possible implementation, the first code length and the second code length may be configured by using a higher layer parameter, or may be predefined. For example, the first code length is 2, and the second code length is 4. Alternatively, the second code length is 6, the second code length is 3, the second code length is related to the DMRS type, or the second code length is related to a frequency resource mapping manner of the DMRS.

The offset value of the reference signal port number is indicated to the terminal device, so that a quantity of pieces of antenna port correspondence (mapping) information that needs to be stored by the terminal device can be reduced, to reduce a storage amount and processing complexity that are of the terminal device. In addition, a length (quantity of bits) of dynamic signaling (for example, the first information) may be further reduced, to reduce signaling overheads.

The following describes a case in which the first field or the second field indicates the value set to which the port number of the reference signal belongs.

It can be learned from the foregoing analysis that:

In a possible implementation, for the type-1 DMRS, a value range of the DMRS port number may be two value sets. 1000 to 1007 may be one value set (a third value set), and a code length of a corresponding FD-OCC is 4 or 2. 1008 to 1015 may be one value set (a fourth value set), and a code length of a corresponding FD-OCC is 4.

Alternatively, in another possible implementation, for the type-1 DMRS, a value range of the DMRS port number may be two value sets. 1000 to 1007 may be one value set (a third value set), and a length of a corresponding code FD-OCC is 2. 1001 to 1015 may be the other value set (a fourth value set), and a code length of a corresponding FD-OCC is 4.

For example, for the type-1 DMRS, a correspondence between different bit states of the first field, the length of the FD-OCC, and the value set to which the port number of the DMRS belongs may be shown in Table 20.

**Table 20**

| Bit state of the first field | Length of the FD-OCC | Value set to which the port number of the DMRS belongs |
|---|---|---|
| 00 | 2 | 1000 to 1007 |
| 01 | 4 | 1000 to 1007 |
| 10 | 4 | 1008 to 1015 |
| 11 | Reserved (Reserved) | Reserved (Reserved) |

It can be learned from Table 20 that value sets to which port numbers of reference signals corresponding to at least two bit states in the bit status of the first field belong are the same, and are each 1000 to 1007.

It can be further learned from Table 20 that:

A first bit state "00" of the first field indicates that the code length of the FD-OCC is a first code length (for example, 2), and the port number of the DMRS belongs to the third value set (the third value set is 1000 to 1007).

A second bit state "01" of the first field indicates that the code length of the FD-OCC is a second code length (for example, 4), and the port number of the DMRS belongs to the third value set (the third value set is 1000 to 1007).

A third bit state "10" of the first field indicates that the code length of the FD-OCC is the second code length (for example, 4), and the port number of the DMRS belongs to the fourth value set (the fourth value set is 1008 to 1015).

In a possible implementation, the first code length and the second code length are configured by using a higher layer parameter, or is predefined. For example, the first code length is 2. For example, the second code length is 4, the second code length is 6, the second code length is 3, the second code length is related to the DMRS type, or the second code length is related to a frequency resource mapping manner of the DMRS.

Optionally, the value range of the DMRS port number being 1000 to 1007 may be separately defined as an antenna port indication table. The value range of the DMRS port number being 1008 to 1015 may be separately defined as an antenna port indication table. In other words, for the type-1 DMRS, there may be two antenna port indication tables in the protocol. The value range of the DMRS port number indicated by one of the tables is 1000 to 1007, and the value range of the DMRS port number indicated by the other table is 1008 to 1015. For example, for the type-1 DMRS, a correspondence between different bit states of the first field, the length of the FD-OCC, and the value set to which the port number of the DMRS belongs may be shown in Table 21.

**Table 21**

| Bit state of the first field | Length of the FD-OCC | Value set to which the port number of the DMRS belongs |
|---|---|---|
| 0 | 2 | 1000 to 1007 |
| 1 | 4 | 1000 to 1015 |

In the example shown in Table 21, the third value set is 1000 to 1007, and the fourth value set is 1000 to 1015.

In a possible implementation, for the type-2 DMRS, the value range of the DMRS port number may be two value sets. The third value set may be 1000 to 1011, and a code length of a corresponding FD-OCC is 4 or 2. The fourth value set may be 1012 to 1023, and a code length of a corresponding FD-OCC is 4.

In another possible implementation, for the type-2 DMRS, the value range of the DMRS port number may include two value sets. The third value set may be 1000 to 1011, and a code length of a corresponding FD-OCC is 2. The fourth value set may be 1000 to 1023, and a code length of a corresponding FD-OCC is 4.

For example, for the type-2 DMRS, a correspondence between different bit states of the first field, the length of the FD-OCC, and the value set to which the port number of the DMRS belongs may be shown in Table 22.

**Table 22**

| Bit state of the first field | Length of the FD-OCC | Value set to which the port number of the DMRS belongs |
|---|---|---|
| 00 | 2 | 1000 to 1011 |
| 01 | 4 | 1000 to 1011 |
| 10 | 4 | 1012 to 1023 |
| 11 | Reserved (Reserved) | Reserved (Reserved) |

It can be learned from Table 22 that value sets to which port numbers of reference signals corresponding to at least two bit states in the bit status of the first field belong are the same, and are each 1000 to 1011.

It can be further learned from Table 22 that:
A first bit state "00" of the first field indicates that the code length of the FD-OCC is a first code length (for example, 2), and the port number of the DMRS belongs to the third value set (1000 to 1011).

A second bit state "01" of the first field indicates that the code length of the FD-OCC is a second code length (for example, 4), and the port number of the DMRS belongs to the third value set (1000 to 1011).

A third bit state "10" of the first field indicates that the code length of the FD-OCC is the second code length (for example, 4), and the port number of the DMRS belongs to the fourth value set (1012 to 1023).

In a possible implementation, the first code length and the second code length are configured by higher layer parameter, or is predefined. For example, the first code length is 2. For example, the second code length is 4, the second code length is 6, the second code length is 3, the second code length is related to the DMRS type, or the second code length is related to a frequency resource mapping manner of the DMRS.

Optionally, the value range of the DMRS port number being 1000 to 1011 may be separately defined as an antenna port indication table. The value range of the DMRS port number being 1012 to 1023 may be separately defined as an antenna port indication table. In other words, for the type-2 DMRS, there may also be two antenna port indication tables in the protocol. The value range of the DMRS port number indicated by one of the tables is 1000 to 1011, and the value range of the DMRS port number indicated by the other table is 1012 to 1023.

For another example, for the type-2 DMRS, a correspondence between different bit states of the first field, the length of the FD-OCC, and the value set to which the port number of the DMRS belongs may be shown in Table 23.

**Table 23**

| Bit state of the first field | Length of the FD-OCC | Value set to which the port number of the DMRS belongs |
|---|---|---|
| 0 | 2 | 1000 to 1011 |
| 1 | 4 | 1000 to 1023 |

In the example shown in Table 23, the third value set is 1000 to 1011, and the fourth value set is 1000 to 1023.

After receiving the DCI sent by the network device, the terminal device may determine, based on the value (value) of the antenna port field in the DCI, a specific row indicated in the table, to determine the port number of the DMRS. Because the antenna port field may correspond to two tables, the port number of the DMRS that is determined based on the antenna port field may belong to different value sets. Further, a specific value set to which the port number of the DMRS belongs may be determined based on the first field, to determine a final port number of the DMRS. In addition, the code length of the FD-OCC used for the DMRS may be further determined based on the first field.

For example, for the type-1 DMRS, the terminal device may store different antenna port correspondences (mapping relationships) or different antenna port indication relationships. A value range of a DMRS port number corresponding to a 1st antenna port mapping relationship is 1000 to 1007, and a value range of a DMRS port number corresponding to a 2nd antenna port mapping relationship is 1008 to 1015. For example, the antenna port mapping relationship or correspondence may exist in a form of an antenna port indication table. After the terminal device receives the DCI sent by the network device, it is assumed that the value (value) of the antenna port field in the DCI is 4. Because the terminal device stores two antenna port indication tables (namely, two antenna port mapping relationships), a DMRS port corresponding to the value (value) 4 of the antenna port field in one of the tables is 1001, and a DMRS port corresponding to the value (value) 4 of the antenna port field in the other table is 1009. In this case, the terminal device may determine, based on a value set to which the port number indicated by the first field belongs, that the DMRS port corresponding to the value (value) 4 of the antenna port field is 1001 if the value set to which the port number indicated by the first field belongs is 1000 to 1007. If the value set to which the port number indicated by the first field belongs is 1008 to 1015, it may be determined that a DMRS port corresponding to the value (value) 4 of the antenna port field is 1009, to determine a final DMRS port number.

The value set to which the reference signal port number belongs is indicated to the terminal device, so that a length (quantity of bits) of dynamic signaling (for example, the first information) can be reduced, to reduce signaling overheads.

In embodiments of this application, the length of the FD-OCC and the port number of the DMRS are dynamically and jointly indicated, so that the terminal device can be definite about the length of the used FD-OCC and numbers of orthogonal DMRS ports. The network device does not need to use additional signaling to indicate the offset value of the port number of the DMRS, so that the terminal device can be definite about the length of the FD-OCC used for the DMRS, to use a proper hardware implementation method (for example, a reference signal decoding or filtering method), so as to obtain a better demodulation effect when different reference signal ports are multiplexed, and improve reference signal transmission efficiency. In addition, dynamic signaling is saved, and utilization of communication resources is improved.

In some implementations, for example, as shown in Table 20, the third value set may be 1000 to 1007, and the fourth value set may be 1008 to 1015. It can be learned that:

A quantity of number values included in the third value set is the same as a quantity of number values included in the second value set, where the quantity is 8.

Configuration types of reference signals corresponding to the third value set and the fourth value set are the same (in other words, types of the reference signals are the same), for example, are both type-1 DMRSs. In embodiments of this application, the configuration type of the reference signal may be understood as a type of the reference signal or a reference signal type, for example, type1 or type2. For example, the configuration type includes a first configuration type and a second configuration type. The first configuration type is type1 or an enhanced configuration type. When the configuration type of the reference signal is the second configuration type (type-2 DMRS), a fifth value set includes 12. The second configuration type is type2 or an enhanced configuration type.

The number value in the fourth value set is determined based on the number value in the third value set and a first value (namely, an offset value). The first value belongs to the fifth value set. For example, the first value may be 8.

In other words, the number values in the fourth value set are in one-to-one correspondence with the number values in the third value set. For example, if the number values in the third value set include 1000, 1001, 1002, 1003, 1004, 1005, 1006 and 1007, the fourth value set includes 1008, 1009, 1010, 1011, 1012, 1013, 1014 and 1015. In the fourth value set, 1008 corresponds to 1000, 1009 corresponds to 1001, 1010 corresponds to 1002, 1011 corresponds to 1003, 1012 corresponds to 1004, 1013 corresponds to 1005, 1014 corresponds to 1006, and 1015 corresponds to 1007. In other words, each value in the fourth value set may be determined based on a same offset value (the first value) and a value in the third value set. For example, a value in the fourth value set may be obtained by adding the offset value to a value in the third value set.

In some other implementations, for the single-symbol type-1 DMRS, when the length of the FD-OCC is 2, the DMRS ports are 1000 to 1003. After the length of the FD-OCC code is extended to 4, based on the original DMRS ports (that is, the DMRS ports corresponding to the FD-OCC with the code length of 2) 1000 to 1003, the new DMRS ports (that is, the DMRS ports corresponding to the FD-OCC with the code length of 4 except the DMRS ports 1000 to 1003) may be 1004 to 1007. In this case, the third value set may be 1000 to 1003, and the fourth value set may be 1004 to 1007. It can be learned that:

A quantity of number values included in the third value set is the same as a quantity of number values included in the second value set, where the quantity is 4.

Configuration types of reference signals corresponding to the third value set and the fourth value set are the same (in other words, types of the reference signals are the same), for example, are both single-symbol type-1 DMRSs.

The number value in the fourth value set is determined based on the number value in the third value set and a first value (namely, an offset value). The first value belongs to the fifth value set. For example, the offset value may be 4. In other words, each value in the fourth value set may be determined based on a same offset value (the first value) and a value in the third value set. For example, a value in the fourth value set may be obtained by adding the offset value to a value in the third value set.

In some implementations, for example, as shown in Table 22, the third value set includes 1000 to 1011, and the fourth value set includes 1012 to 1023. It can be learned that:

A quantity of number values included in the third value set is the same as a quantity of number values included in the second value set, where the quantity is 12.

Configuration types of reference signals corresponding to the third value set and the fourth value set are the same (in other words, types of the reference signals are the same), for example, are both type-2 DMRSs.

The number value in the fourth value set is determined based on the number value in the third value set and a first value (namely, an offset value). The first value belongs to the fifth value set. For example, the offset value may be 12.

In other words, the number values in the fourth value set are in one-to-one correspondence with the number values in the third value set. For example, the number values in the third value set include 1000, 1001, 1002, 1003, 1004, 1005, 1006, 1007, 1008, 1009, 1010 and 1011. The number values in the fourth value set include 1012, 1013, 1014, 1015, 1016, 1017, 1018, 1019, 1020, 1021, 1022 and 1023. In the fourth value set, 1012 corresponds to 1000, 1013 corresponds to 1001, 1014 corresponds to 1002, 1015 corresponds to 1003, 1016 corresponds to 1004, 1017 corresponds to 1005, 1018 corresponds to 1006, 1019 corresponds to 1007, 1020 corresponds to 1008, 1021 corresponds to 1009, 1022 corresponds to 1010, and 1023 corresponds to 1011. In other words, each value in the fourth value set may be determined based on a same offset value (the first value) and a value in the third value set. For example, a value in the fourth value set may be obtained by adding the offset value to a value in the third value set.

In some other implementations, for the single-symbol type-2 DMRS, when the length of the FD-OCC is 2, the DMRS ports are 1000 to 1005. After the length of the FD-OCC code is extended to 4, based on the original DMRS ports (that is, the DMRS ports corresponding to the FD-OCC with the code length of 2) 1000 to 1005, the new DMRS ports (that is, the DMRS ports corresponding to the FD-OCC with the code length of 4 except the DMRS ports 1000 to 1005) may be 1006 to 1011. In this case, the third value set may be 1000 to 1005, and the fourth value set may be 1006 to 1011. It can be learned that:

A quantity of number values included in the third value set is the same as a quantity of number values included in the second value set, where the quantity is 6.

Configuration types of reference signals corresponding to the third value set and the fourth value set are the same (in other words, types of the reference signals are the same), for example, are both single-symbol type-2 DMRSs.

The number value in the fourth value set is determined based on the number value in the third value set and a first value (namely, an offset value). The offset value belongs to the fifth value set. For example, the offset value may be 6. In other words, each value in the fourth value set may be determined based on a same offset value (the first value) and a value in the third value set. For example, a value in the fourth value set may be obtained by adding the offset value to a value in the third value set.

Optionally, in this embodiment of this application, the fifth value set includes one or more of the following values: 4, 8, 6, and 12.

In a possible implementation, the fifth value set may be predefined. For example, when the configuration type of the reference signal is the type-1 DMRS, the fifth value set is {4, 8}. For another example, when the configuration type of the reference signal is the type-2 DMRS, the fifth value set is {6, 12}.

In another possible implementation, the fifth value set may be configured by using a higher layer parameter. For example, when the configuration type of the reference signal is the type-1 DMRS, the fifth value set is {4, 8}. When the reference signal is configured as the single-symbol type-1 DMRS, the fifth value set is {4, 8}. When the reference signal is configured as the double-symbol type-1 DMRS, the fifth value set is {8}.

For another example, when the configuration type of the reference signal is the type-2 DMRS, the fifth value set is {6, 12}. When the reference signal is configured as the single-symbol type-2 DMRS, the fifth value set is {6, 12}. When the reference signal is configured as the double-symbol type-2 DMRS, the fifth value set is {12}.

Optionally, in some implementations of this application, for example, if the first information may be DCI, the first information may further include an antenna port field (Antenna port(s)). The antenna port field indicates a DMRS port number and a first physical resource to the terminal device. In this embodiment of this application, the first physical resource may be one or more groups of time-domain and/or frequency-domain resources. In addition, the terminal device does not perform data transmission on the first physical resource. For example, the first physical resource may be a quantity of CDM groups. For another example, the first physical resource is one or more CDM groups.

For example, as shown in Table 6, assuming that the value (value) of the antenna port field is 5, the first physical resource includes two groups of time-frequency resources, the first physical resource includes two CDM groups, or the first physical resource is two CDM groups. One CDM group indicates (corresponds to) one physical resource (time-frequency resource), and different CDM groups correspond to different physical resources.

In a possible implementation, when the antenna port field indicates the first physical resource, the bit status of the first field further includes a fourth bit state. For example, the fourth bit state of the first field may be the reserved bit state "11" in Table 18, the reserved bit state "11" in Table 19, the reserved bit state "11" in Table 20, or the reserved bit state "11" in Table 22. The fourth bit state of the first field may indicate that no terminal device other than the terminal device performs data or signal transmission on the first physical resource, or no paired user exists on the first physical resource. Based on the indication, the terminal device can determine whether another terminal device sends a reference signal on a physical resource other than a physical resource (first physical resource) occupied by the DMRS port, to determine a quantity of orthogonal DMRS ports that currently need to be distinguished, so as to use a more proper filter to obtain a better channel estimation effect.

When the fourth bit state of the first field indicates that no terminal device other than the terminal device performs data or signal transmission on the first physical resource, at least one of the first bit state, the second bit state, and the third bit state of the first field further indicates that another terminal device other than the terminal device performs data or signal transmission on the first physical resource, or a paired user exists on the first physical resource. Based on the indication, the terminal device can determine whether another terminal device sends a reference signal on a physical resource other than a physical resource (first physical resource) occupied by the DMRS port, to determine a quantity of orthogonal DMRS ports that currently need to be distinguished, so as to use a more proper filter to obtain a better channel estimation effect.

When the fourth bit state of the first field indicates that no terminal device other than the terminal device performs data or signal transmission on the first physical resource:

In a possible implementation, the code length of the first mask (for example, the FD-OCC) may be predefined or preconfigured, and/or the offset value of the reference signal port number or the value set to which the port number of the reference signal belongs may also be predefined or preconfigured. In other words, the fourth bit state of the first field may not need to indicate the code length of the first mask (for example, the FD-OCC) and/or the reference signal port number. For example, the code length of the first mask is 2, or the code length of the first mask is 4. The offset value of the DMRS port number is the first offset value (for example, 0), or the port number of the DMRS belongs to the third value set (1000 to 1007).

When the fourth bit state of the first field indicates that no terminal device other than the terminal device performs data or signal transmission on the first physical resource, in another possible implementation, the fourth bit state of the first field may further indicate the code length of the first mask (for example, the FD-OCC), and/or the offset value of the reference signal port number or the value set to which the port number of the reference signal belongs. In other words, the fourth bit state of the first field may further indicate the code length of the first mask (for example, the FD-OCC) and/or the reference signal port number.

For example, the first bit state of the first field may be the bit state "00" in Table 18, the bit state "00" in Table 19, the bit state "00" in Table 20, or the bit state "00" in Table 22. The second bit state of the first field may be the bit state "01" in Table 18, the bit state "01" in Table 19, the bit state "01" in Table 20, or the bit state "01" in Table 22. The third bit state of the first field may be the bit state "10" in Table 18, the bit state "10" in Table 19, the bit state "10" in Table 20, or the bit state "10" in Table 22.

Optionally, in some embodiments of this application, when the antenna port field indicates the first physical resource, the fourth bit state of the first field may indicate that a paired user exists on the first physical resource.

In this application, "a paired user exists on the first physical resource" may be understood as follows: Another terminal device other than the terminal device performs data or signal transmission on the first physical resource; or on the first physical resource, all orthogonal antenna ports are associated with a PDSCH transmitted to another terminal device; or another terminal device is scheduled on the first physical resource.

In this application, "no paired user exists on the first physical resource" may be understood as follows: No terminal device other than the terminal device performs data or signal transmission on the first physical resource; or on the first physical resource, no orthogonal antenna port is not associated with a PDSCH transmitted to another terminal device; or another terminal device is not scheduled on the first physical resource.

Based on the indication, the terminal device can also determine whether another terminal device sends a reference signal on a physical resource other than a physical resource (first physical resource) occupied by the DMRS port, to determine a quantity of orthogonal DMRS ports that currently need to be distinguished, so as to use a more proper filter to obtain a better channel estimation effect.

When the fourth bit state of the first field indicates that another terminal device other than the terminal device performs data or signal transmission on the first physical resource, at least one of the first bit state, the second bit state, and the third bit state of the first field further indicates that no terminal device other than the terminal device performs data or signal transmission on the first physical resource, or no paired user exists on the first physical resource. Based on the indication, the terminal device can also determine whether another terminal device sends a reference signal on a physical resource other than a physical resource (first physical resource) occupied by the DMRS port, to determine a quantity of orthogonal DMRS ports that currently need to be distinguished, so as to use a more proper filter to obtain a better channel estimation effect.

Optionally, in this embodiment of this application, when the fourth bit state of the first field indicates that another terminal device other than the terminal device performs data or signal transmission on the first physical resource, the code length of the first mask (for example, the FD-OCC) and/or the reference signal port number may be predefined or preconfigured. In other words, the fourth bit state of the first field may not need to indicate the code length of the first mask (for example, the FD-OCC) and/or the reference signal port number. Alternatively, the code length of the first mask (for example, the FD-OCC) and/or the reference signal port number may be indicated by the fourth bit state of the first field. For example, the code length of the first mask is 2, or the code length of the first mask is 4.

Optionally, in some possible implementations of this application, the bit status of the first field may further include a fifth bit state, and the fifth bit state indicates that a quantity of data streams corresponding to the reference signal (for example, the DMRS) is 3 or 4, and the code length of the first mask is the first code length or the second code length.

For example, if the length of the first field is 2 bits, the fifth bit state of the first field may be: the reserved bit state "11" in Table 18, the reserved bit state "11" in Table 19, the reserved bit state "11" in Table 20, or the reserved bit state "11" in Table 22. In this case, the fifth bit state of the first field and the fourth bit state of the first field cannot coexist, and only one of the fifth bit state of the first field and the fourth bit state of the first field can exist.

For another example, if the length of the first field is greater than 2 bits, the fifth bit state of the first field may be different from the foregoing fifth bit state or fourth bit state. In this case, the fifth bit state of the first field and the fourth bit state of the first field may coexist.

In this embodiment of this application, the fifth bit state of the first field may indicate that the quantity of data streams corresponding to the reference signal (for example, the DMRS) is 3 or 4. The quantity of data streams corresponding to the reference signal is a quantity of ports of the reference signal, a quantity of streams of a data channel of the reference signal, or a quantity of layers of the data channel of the reference signal.

When the fifth bit state of the first field indicates that the quantity of data streams corresponding to the reference signal (for example, the DMRS) is 3 or 4, and the code length of the first mask is the first code length or the second code length, in a possible implementation, the offset value of the reference signal port number or the value set to which the port number of the reference signal belongs may be predefined or preconfigured. In other words, the fifth bit state of the first field may not need to indicate the reference signal port number. For example, the offset value of the DMRS port number is the first offset value (for example, 0), or the DMRS port number belongs to the first value set (1000 to 1007). In another possible implementation, the fifth bit state of the first field may further indicate the offset value of the reference signal port number or the value set to which the port number of the reference signal belongs. In other words, the fifth bit state of the first field may alternatively indicate the reference signal port number.

When the fifth bit state of the first field indicates that the quantity of data streams corresponding to the reference signal (for example, the DMRS) is 3 or 4, and the code length of the first mask is the first code length or the second code length, if the length of the first field is 2 bits, at least one of the first bit state, the second bit state, and the third bit state of the first field further indicates that the quantity of data streams corresponding to the reference signal is 1 or 2, and the code length of the first mask is the first code length or the second code length. If the length of the first field is greater than 2 bits, at least one bit state of the first field other than the fifth bit state further indicates that the quantity of data streams corresponding to the reference signal is 1 or 2.

Optionally, in this embodiment of this application, the first information (for example, the DCI) may further include an antenna port field (Antenna port(s)), indicating the DMRS port number, the first physical resource, and the like to the terminal device. When the fifth bit state of the first field indicates that the quantity of data streams corresponding to the reference signal (for example, the DMRS) is 3 or 4, the antenna port field needs to indicate numbers of only three or four DMRS ports and a quantity of corresponding CDM groups. In this way, a length of the antenna port field can be reduced, and communication resources can be saved.

The following provides descriptions with reference to specific examples.

For example, with reference to the example shown in Table 6, when the quantity of data streams is 3 or 4 (or the quantity of DMRS ports is 3 or 4), for the single-symbol type-1 DMRS, there are only two possibilities for indicating the antenna ports: The DMRS ports are 0 to 3 and 0 to 2. Therefore, the antenna port field needs only 1 bit to indicate the two cases in which the DMRS ports are 0 to 3 and 0 to 2. Based on Table 6, the antenna port field needs to indicate at least 11 different cases. In this case, the antenna port field needs at least 4 bits to indicate the 11 different cases. Therefore, overheads of the antenna port field can be significantly reduced.

For another example, with reference to the example shown in Table 7, when the quantity of data streams is 3 or 4 (or the quantity of DMRS ports is 3 or 4), for the double-symbol type-1 DMRS, there are seven possibilities for indicating the antenna ports. Therefore, the antenna port field needs only 3 bits to indicate the seven different cases. Based on Table 7, the antenna port field needs to indicate at least 30 different cases. In this case, the antenna port field needs at least 5 bits to indicate the 30 different cases. Therefore, overheads of the antenna port field can be significantly reduced.

For another example, with reference to the example shown in Table 8, when the quantity of data streams is 3 or 4 (or the quantity of DMRS ports is 3 or 4), for the single-symbol type-2 DMRS, there are five possibilities for indicating the antenna ports. Therefore, the antenna port field needs only 3 bits to indicate the five different cases. Based on Table 8, the antenna port field needs to indicate at least 23 different cases. In this case, the antenna port field needs at least 5 bits to indicate the 23 different cases. Therefore, overheads of the antenna port field can be significantly reduced.

For another example, with reference to the example shown in Table 9, when the quantity of data streams is 3 or 4 (or the quantity of DMRS ports is 3 or 4), for the double-symbol type-2 DMRS, there are 11 possibilities for indicating the antenna ports. Therefore, the antenna port field needs only 4 bits to indicate the 11 different cases. Based on Table 9, the antenna port field needs to indicate at least 57 different cases. In this case, the antenna port field needs at least 6 bits to indicate the 57 different cases. Therefore, overheads of the antenna port field can be significantly reduced.

When at least one of the first bit state, the second bit state, or the third bit state of the first field (or at least one bit state of the first field other than the fifth bit state) indicates that the quantity of data streams corresponding to the reference signal (for example, the DMRS) is 1 or 2, the antenna port field may alternatively need to indicate numbers of only one or two DMRS ports and a quantity of corresponding CDM groups. The following provides descriptions with reference to specific examples.

With reference to the example shown in Table 6, when the quantity of data streams is 1 or 2 (or the quantity of DMRS ports is 1 or 2), for the single-symbol type-1 DMRS, there are 10 possibilities for indicating the antenna ports. Therefore, the antenna port field needs 4 bits to indicate the 10 different cases.

With reference to the example shown in Table 7, when the quantity of data streams is 1 or 2 (or the quantity of DMRS ports is 1 or 2), for the double-symbol type-1 DMRS, there are 24 possibilities for indicating the antenna ports. Therefore, the antenna port field needs 5 bits to indicate the 24 different cases.

With reference to the example shown in Table 8, when the quantity of data streams is 1 or 2 (or the quantity of DMRS ports is 1 or 2), for the single-symbol type-2 DMRS, there are 19 possibilities for indicating the antenna ports. Therefore, the antenna port field needs 5 bits to indicate the 19 different cases.

With reference to the example shown in Table 9, when the quantity of data streams is 1 or 2 (or the quantity of DMRS ports is 1 or 2), for the double-symbol type-2 DMRS, there are 47 possibilities for indicating the antenna ports. Therefore, the antenna port field needs 6 bits to indicate the 47 different cases.

When the fifth bit state of the first field indicates that the quantity of data streams corresponding to the reference signal (for example, the DMRS) is 3 or 4, with reference to the foregoing examples, it can be learned that for the single-symbol type-1 DMRS, the antenna port field needs only 1 bit, and the length m of the antenna port field is equal to 1. When at least one of the first bit state, the second bit state, or the third bit state of the first field (or at least one bit state of the first field other than the fifth bit state) indicates that the quantity of data streams corresponding to the reference signal (for example, the DMRS) is 1 or 2, the antenna port field needs 4 bits, and the length n of the antenna port field is equal to 4. It can be learned that, when the first field indicates that the quantity of data streams corresponding to the reference signal (for example, the DMRS) is 3 or 4, the length of the antenna port field is m, which is less than the length n needed by the antenna port field when the first field indicates that the quantity of data streams corresponding to the reference signal is 1 or 2. In other words, when the first field indicates that the quantity of data streams corresponding to the reference signal (for example, the DMRS) is 3 or 4, the length needed by the antenna port field may be reduced or shortened, thereby reducing overheads of the antenna port field and saving communication resources.

When the fifth bit state of the first field indicates that the quantity of data streams corresponding to the reference signal (for example, the DMRS) is 3 or 4, with reference to the foregoing examples, it can be learned that for the double-symbol type-1 DMRS, the antenna port field needs only 3 bit, and the length m of the antenna port field is equal to 3. When at least one of the first bit state, the second bit state, or the third bit state of the first field (or at least one bit state of the first field other than the fifth bit state) indicates that the quantity of data streams corresponding to the reference signal (for example, the DMRS) is 1 or 2, the antenna port field needs 5 bits, and the length n of the antenna port field is equal to 5. It can be learned that, when the first field indicates that the quantity of data streams corresponding to the reference signal (for example, the DMRS) is 3 or 4, the length of the antenna port field is m, which is less than the length n needed by the antenna port field when the first field indicates that the quantity of data streams corresponding to the reference signal is 1 or 2. In other words, when the first field indicates that the quantity of data streams corresponding to the reference signal (for example, the DMRS) is 3 or 4, the length needed by the antenna port field may be reduced or shortened, thereby reducing overheads of the antenna port field and saving communication resources.

When the fifth bit state of the first field indicates that the quantity of data streams corresponding to the reference signal (for example, the DMRS) is 3 or 4, with reference to the foregoing examples, it can be learned that for the single-symbol type-2 DMRS, the antenna port field needs only 3 bit, and the length m of the antenna port field is equal to 3. When at least one of the first bit state, the second bit state, or the third bit state of the first field (or at least one bit state of the first field other than the fifth bit state) indicates that the quantity of data streams corresponding to the reference signal (for example, the DMRS) is 1 or 2, the antenna port field needs 5 bits, and the length n of the antenna port field is equal to 5. It can be learned that, when the first field indicates that the quantity of data streams corresponding to the reference signal (for example, the DMRS) is 3 or 4, the length of the antenna port field is m, which is less than the length n needed by the antenna port field when the first field indicates that the quantity of data streams corresponding to the reference signal is 1 or 2. In other words, when the first field indicates that the quantity of data streams corresponding to the reference signal (for example, the DMRS) is 3 or 4, the length needed by the antenna port field may be reduced or shortened, thereby reducing overheads of the antenna port field and saving communication resources.

When the fifth bit state of the first field indicates that the quantity of data streams corresponding to the reference signal (for example, the DMRS) is 3 or 4, with reference to the foregoing examples, it can be learned that for the double-symbol type-2 DMRS, the antenna port field needs only 4 bit, and the length m of the antenna port field is equal to 4. When at least one of the first bit state, the second bit state, or the third bit state of the first field (or at least one bit state of the first field other than the fifth bit state) indicates that the quantity of data streams corresponding to the reference signal (for example, the DMRS) is 1 or 2, the antenna port field needs 6 bits, and the length n of the antenna port field is equal to 6. It can be learned that, when the first field indicates that the quantity of data streams corresponding to the reference signal (for example, the DMRS) is 3 or 4, the length of the antenna port field is m, which is less than the length n needed by the antenna port field when the first field indicates that the quantity of data streams corresponding to the reference signal is 1 or 2. In other words, when the first field indicates that the quantity of data streams corresponding to the reference signal (for example, the DMRS) is 3 or 4, the length needed by the antenna port field may be reduced or shortened, thereby reducing overheads of the antenna port field and saving communication resources.

Optionally, in some embodiments of this application, the first information may be the DCI. In this case, the first information (for example, the antenna port field in the first information) further indicates the first physical resource, and the bit status of the first field in the first information may further include a sixth bit state and/or a seventh bit state. The first physical resource may be one or more groups of time-domain and/or frequency-domain resources. In addition, the terminal device does not perform data transmission on the first physical resource. For example, the first physical resource may be a quantity of CDM groups. For another example, the first physical resource is one or more CDM groups.

The sixth bit state of the first field indicates that the code length of the first mask (for example, the FD-OCC) is the first code length (for example, 2) or the second code length (for example, 4), and no terminal device other than the terminal device performs data or signal transmission on the first physical resource.

The seventh bit state of the first field indicates that the code length of the first mask (for example, the FD-OCC) is the first code length (for example, 2) or the second code length (for example, 4), and another terminal device other than the terminal device performs data or signal transmission on the first physical resource.

Alternatively, the sixth bit state of the first field indicates that the code length of the first mask (for example, the FD-OCC) is the first code length (for example, 2) or the second code length (for example, 4), and another terminal device other than the terminal device performs data or signal transmission on the first physical resource.

The seventh bit state of the first field indicates that the code length of the first mask (for example, the FD-OCC) is the first code length (for example, 2) or the second code length (for example, 4), and no terminal device other than the terminal device performs data or signal transmission on the first physical resource.

Through such an indication, the terminal device can also determine a quantity of orthogonal DMRS ports that currently need to be distinguished, to user a more proper filter to obtain a better channel estimation effect.

When the bit status of the first field is the sixth bit state or the seventh bit state, in a possible implementation, the offset value of the reference signal port number or the value set to which the port number of the reference signal belongs may be predefined or preconfigured. For example, the offset value of the DMRS port number is the first offset value (for example, 0), or the port number of the DMRS belongs to the third value set (1000 to 1007). In other words, the sixth bit state or the seventh bit state of the first field may not indicate the reference signal (DMRS) port number. Alternatively, the offset value of the reference signal port number or the value set to which the port number of the reference signal belongs may be indicated by the second field.

Optionally, in some embodiments of this application, the bit status of the first field may further include an eighth bit state and/or a ninth bit state. The eighth bit state indicates that the quantity of data streams corresponding to the reference signal is 3, and the code length of the first mask is the second code length. The ninth bit state indicates that the quantity of data streams corresponding to the reference signal is 4, and the code length of the first mask is the second code length.

In this embodiment of this application, in a possible manner, the first information may be the DCI, and the first field may be the antenna port field. Alternatively, in another possible manner, the first field and the antenna port field are different fields.

The following provides descriptions with reference to specific examples.

A case in which the first field and the antenna port field are different fields is first described.

If the first field and the antenna port field are different fields, the eighth bit state of the first field indicates that the quantity of data streams corresponding to the reference signal (for example, the DMRS) is 3 (that is, indicates numbers of three DMRS ports), and the code length of the first mask (for example, the FD-OCC) is the second code length (for example, 4). In addition, the three DMRS port numbers obtained when the FD-OCC length is 4 and the quantity of data streams is 3 are the same as three DMRS port numbers obtained when the FD-OCC length is 2 and the quantity of data streams is 3.

The ninth bit state of the first field indicates that the quantity of data streams corresponding to the reference signal (for example, the DMRS) is 4 (that is, indicates numbers of four DMRS ports), and the code length of the first mask (for example, the FD-OCC) is the second code length (for example, 4). In addition, the three DMRS port numbers obtained when the FD-OCC length is 4 and the quantity of data streams is 4 are the same as four DMRS port numbers obtained when the FD-OCC length is 2 and the quantity of data streams is 4.

Based on the foregoing indication manners, when the length of the FD-OCC is 4 and the quantity of data streams is 3 or 4, the DMRS ports may be consistent with the DMRS ports used when the length of the FD-OCC is 2 and the quantity of data streams is 3 or 4, to ensure good backward compatibility.

When the bit status of the first field is the eighth bit state or the ninth bit state, in a possible implementation, the offset value of the reference signal port number or the value set to which the port number of the reference signal belongs may be predefined or preconfigured. For example, the offset value of the DMRS port number is the first offset value (for example, 0), or the port number of the DMRS belongs to the third value set (1000 to 1007). In other words, the eighth bit state or the ninth bit state may not indicate the reference signal (DMRS) port number. Alternatively, the offset value of the reference signal port number or the value set to which the port number of the reference signal belongs may be indicated by the second field.

The following describes a case in which the first field is the antenna port field.

If the first field is the antenna port field, for example, the first information may be the DCI, and the first field may be the antenna port field, the first mask is the FD-OCC, the first code length is 2, and the second code length is 4. For the single-symbol type-1 DMRS, the original antenna port field (for example, as shown in Table 6) is extended to 5 bits. In this case, there may be 32 different bit states, and the 32 different bit states include at least the following three parts:

Part 1: 12 original bit states in Table 6 in which the FD-OCC length is 2 (FD-OCC=2).
Part 2: nine bit states in which the FD-OCC length is 4, DMRS port numbers are the same as those in Table 6, and the quantity of data streams is 1 or 2.
Part 3: nine bit states in which the FD-OCC length is 4 (FD-OCC=4), DMRS port numbers are different from those in Table 6, and the quantity of data streams is 1 or 2.

In other words, an existing antenna port field (namely, the antenna port field corresponding to FD-OCC=2) may be extended, so that an extended antenna port field indicates the FD-OCC length.

For example, for the single-symbol type-1 DMRS, an antenna port indication relationship obtained by extending the antenna port field to 5 bits may be shown in Table 24.

**Table 24: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 (FD-OCC=2) | 0 |
| 1 | 1 (FD-OCC=2) | 1 |
| 2 | 1 (FD-OCC=4) | 0 |
| 3 | 1 (FD-OCC=4) | 1 |
| 4 | 1 (FD-OCC=4) | 8 |
| 5 | 1 (FD-OCC=4) | 9 |
| 6 | 1 (FD-OCC=2) | 0 and 1 |
| 7 | 1 (FD-OCC=4) | 0 and 1 |
| 8 | 1 (FD-OCC=4) | 8 and 9 |
| 9 | 2 (FD-OCC=2) | 0 |
| 10 | 2 (FD-OCC=2) | 1 |
| 11 | 2 (FD-OCC=2) | 2 |
| 12 | 2 (FD-OCC=2) | 3 |
| 13 | 2 (FD-OCC=4) | 0 |
| 14 | 2 (FD-OCC=4) | 1 |
| 15 | 2 (FD-OCC=4) | 2 |
| 16 | 2 (FD-OCC=4) | 3 |
| 17 | 2 (FD-OCC=4) | 8 |
| 18 | 2 (FD-OCC=4) | 9 |
| 19 | 2 (FD-OCC=4) | 10 |
| 20 | 2 (FD-OCC=4) | 11 |
| 21 | 2 (FD-OCC=2) | 0 and 1 |
| 22 | 2 (FD-OCC=2) | 2 and 3 |
| 23 | 2 (FD-OCC=4) | 0 and 1 |
| 24 | 2 (FD-OCC=4) | 2 and 3 |
| 25 | 2 (FD-OCC=4) | 8 and 9 |

(continued)

| One codeword (one codeword) Codeword 0 is enabled (codeword 0 enable), and codeword 1 is disabled (codeword 1 disable) | | |
| --- | --- | --- |
| Value (value) | Quantity of CDM groups without data (number of CDM group(s) without data) | DMRS port (DMRS port(s)) |
| 26 | 2 (FD-OCC=4) | 10 and 11 |
| 27 | 2 (FD-OCC=2) | 0 to 2 |
| 28 | 2 (FD-OCC=2) | 0 to 3 |
| 29 | 2 (FD-OCC=2) | 0 and 2 |
| 30 | 2 (FD-OCC=4) | 0 to 2 |
| 31 | 2 (FD-OCC=4) | 0 to 3 |

For example, with reference to the example shown in Table 24, the value (value) corresponding to the eighth bit state of the first field may be 30, indicating that the quantity of data streams corresponding to the DMRS is 3 (that is, three DMRS ports with numbers of 1000 to 1002), and the length of the FD-OCC is 4. The value (value) corresponding to the ninth bit state of the first field may be 31, indicating that the quantity of data streams corresponding to the DMRS is 4 (that is, three DMRS ports with numbers of 1000 to 1003), and the length of the FD-OCC is 4.

Based on the foregoing indication manners, when the length of the FD-OCC is 4 and the quantity of data streams is 3 or 4, the DMRS ports may be consistent with the DMRS ports used when the length of the FD-OCC is 2 and the quantity of data streams is 3 or 4, to ensure good backward compatibility.

It can be learned from Table 24 that when the quantity of data streams for FD-OCC=2 is 3 or 4, or when the quantity of DMRS ports is 3 or 4, the three or four DMRS ports do not belong to a same CDM group. To be specific, time and frequency positions of reference signal resources corresponding to the three or four DMRS ports are completely different.

For example, with reference to the example shown in Table 24, for FD-OCC=2, the value (value) corresponding to a tenth bit state of the first field is 27, and the numbers of the three DMRS ports are 1000 to 1002. It can be learned from the correspondence (for example, the correspondence shown in Table 4) between the type-1 DMRS port and the mapping parameter that the DMRS ports 1000 and 1001 belong to the CDM group 0, and the DMRS port 1002 belongs to the CDM group 1.

For another example, for FD-OCC=2, the value (value) corresponding to the tenth bit state of the first field is 28, and the numbers of the four DMRS ports are 1000 to 1003. It can be learned from the correspondence (for example, the correspondence shown in Table 4) between the type-1 DMRS port and the mapping parameter that the DMRS ports 1000 and 1001 belong to the CDM group 0, and the DMRS ports 1002 and 1003 belong to the CDM group 1.

For the single-symbol type-2 DMRS, the original antenna port field (for example, as shown in Table 8) is extended to 7 bits, and there may be 128 different bit states. For example, for the single-symbol type-2 DMRS, an antenna port indication relationship obtained by extending the antenna port field to 7 bits may be shown in Table 25.

**Table 25: Antenna port indication table (dmrs-Type=2 and maxLength=1)**

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
| --- | --- | --- | --- | --- | --- |
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 0 | 1 (FD-OCC=2) | 0 | 0 | 2 (FD-OCC=2) | 0 to 4 |
| 1 | 1 (FD-OCC=2) | 1 | 1 | 2 (FD-OCC=4) | 0 to 4 |
| 2 | 1 (FD-OCC=4) | 0 | 2 | 2 (FD-OCC=4) | 12 to 16 |
| 3 | 1 (FD-OCC=4) | 1 | 3 | 2 (FD-OCC=2) | 0 to 5 |
| 4 | 1 (FD-OCC=4) | 12 | 4 | 2 (FD-OCC=4) | 0 to 5 |
| 5 | 1 (FD-OCC=4) | 13 | 5 | 2 (FD-OCC=4) | 12 to 17 |

(continued)

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
|---|---|---|---|---|---|
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 6 | 1 (FD-OCC=2) | 0 and 1 | 6 to 127 | Reserved (Reserved) | Reserved (Reserved) |
| 7 | 1 (FD-OCC=4) | 0 and 1 | | | |
| 8 | 1 (FD-OCC=4) | 12 and 13 | | | |
| 9 | 2 (FD-OCC=2) | 0 | | | |
| 10 | 2 (FD-OCC=4) | 0 | | | |
| 11 | 2 (FD-OCC=4) | 12 | | | |
| 12 | 2 (FD-OCC=2) | 1 | | | |
| 13 | 2 (FD-OCC=4) | 1 | | | |
| 14 | 2 (FD-OCC=4) | 13 | | | |
| 15 | 2 (FD-OCC=2) | 2 | | | |
| 16 | 2 (FD-OCC=4) | 2 | | | |
| 17 | 2 (FD-OCC=4) | 14 | | | |
| 18 | 2 (FD-OCC=2) | 3 | | | |
| 19 | 2 (FD-OCC=4) | 3 | | | |
| 20 | 2 (FD-OCC=4) | 15 | | | |
| 21 | 2 (FD-OCC=2) | 0 and 1 | | | |
| 22 | 2 (FD-OCC=4) | 0 and 1 | | | |
| 23 | 2 (FD-OCC=4) | 12 and 13 | | | |
| 24 | 2 (FD-OCC=2) | 2 and 3 | | | |
| 25 | 2 (FD-OCC=4) | 2 and 3 | | | |
| 26 | 2 (FD-OCC=4) | 14 and 15 | | | |
| 27 | 2 (FD-OCC=2) | 0 to 2 | | | |
| 28 | 2 (FD-OCC=4) | 0 to 2 | | | |
| 29 | 2 (FD-OCC=4) | 12 to 14 | | | |
| 30 | 2 (FD-OCC=2) | 0 to 3 | | | |
| 31 | 2 (FD-OCC=4) | 0 to 3 | | | |
| 32 | 2 (FD-OCC=4) | 12 to 15 | | | |
| 33 | 3 (FD-OCC=2) | 0 | | | |
| 34 | 3 (FD-OCC=4) | 0 | | | |
| 35 | 3 (FD-OCC=4) | 12 | | | |
| 36 | 3 (FD-OCC=2) | 1 | | | |
| 37 | 3 (FD-OCC=4) | 1 | | | |
| 38 | 3 (FD-OCC=4) | 13 | | | |
| 39 | 3 (FD-OCC=2) | 2 | | | |
| 40 | 3 (FD-OCC=4) | 2 | | | |

(continued)

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
|---|---|---|---|---|---|
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 41 | 3 (FD-OCC=4) | 14 | | | |
| 42 | 3 (FD-OCC=2) | 3 | | | |
| 43 | 3 (FD-OCC=4) | 3 | | | |
| 44 | 3 (FD-OCC=4) | 15 | | | |
| 45 | 3 (FD-OCC=2) | 4 | | | |
| 46 | 3 (FD-OCC=4) | 4 | | | |
| 47 | 3 (FD-OCC=4) | 16 | | | |
| 48 | 3 (FD-OCC=2) | 5 | | | |
| 49 | 3 (FD-OCC=4) | 5 | | | |
| 50 | 3 (FD-OCC=4) | 17 | | | |
| 51 | 3 (FD-OCC=2) | 0 and 1 | | | |
| 52 | 3 (FD-OCC=4) | 0 and 1 | | | |
| 53 | 3 (FD-OCC=4) | 12 and 13 | | | |
| 54 | 3 (FD-OCC=2) | 2 and 3 | | | |
| 55 | 3 (FD-OCC=4) | 2 and 3 | | | |
| 56 | 3 (FD-OCC=4) | 14 and 15 | | | |
| 57 | 3 (FD-OCC=2) | 4 and 5 | | | |
| 58 | 3 (FD-OCC=4) | 4 and 5 | | | |
| 59 | 3 (FD-OCC=4) | 16 and 17 | | | |
| 60 | 3 (FD-OCC=2) | 0 to 2 | | | |
| 61 | 3 (FD-OCC=4) | 0 to 2 | | | |
| 62 | 3 (FD-OCC=4) | 12 to 14 | | | |
| 63 | 3 (FD-OCC=2) | 3 to 5 | | | |
| 64 | 3 (FD-OCC=4) | 3 to 5 | | | |
| 65 | 3 (FD-OCC=4) | 15 to 17 | | | |
| 66 | 3 (FD-OCC=2) | 0 to 3 | | | |
| 67 | 3 (FD-OCC=4) | 0 to 3 | | | |
| 68 | 3 (FD-OCC=4) | 12 to 15 | | | |
| 69 | 3 (FD-OCC=2) | 0 and 2 | | | |
| 70 | 3 (FD-OCC=4) | 0 and 2 | | | |
| 71 | 3 (FD-OCC=4) | 12 and 14 | | | |
| 72 to 127 | Reserved (Reserved) | Reserved (Reserved) | | | |

For example, with reference to the example shown in Table 25, the value (value) corresponding to the eighth bit state of the first field may be 28, indicating that the quantity of data streams corresponding to the DMRS is 3 (that is, three DMRS ports with numbers of 1000 to 1002), and the length of the FD-OCC is 4. The value (value) corresponding to the ninth bit state of the first field may be 27, indicating that the quantity of data streams corresponding to the DMRS is 3 (that is, three DMRS ports with numbers of 1000 to 1002), and the length of the FD-OCC is 2.

Based on the foregoing indication manners, when the FD-OCC length is 4 and the quantity of data streams is 3 or 4, the DMRS ports may be consistent with the DMRS ports used when the FD-OCC length is 2 and the quantity of data streams is 3 or 4, to ensure good backward compatibility.

It can be learned from Table 25 that when the quantity of data streams for FD-OCC=2 is 3 or 4, or when the quantity of DMRS ports is 3 or 4, the three or four DMRS ports do not belong to a same CDM group. To be specific, time and frequency positions of reference signal resources corresponding to the three or four DMRS ports are completely different.

For example, with reference to the example shown in Table 25, for FD-OCC=2, the value (value) corresponding to the tenth bit state of the first field is 30, and the numbers of the four DMRS ports are 1000 to 1003. However, the DMRS ports 1000 and 1001 belong to the CDM group 0, and the DMRS ports 1002 and 1003 belong to the CDM group 1.

Because the three or four DMRS ports do not belong to a same CDM group, complexity of implementing DMRS port orthogonality by the terminal device is increased, and a frequency domain resource is wasted. This is not conducive to reducing, by the terminal device through precoding, orthogonality damage caused by a non-ideal factor. Therefore, in some implementations of this application, for the single-symbol type-1 DMRS, as shown in Table 26, for the two bit states in which the values (values) of the antenna port field are 30 and 31 in Table 24, the two bit states in which the values (values) of the antenna port field are 30 and 31 may further indicate: The code length of the first mask (for example, the FD-OCC) is the second code length (for example, 4), the quantity of DMRS ports is 3 or 4, and time and frequency positions of reference signal resources corresponding to the DMRS ports are the same. In other words, the three or four DMRS ports belong to a same CDM group.

**Table 26: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 to 29 | Same as those in Table 24 | Same as those in Table 24 |
| 30 | 2 (FD-OCC=4) | 0, 1, and 8 |
| 31 | 2 (FD-OCC=4) | 0, 1, 8, and 9 |

As shown in Table 26, for FD-OCC=4, a value (value) corresponding to an eleventh bit state of the first field is 30, and the numbers of the three DMRS ports are 1000, 1001, and 1008. It can be learned from the correspondence (for example, the correspondence shown in Table 11) between the type-1 DMRS port and the mapping parameter that the DMRS ports 1000, 1001, and 1008 belong to the CDM group 0.

Alternatively, for FD-OCC=4, the value (value) corresponding to the eleventh bit state of the first field is 31, and the numbers of the four DMRS ports are 1000, 1001, 1008, and 1009. It can be learned from the correspondence (for example, the correspondence shown in Table 11) between the type-1 DMRS port and the mapping parameter that all the DMRS ports 1000, 1001, 1008, and 1009 belong to the CDM group 0.

In the foregoing indication manners, when the FD-OCC length is 4 and the quantity of data streams is 3 or 4, DMRS ports are indicated as ports in a same CDM group. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

Table 24 and Table 26 are examples for the single-symbol type-1 DMRS. For the single-symbol type-2 DMRS, the original antenna port indication table may also be extended, and an extended antenna port field is shown in Table 25, so that the FD-OCC length is indicated by using the extended antenna port indication table. In addition, further, in the extended antenna port indication table, a bit status (which may be, for example, a reserved bit state) of the antenna port field may further include one or more bit states (namely, the eleventh bit state), indicating that, when the code length of the FD-OCC is 4 and the quantity of DMRS ports is 3 or 4, the time and frequency positions of the reference signal resources corresponding to the DMRS ports are the same (namely, belong to a same CDM group).

For example, the reserved bit state of the antenna port field in Table 25 may indicate that the code length of the first mask (for example, the FD-OCC) is the second code length (for example, 4), the quantity of DMRS ports is 3 or 4, and the time and frequency positions of the reference signal resources corresponding to the DMRS ports are the same. In other words, the three or four DMRS ports belong to a same CDM group. An antenna port indication relationship may be shown in Table 27.

**Table 27: Antenna port indication table (dmrs-Type=2 and maxLength=1)**

| One codeword (one codeword) Codeword 0 is enabled (codeword 0 enable), and codeword 1 is disabled (codeword 1 disable) | | | Two codewords (one codeword) Codeword 0 is enabled (codeword 0 enable), and codeword 1 is enabled (codeword 1 enable) | | |
|---|---|---|---|---|---|
| Value (value) | Quantity of CDM groups without data (number of CDM group(s) without data) | DMRS port (DMRS port(s)) | Value (value) | Quantity of CDM groups without data (number of CDM group(s) without data) | DMRS port (DMRS port(s)) |
| 0 to 71 | Same as those in Table 25 | Same as those in Table 25 | 0 to 5 | Same as those in Table 25 | Same as those in Table 25 |
| 72 | 2 (FD-OCC=4) | 0, 1, and 12 | 6 to 127 | Reserved (Reserved) | Reserved (Reserved) |
| 73 | 2 (FD-OCC=4) | 0, 1, 12, and 13 | | | |
| 74 | 3 (FD-OCC=4) | 2, 3, 14, and 15 | | | |
| 74 to 127 | Reserved (Reserved) | Reserved (Reserved) | | | |

As shown in Table 27, for FD-OCC=4, the value (value) corresponding to the eleventh bit state of the first field is 72, and the numbers of the three DMRS ports are 1000, 1001, and 1012. It can be learned that the DMRS ports 1000, 1001, and 1012 belong to the CDM group 0.

Alternatively, for FD-OCC=4, the value (value) corresponding to the eleventh bit state of the first field is 74, and the numbers of the four DMRS ports are 1002, 1003, 1014, and 1015. It can be learned that the DMRS ports 1002, 1003, 1014, and 1015 belong to the CDM group 1.

In the foregoing indication manners, when the FD-OCC length is 4 and the quantity of data streams is 3 or 4, the DMRS ports are indicated as ports in a same CDM group. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

For the double-symbol type-1 DMRS, the original antenna port indication table (Table 7) may also be extended, so that the FD-OCC length is indicated by using an extended antenna port indication table. In addition, further, in the extended antenna port indication table, the bit status of the antenna port field may further include one or more bit states (namely, a thirteenth bit state), indicating that, when the code length of the FD-OCC is 4 and the quantity of DMRS ports is greater than 4, the time and frequency positions of the reference signal resources corresponding to the DMRS ports are the same (namely, belong to a same CDM group).

For the double-symbol type-2 DMRS, the original antenna port indication table (Table 9) may also be extended, so that the FD-OCC length is indicated by using an extended antenna port indication table. In addition, further, in the extended antenna port indication table, the bit status of the antenna port field may further include one or more bit states (namely, a thirteenth bit state), indicating that, when the code length of the FD-OCC is 4 and the quantity of DMRS ports is greater than 4, the time and frequency positions of the reference signal resources corresponding to the DMRS ports are the same (namely, belong to a same CDM group).

In the foregoing indication manners, when the FD-OCC length is 4 and the quantity of data streams is greater than 3 (the quantity of DMRS ports is greater than 3), the DMRS ports are indicated as ports in a same CDM group. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

Optionally, when the FD-OCC length and the DMRS port number are indicated to the terminal device by using the extended antenna port field, in a possible implementation, an offset value of a DMRS port number corresponding to a bit state of the extended antenna port field or a value set to which the DMRS port number belongs may be predefined or preconfigured. For example, the offset value of the DMRS port number is the first offset value (for example, 0), or the port number of the DMRS belongs to the third value set (1000 to 1007). In another possible implementation, an offset value of a DMRS port number corresponding to a bit state of the extended antenna port field or a value set to which the DMRS port number belongs may also be indicated by the second field.

Optionally, in some embodiments of this application, in addition to indicating, to the terminal device by using the extended antenna port field, that the DMRS ports belong to the same CDM group when the FD-OCC length is 4 and the quantity of data streams is greater than 3 (the quantity of DMRS ports is greater than 3), a reserved bit of an existing antenna port field (an antenna port field corresponding to FD-OCC=2) may be used for indication. The following provides specific descriptions.

For example, for the single-symbol type-1 DMRS, an antenna port indication relationship may be shown in Table 28.

**Table 28: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 0 |
| 1 | 1 | 1 |
| 2 | 1 | 0 and 1 |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 | 1 (FD-OCC=4) | 0, 1, and 8 |
| 13 | 1 (FD-OCC=4) | 0, 1, 8, and 9 |
| 14 | 2 (FD-OCC=4) | 0, 1, and 8 |
| 15 | 2 (FD-OCC=4) | 0, 1, 8, and 9 |

For example, as shown in Table 28, the reserved bit (with values (values) of 12 to 15) of the existing antenna port field (for example, Table 6) indicates that the DMRS ports are indicated as ports in a same CDM group when the FD-OCC length is 4, and the quantity of data streams is 3 or 4.

As shown in Table 28, for FD-OCC=4, the value (value) of the antenna port field is 12 or 14, and the numbers of the three DMRS ports are 1000, 1001, and 1008. It may be determined, based on the correspondence (for example, the correspondence shown in Table 11) between the type-1 DMRS port and the mapping parameter, that the DMRS ports 1000, 1001, and 1008 belong to the CDM group 0.

Alternatively, for FD-OCC=4, the value (value) of the antenna port field is 13 or 15, and the numbers of the four DMRS ports are 1000, 1001, 1008, and 1009. It may be determined, based on the correspondence (for example, the correspondence shown in Table 11) between the type-1 DMRS port and the mapping parameter, that all the DMRS ports 1000, 1001, 1008, and 1009 belong to the CDM group 0.

For another example, for the single-symbol type-1 DMRS, an antenna port indication relationship may be shown in Table 29.

**Table 29: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 0 |
| 1 | 1 | 1 |
| 2 | 1 | 0 and 1 |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 | 2 (FD-OCC=4) | 0, 1, and 8 |
| 13 | 2 (FD-OCC=4) | 2, 3, and 10 |
| 14 | 2 (FD-OCC=4) | 0, 1, 8, and 9 |
| 15 | 2 (FD-OCC=4) | 2, 3, 10, and 11 |

As shown in Table 29, for FD-OCC=4, the value (value) of the antenna port field is 13, and the numbers of the three DMRS ports are 1002, 1003, and 1010. It may be determined, based on the correspondence (for example, the correspondence shown in Table 11) between the type-1 DMRS port and the mapping parameter, that the DMRS ports 1002, 1003, and 1010 belong to the CDM group 1.

For FD-OCC=4, the value (value) of the antenna port field is 15, and the numbers of the four DMRS ports are 1002, 1003, 1010, and 1011. It may be determined, based on the correspondence (for example, the correspondence shown in Table 11) between the type-1 DMRS port and the mapping parameter, that the DMRS ports 1002, 1003, 1010, and 1011 belong to the CDM group 1.

In the foregoing indication manners, when the FD-OCC length is 4 and the quantity of data streams is 3 or 4, the DMRS ports may also be indicated as ports in a same CDM group. This ensures that DMRS ports of the terminal device are allocated to a same CDM group. This helps reduce complexity of implementing DMRS orthogonality by the terminal device, and saves frequency domain resources.

The foregoing examples are examples for the single-symbol type-1 DMRS. For the single-symbol type-2 DMRS, a reserved bit of an existing antenna port field (an antenna port field corresponding to FD-OCC=2) corresponding to the single-symbol type-2 DMRS may also indicate: When the FD-OCC length is 4 and the quantity of data streams is 3 or 4, the DMRS ports are indicated as ports in a same CDM group.

For the double-symbol type-1 DMRS and the double-symbol type-2 DMRS, a reserved bit of an existing antenna port field corresponding to each of the two DMRSs may also indicate: When the FD-OCC length is 4 and the quantity of data streams is greater than 4, the DMRS ports are indicated as ports in a same CDM group.

Optionally, when the reserved bit of the existing antenna port field (antenna port field corresponding to FD-OCC=2) indicates the FD-OCC length and the DMRS port numbers to the terminal device, in a possible implementation, an offset value of a DMRS port number corresponding to a bit state of the reserved bit of the existing antenna port field or a value set to which the DMRS port number belongs may be predefined or preconfigured. For example, the offset value of the DMRS port number is the first offset value (for example, 0), or the port number of the DMRS belongs to the third value set (1000 to 1007). In another possible implementation, an offset value of a DMRS port number corresponding to a bit state of the reserved bit of the existing antenna port field or a value set to which the DMRS port number belongs may also be indicated by the second field.

In the foregoing examples, an example in which the first field may be the antenna port field is used to describe a case in which the DMRS ports are indicated as ports in a same CDM group when the FD-OCC length is 4 and the quantity of data streams is greater than 3. In some other embodiments of this application, the first field may alternatively be different from the antenna port field. In this case, the bit status of the first field further includes a tenth bit state and/or an eleventh bit state.

The tenth bit state indicates that the code length of the first mask (for example, the FD-OCC) is the first code length (for example, 2), the quantity of ports of the reference signal (for example, the DMRS) is 3 or 4, and time and/or frequency positions of reference signal resources corresponding to the ports of the reference signal are different.

The eleventh bit state indicates that the code length of the first mask (for example, the FD-OCC) is the second code length (for example, 2), the quantity of ports of the reference signal (for example, the DMRS) is 3 or 4, and the time and frequency positions of the reference signal resources corresponding to the ports of the reference signal are the same. In other words, the three or four DMRS ports are ports in a same CDM group.

In other words, for the single-symbol type-1 DMRS and the single-symbol type-2 DMRS, when the FD-OCC length is 4 and the quantity of data streams is 3 or 4, the DMRS ports are indicated as ports in the same CDM group by using the eleventh bit state of the first field. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

When the bit status of the first field is the tenth bit state or the eleventh bit state, in a possible implementation, the offset value of the reference signal (for example, DMRS) port number or the value set to which the port number of the reference signal (for example, the DMRS) belongs may be predefined or preconfigured. For example, the offset value of the DMRS port number is the first offset value (for example, 0), or the port number of the DMRS belongs to the third value set (1000 to 1007). In other words, the tenth bit state and/or the eleventh bit state may not indicate the reference signal (DMRS) port number. Alternatively, the offset value of the reference signal port number or the value set to which the port number of the reference signal belongs may be indicated by the second field.

In some other embodiments of this application, the first field may alternatively be different from the antenna port field. In this case, the bit status of the first field further includes a twelfth bit state and/or a thirteenth bit state.

The twelfth bit state indicates that the code length of the first mask (for example, the FD-OCC) is the first code length (for example, 2), the quantity of ports of the reference signal (for example, the DMRS) is greater than 4, and time and/or frequency positions of reference signal resources corresponding to the ports of the reference signal are different.

The thirteenth bit state indicates that the code length of the first mask (for example, the FD-OCC) is the second code length (for example, 2), the quantity of ports of the reference signal (for example, the DMRS) is greater than 4, and the time and frequency positions of the reference signal resources corresponding to the ports of the reference signal are the same. In other words, the more than four DMRS ports are ports in a same CDM group.

In other words, for the double-symbol type-1 DMRS and the double-symbol type-2 DMRS, when the FD-OCC length is 4 and the quantity of data streams is greater than 4, the DMRS ports are indicated as ports in the same CDM group by using the thirteenth bit state of the first field. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

When the bit status of the first field is the twelfth bit state or the thirteenth bit state, in a possible implementation, the offset value of the reference signal (for example, DMRS) port number or the value set to which the port number of the reference signal (for example, the DMRS) belongs may be predefined or preconfigured. For example, the offset value of the DMRS port number is the first offset value (for example, 0), or the port number of the DMRS belongs to the third value set (1000 to 1007). In other words, the twelfth bit state and/or the thirteenth bit state may not indicate the reference signal (DMRS) port number. Alternatively, the offset value of the reference signal port number or the value set to which the port number of the reference signal belongs may be indicated by the second field.

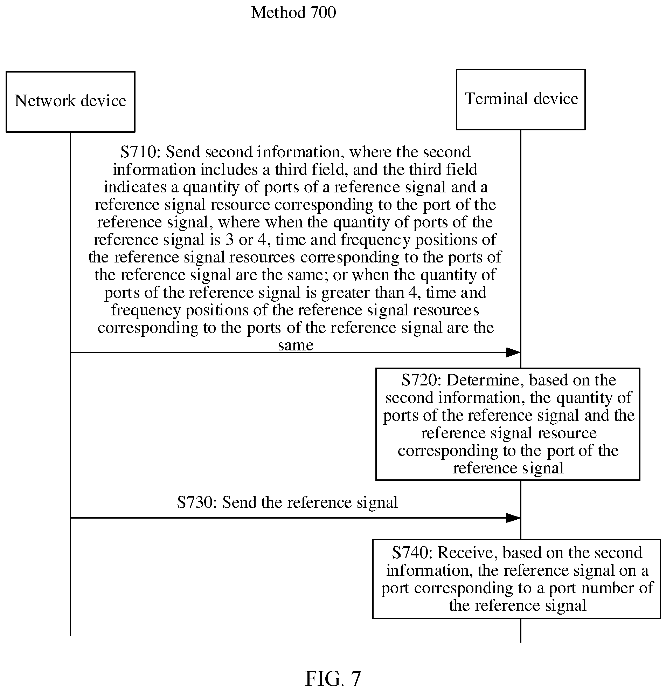

FIG. 7 is a schematic interaction diagram of a signal transmission method 700 according to another embodiment of this application. The method 700 may be used in the scenario shown in FIG. 5, and certainly may also be used in another communication scenario. This is not limited in embodiments of this application.

As shown in FIG. 7, the method 700 shown in FIG. 7 may include S710 to S740. The following describes steps in the method 700 in detail with reference to FIG. 7.

S710: A network device sends second information to a terminal device, where the second information includes a third field, and the third field is used to determine a quantity of ports of a reference signal and a reference signal resource corresponding to the port of the reference signal.

The quantity of ports of the reference signal is 3 or 4, and time and frequency positions of the reference signal resources corresponding to the ports of the reference signal are the same; or the quantity of ports of the reference signal is greater than 4, and time and frequency positions of the reference signal resources corresponding to the ports of the reference signal are the same.

Alternatively, the quantity of ports of the reference signal is 3 or 4, and time or frequency positions of the reference signal resources corresponding to the ports of the reference signal are the same; or the quantity of ports of the reference signal is greater than 4, and time or frequency positions of the reference signal resources corresponding to the ports of the reference signal are the same.

It may be understood that the reference signal resource corresponding to the port of the reference signal is a time and/or frequency resource for sending or receiving the reference signal.

In a possible implementation, the second information may be higher layer information or downlink control information. For example, the second information may be RRC, a MAC CE, or RLC signaling. For another example, the second information may be DCI. A specific form of the second information is not limited in this embodiment of this application.

In a possible implementation, if the second information may be the DCI, the third field may be an antenna port field.

In a possible implementation, the reference signal indicated by the third field may be a DMRS (downlink DMRS).

It should be understood that, in another implementation of this application, the reference signal indicated by the third field may alternatively be another reference signal, for example, including an uplink DMRS, an SRS, a PTRS, a CSI-RS, or the like. This is not limited herein in this embodiment of this application. In the following examples, the DMRS (downlink DMRS) is used as an example for description.

In a possible implementation, the quantity of ports of the reference signal that is indicated by the third field is 3 or 4 (namely, a quantity of data streams is 3 or 4), and the time and frequency positions of the reference signal resources corresponding to the ports of the reference signal (namely, resources corresponding to the three or four ports of the reference signal) are the same.

In another possible implementation, the quantity of ports of the reference signal that is indicated by the third field is 3 or 4 (namely, a quantity of data streams is 3 or 4), and the time and frequency positions of the reference signal resources corresponding to the ports of the reference signal (namely, resources corresponding to the three or four ports of the reference signal) are the same.

In another possible implementation, the quantity of ports of the reference signal that is indicated by the third field is 3 or 4 (namely, a quantity of data streams is 3 or 4), and the time and/or frequency positions of the reference signal resources corresponding to the ports of the reference signal (namely, resources corresponding to the three or four ports of the reference signal) are the same.

In another possible implementation, the quantity of ports of the reference signal that is indicated by the third field is greater than 4 (namely, a quantity of data streams is greater than 4), and the time and frequency positions of the reference signal resources corresponding to the ports of the reference signal (namely, resources corresponding to the more than four ports of the reference signal) are the same.

In another possible implementation, the quantity of ports of the reference signal that is indicated by the third field is greater than 4 (namely, a quantity of data streams is greater than 4), and the time and frequency positions of the reference signal resources corresponding to the ports of the reference signal (namely, resources corresponding to the more than four ports of the reference signal) are the same.

In another possible implementation, the quantity of ports of the reference signal that is indicated by the third field is greater than 4 (namely, a quantity of data streams is greater than 4), and the time and/or frequency positions of the reference signal resources corresponding to the ports of the reference signal (namely, resources corresponding to the more than four ports of the reference signal) are the same.

It should be understood that, in this embodiment of this application, the reference signal resource (a time domain resource and a frequency resource) corresponding to the port of the reference signal may be understood as a physical resource corresponding to the port of the reference signal, and the physical resource may be one or more groups of time domain and/or frequency domain resources. In addition, the terminal device does not perform data transmission on the physical resource. For example, the physical resource may be a quantity of CDM groups. For another example, the physical resource is one or more CDM groups.

In a possible implementation, it is assumed that the reference signal is the DMRS, and the third field is the antenna port field. For a single-symbol type-1 DMRS, an antenna port indication relationship may be shown in Table 30.

**Table 30: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 0 |

(continued)

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 1 | 1 | 1 |
| 2 | 1 | 0 and 1 |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 | 2 | 0, 1, and 8 |
| 13 | 2 | 2, 3, and 10 |
| 14 | 2 | 0, 1, 8, and 9 |
| 15 | 2 | 2, 3, 10, and 11 |

In the example shown in Table 30:
For example, if the value (value) of the third field is 12, the indicated quantity of ports of the DMRS is 3, and numbers of the three DMRS ports are respectively 1000, 1001, and 1008. It may be determined, based on a correspondence (for example, the correspondence shown in Table 11) between a port of a type-1 DMRS and a mapping parameter, that the DMRS ports 1000, 1001, and 1008 all belong to a CDM group 0. To be specific, time and frequency positions of DMRS resources corresponding to the three DMRS ports are the same.

For another example, if the value (value) of the third field is 13, the indicated quantity of ports of the DMRS is 3, and numbers of the three DMRS ports are respectively 1002, 1003, and 1010. It may be determined, based on the correspondence (for example, the correspondence shown in Table 11) between the port of the type-1 DMRS and the mapping parameter, that the DMRS ports 1000, 1001, and 1008 all belong to a CDM group 1. To be specific, time and frequency positions of DMRS resources corresponding to the three DMRS ports are the same.

For another example, if the value (value) of the third field is 14, the indicated quantity of ports of the DMRS is 4, and numbers of the four DMRS ports are respectively 1000, 1001, 1008, and 1009. It may be determined, based on the correspondence (for example, the correspondence shown in Table 11) between the port of the type-1 DMRS and the mapping parameter, that the DMRS ports 1000, 1001, and 1008 all belong to the CDM group 0. To be specific, time and frequency positions of DMRS resources corresponding to the four DMRS ports are the same.

In another possible implementation, it is assumed that the reference signal is the DMRS, and the third field is the antenna port field. For a single-symbol type-1 DMRS, an antenna port indication relationship may be shown in Table 31.

**Table 31: Antenna port indication table (dmrs-Type=1 and maxLength=1)**

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 0 | 1 | 0 |
| 1 | 1 | 1 |
| 2 | 1 | 0 and 1 |

(continued)

| One codeword (one codeword) Codeword 0 is enabled (codeword 0 enable), and codeword 1 is disabled (codeword 1 disable) | | |
|---|---|---|
| Value (value) | Quantity of CDM groups without data (number of CDM group(s) without data) | DMRS port (DMRS port(s)) |
| 3 | 2 | 0 |
| 4 | 2 | 1 |
| 5 | 2 | 2 |
| 6 | 2 | 3 |
| 7 | 2 | 0 and 1 |
| 8 | 2 | 2 and 3 |
| 9 | 2 | 0 to 2 |
| 10 | 2 | 0 to 3 |
| 11 | 2 | 0 and 2 |
| 12 | 1 | 0, 1, and 8 |
| 13 | 1 | 0, 1, 8, and 9 |
| 14 | 2 | 0, 1, and 8 |
| 15 | 2 | 0, 1, 8, and 9 |

In the example shown in Table 31:
For example, if the value (value) of the third field is 12, the indicated quantity of ports of the DMRS is 3, and numbers of the three DMRS ports are respectively 1000, 1001, and 1008. It may be determined, based on a correspondence (for example, the correspondence shown in Table 11) between a port of a type-1 DMRS and a mapping parameter, that the DMRS ports 1000, 1001, and 1008 all belong to a CDM group 0. To be specific, time and frequency positions of DMRS resources corresponding to the three DMRS ports are the same.

For another example, if the value (value) of the third field is 13, the indicated quantity of ports of the DMRS is 4, and numbers of the four DMRS ports are respectively 1000, 1001, 1008, and 1009. It may be determined, based on the correspondence (for example, the correspondence shown in Table 11) between the port of the type-1 DMRS and the mapping parameter, that the DMRS ports 11000, 1001, 1008, and 1009 all belong to the CDM group 0. To be specific, time and frequency positions of DMRS resources corresponding to the four DMRS ports are the same.

The examples shown in Table 30 and Table 31 are for the single-symbol type-1 DMRS, and a reserved bit of an existing antenna port field (shown in Table 6) corresponding to the single-symbol type-1 DMRS is used to indicate: When the quantity of ports of the DMRS is 3 or 4, the three or four DMRS ports are indicated as ports in a same CDM group. To be specific, time and frequency positions of reference signal resources corresponding to the three or four DMRS ports are the same.

In some possible implementations, for a single-symbol type-2 DMRS, a reserved bit of an existing antenna port field (shown in Table 8) corresponding to the single-symbol type-2 DMRS is used to indicate: When the quantity of ports of the DMRS is 3 or 4, the three or four DMRS ports are indicated as ports in a same CDM group. To be specific, time and frequency positions of reference signal resources corresponding to the three or four DMRS ports are the same.

In some possible implementations, for a double-symbol type-1 DMRS and a double-symbol type-2 DMRS, a reserved bit of an existing antenna port field (shown in Table 7 and Table 9) corresponding to each of the double-symbol type-1 DMRS and the double-symbol type-2 DMRS is used to indicate: When the quantity of ports of the DMRS is greater than 4, the more than four DMRS ports are indicated as ports in a same CDM group. To be specific, time and frequency positions of reference signal resources corresponding to the more than four DMRS ports are the same.

Based on the foregoing indication methods, it is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

In some implementations, the second information may further indicate a DMRS port number.

S720: After receiving the second information, the terminal device determines, based on the second information, the quantity of ports of the reference signal and the reference signal resource corresponding to the port of the reference signal.

In some implementations, the second information may be the DCI, the third field may be the antenna port field. The terminal device may determine the value (value) of the antenna port field based on the antenna port field in the DCI sent by the network device, to determine the DMRS port number indicated by the field and the physical resource corresponding to the DMRS port. The physical resource may be the quantity of CDM groups.

S730: The network device sends the reference signal to the terminal device.

For example, if the reference signal is the DMRS, the network device may send the DMRS to the terminal device on the time and/or frequency resource corresponding to the DMRS through the DMRS port.

In a possible implementation, the terminal device may determine, based on the higher layer parameter RRC and/or the DCI, the time and/or frequency resource corresponding to the DMRS.

S740: The terminal device receives, based on the second information, the reference signal on the port corresponding to the port number of the reference signal.

In a possible implementation, the terminal device may determine the value (value) of the antenna port field based on the antenna port field in the DCI sent by the network device, to determine the DMRS port number and the physical resource corresponding to the DMRS port that are indicated by the field. The physical resource may be the quantity of CDM groups. In this way, the DMRS is received on the physical resource corresponding to the DMRS port through the DMRS port.

The third field may indicate: The quantity of ports of the DMRS is 3 or 4, and the time and frequency positions of the reference signal resources corresponding to the three or four DMRS ports are the same; or the quantity of ports of the DMRS is greater than 4, and the time and frequency positions of the reference signal resources corresponding to the more than four DMRS ports are the same. Therefore, the terminal device may determine, based on the third field, that the DMRS ports are indicated as ports in the same CDM group when the quantity of data streams is 3 or 4, or the DMRS ports are indicated as ports in the same CDM group when the quantity of data streams is greater than 3. It is ensured that DMRS ports of the terminal device are allocated to a same CDM group. This helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

Optionally, in some implementations, the third field is further used to determine a code length of a first mask, the code length of the first mask is included in a first value set, and the first value set includes one or more of the following values: 2, 3, 4, 6, and 8.

In some possible implementations, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

In some implementations, the code length of the first mask may be any one of 2, 3, 4, 6, and 8.

In some implementations, the first value set is a value set including one or more integers. For example, if the first value set is {2, 4}, a candidate value of the code length of the first mask may be 2 or 4. The first information indicates that the code length of the first mask is a value in the first value set.

For example, the reference signal may be a downlink DMRS or an uplink DMRS. If the reference signal is the downlink DMRS, the terminal device receives the reference signal. If the reference signal is the uplink DMRS, the terminal device sends the reference signal.

For example, different bit states of a bit of the third field may indicate different code lengths, quantities of ports of the reference signal, and reference signal resources corresponding to the ports of the reference signal.

For example, when the third field indicates that the quantity of ports of the DMRS is 3 or 4, and the time and frequency positions of the reference signal resources corresponding to the three or four DMRS ports are the same, a code length of a corresponding FD-OCC may be 4.

For another example, when the third field indicates that the quantity of ports of the DMRS is greater than 4, and the time and frequency positions of the reference signal resources corresponding to the more than four DMRS ports are the same, a code length of a corresponding FD-OCC may also be 4.

In some implementations, when the third field further indicates the code length of the first mask, for the single-symbol type-1 DMRS, an antenna port indication table corresponding to the third field may be shown in Table 24 or Table 25.

Based on the signal transmission method provided in this application, the following information is indicated to the terminal device: The quantity of ports of the reference signal is 3 or 4 (namely, the quantity of data streams is 3 or 4), and the time and frequency positions of the reference signal resources corresponding to the ports of the reference signal are the same; or the quantity of ports of the reference signal is greater than 4 (namely, the quantity of data streams is greater than 4), and the time and/or frequency positions of the reference signal resources corresponding to the ports of the reference signal are the same. Further, the code length of the mask corresponding to the reference signal can be indicated to the terminal device, to ensure that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency. In addition, this helps reduce complexity of implementing DMRS orthogonality by the terminal device, and save frequency domain resources. In addition, this can better satisfy orthogonality between the ports allocated to the terminal device, and help the terminal device reduce, through precoding, orthogonality damage caused by a non-ideal factor.

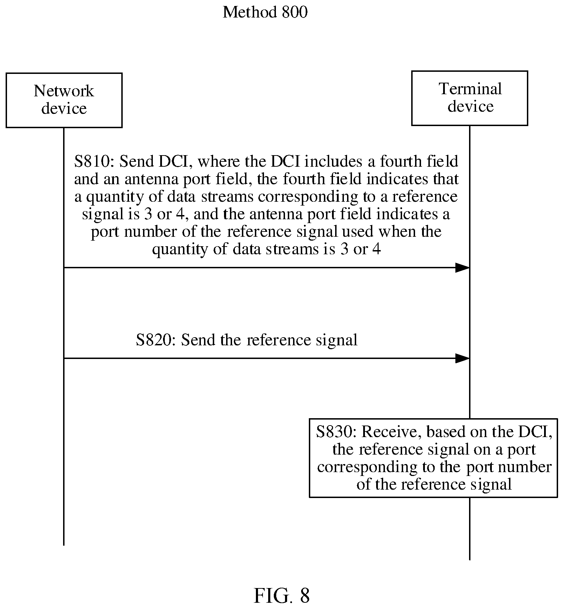

FIG. 8 is a schematic interaction diagram of a signal transmission method 800 according to another embodiment of this application. The method 800 may be used in the scenario shown in FIG. 5, and certainly may also be used in another communication scenario. This is not limited in embodiments of this application.

As shown in FIG. 8, the method 800 shown in FIG. 8 may include S810 to S830. The following describes steps in the method 800 in detail with reference to FIG. 8.

S810: A network device sends DCI to a terminal device, where the DCI includes a fourth field and an antenna port field, the fourth field is used to determine that a quantity of data streams corresponding to a reference signal is 3 or 4, and the antenna port field is used to determine a port number of the reference signal when the quantity of data streams is 3 or 4.

In a possible implementation, the reference signal indicated by the fourth field may be a DMRS (downlink DMRS).

In a possible implementation, the fourth field may alternatively not be included in the DCI. For example, RRC, a MAC CE, or RLC signaling sent by the network device to the terminal device may include the fourth field.

It should be understood that, in another implementation of this application, the reference signal indicated by the fourth field may alternatively be another reference signal, for example, including an uplink DMRS, an SRS, a PTRS, a CSI-RS, or the like. This is not limited herein in this embodiment of this application. In the following examples, the DMRS (downlink DMRS) is used as an example for description.

In this embodiment of this application, the quantity of data streams corresponding to the reference signal is a quantity of ports of the reference signal, a quantity of streams of a data channel of the reference signal, or a quantity of layers of the data channel of the reference signal.

The fourth field is used to determine that the quantity of data streams corresponding to the DMRS is 3 or 4. The antenna port field in the DCI is used to determine the three or four port numbers of the DMRS when the quantity of data streams is 3 or 4 (or the quantity of DMRS ports is 3 or 4).

In some implementations, the antenna port field in the DCI further indicates, to the terminal device, a physical resource corresponding to the three or four DMRS ports, and the like. The physical resource may be one or more groups of time-domain and/or frequency-domain resources. In addition, the terminal device does not perform data transmission on the physical resource. For example, the physical resource may be a quantity of CDM groups. For another example, the physical resource is one or more CDM groups. For example, an antenna port indication table corresponding to the antenna port field may be any one of the foregoing antenna port indication tables.

When the fourth field indicates that the quantity of data streams corresponding to the DMRS is 3 or 4, the antenna port field needs to indicate numbers of only the three or four DMRS ports and a quantity of corresponding CDM groups. In this way, a length of the antenna port field can be reduced, and communication resources can be saved.

For example, with reference to the example shown in Table 6, when the quantity of data streams is 3 or 4 (or the quantity of DMRS ports is 3 or 4), for a single-symbol type-1 DMRS, there are only two possibilities for indicating the antenna ports: The DMRS ports are 0 to 3 and 0 to 2. Therefore, the antenna port field needs only 1 bit to indicate the two cases in which the DMRS ports are 0 to 3 and 0 to 2. Based on Table 6, when the antenna port field needs to indicate at least 11 different cases, the antenna port field needs at least 4 bits to indicate the 11 different cases. Therefore, overheads of the antenna port field can be significantly reduced.

For another example, with reference to the example shown in Table 7, when the quantity of data streams is 3 or 4 (or the quantity of DMRS ports is 3 or 4), for a double-symbol type-1 DMRS, there are seven possibilities for indicating the antenna ports. Therefore, the antenna port field needs only 3 bits to indicate the seven different cases. Based on Table 7, when the antenna port field needs to indicate at least 30 different cases, the antenna port field needs at least 5 bits to indicate the 30 different cases. Therefore, overheads of the antenna port field can be significantly reduced.

For another example, with reference to the example shown in Table 8, when the quantity of data streams is 3 or 4 (or the quantity of DMRS ports is 3 or 4), for a single-symbol type-2 DMRS, there are five possibilities for indicating the antenna ports. Therefore, the antenna port field needs only 3 bits to indicate the five different cases. Based on Table 8, when the antenna port field needs to indicate at least 23 different cases, the antenna port field needs at least 5 bits to indicate the 23 different cases. Therefore, overheads of the antenna port field can be significantly reduced.

For another example, with reference to the example shown in Table 9, when the quantity of data streams is 3 or 4 (or the quantity of DMRS ports is 3 or 4), for a double-symbol type-2 DMRS, there are 11 possibilities for indicating the antenna ports. Therefore, the antenna port field needs only 4 bits to indicate the 11 different cases. Based on Table 9, when the antenna port field needs to indicate at least 57 different cases, the antenna port field needs at least 6 bits to indicate the 57 different cases. Therefore, overheads of the antenna port field can be significantly reduced.

S820: The network device sends the reference signal to the terminal device.

It should be understood that, in this embodiment of this application, the network device may send the reference signal to the terminal device on all or a part of the reference signal resource. Further, the network device may send the reference signal on the reference signal resource through a reference signal port.

For example, if the reference signal is the DMRS, the network device may send the reference signal to the terminal device on all or some of the three or four resources of the DMRS through the three or four DMRS ports.

S830: After receiving the DCI, the terminal device receives, based on the DCI, the reference signal on the port corresponding to the port number of the reference signal.

In a possible implementation, the terminal device may determine a value (value) of the antenna port field based on the antenna port field in the DCI sent by the network device, to determine the DMRS port number and the physical resource corresponding to the DMRS port that are indicated by the field. The physical resource may be the quantity of CDM groups. In this way, the DMRS is received on the physical resource corresponding to the DMRS port through the DMRS port.

Based on the signal transmission method provided in this application, the fourth field indicates that the quantity of data streams corresponding to the reference signal is 3 or 4, and the antenna port field indicates the port number of the reference signal when the quantity of data streams is 3 or 4. In this way, overheads of the antenna port field can be reduced, and utilization of communication resources can be improved.

For example, the reference signal may be a downlink DMRS or an uplink DMRS. If the reference signal is the downlink DMRS, the terminal device receives the reference signal. If the reference signal is the uplink DMRS, the terminal device sends the reference signal.

Optionally, in some implementations, the fourth field is further used to determine a code length of a first mask, the code length of the first mask is included in a first value set, and the first value set includes one or more of the following values: 2, 3, 4, 6, and 8.

In some possible implementations, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

In some implementations, the code length of the first mask may be any one of 2, 3, 4, 6, and 8.

The first value set is a value set including one or more integers. For example, if the first value set is {2, 4}, a candidate value of the code length of the first mask may be 2 or 4. The first information indicates that the code length of the first mask is a value in the first value set.

For example, different bit states of a bit of the fourth field may indicate different code lengths and quantities of data streams.

For example, if the code length of the first mask is any one of 2, 3, 4, 6, and 8, the different bit states of the bit of the fourth field indicate the different code lengths, and the quantity of data streams corresponding to the reference signal is 3 or 4.

In this case, a length of the fourth field may be 2 bits. For example, a correspondence between the bit state of the fourth field, a code length of the FD-OCC, and the quantity of data streams may be shown in Table 32.

**Table 32**

| Bit state of the fourth field | Length of the FD-OCC | Quantity of data streams |
|---|---|---|
| 00 | 2 | 3 |
| 01 | 2 | 3 |
| 10 | 4 | 4 |
| 11 | 4 | 4 |

For example, assuming that the bit state of the fourth field in the DCI sent by the network device is "10", the terminal device may determine that the length of the FD-OCC corresponding to the reference signal is 4, and the quantity of DMRS ports is 4. Further, the terminal device may determine four DMRS port numbers and corresponding physical resources (CDM group) based on the value (value) of the antenna port field, to receive the DMRS on the physical resources corresponding to four different DMRS ports.

Based on the signal transmission method provided in this application, the fourth field indicates that the quantity of data streams corresponding to the reference signal is 3 or 4, and the antenna port field indicates the port number of the reference signal when the quantity of data streams is 3 or 4. In this way, overheads of the antenna port field can be reduced, and utilization of communication resources can be improved. In addition, the code length of the mask corresponding to the reference signal can further be indicated to the terminal device, to ensure that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency.

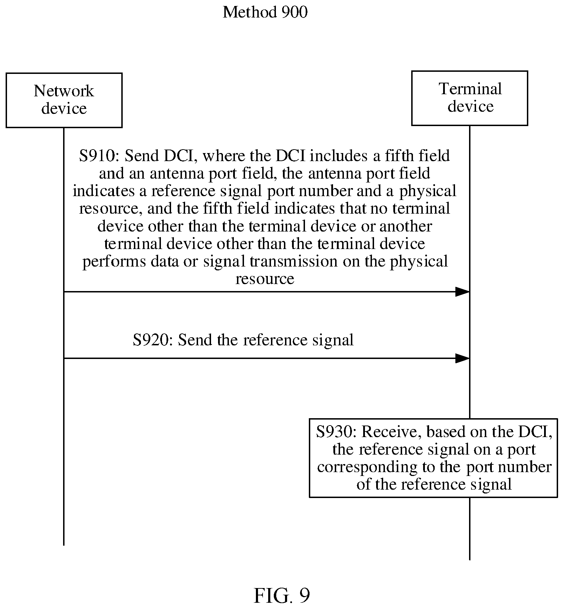

FIG. 9 is a schematic interaction diagram of a signal transmission method 900 according to another embodiment of this application. The method 900 may be used in the scenario shown in FIG. 5, and certainly may also be used in another communication scenario. This is not limited in embodiments of this application.

As shown in FIG. 9, the method 900 shown in FIG. 9 may include S910 to S930. The following describes steps in the method 900 in detail with reference to FIG. 9.

S910: A network device sends DCI to a terminal device, where the DCI includes a fifth field and an antenna port field, the antenna port field indicates a reference signal port number and a physical resource, and the fifth field indicates: No terminal device other than the terminal device or another terminal device other than the terminal device performs data or signal transmission on the physical resource.

In a possible implementation, a reference signal indicated by the fifth field may be a DMRS (downlink DMRS).

In a possible implementation, the fifth field may alternatively not be included in the DCI. For example, RRC, a MAC CE, or RLC signaling sent by the network device to the terminal device may include the fifth field.

The antenna port field in the DCI indicates the DMRS port number and the physical resource to the terminal device. The physical resource may be one or more groups of time-domain and/or frequency-domain resources. In addition, the terminal device does not perform data transmission on the physical resource. For example, the physical resource may be a quantity of CDM groups. For another example, the physical resource is one or more CDM groups. For example, an antenna port indication table corresponding to the antenna port field may be any one of the foregoing antenna port indication tables.

For example, the fifth field may include a first bit state and/or a second bit state. The first bit state indicates that no terminal device other than the terminal device performs data or signal transmission on the physical resource. The second bit state indicates that the another terminal device other than the terminal device performs data or signal transmission on the physical resource. It may be understood that, that the terminal device receives the reference signal on the physical resource means that the terminal device receives the reference signal on all of the physical resource, or the terminal device receives the reference signal on a part of the physical resource.

In this embodiment, the fifth field may indicate that no terminal device other than the terminal device or the another terminal device other than the terminal device performs data or signal transmission on the physical resource, or a paired user or no paired user exists on the physical resource. That another terminal device other than the terminal device performs data or signal transmission on the physical resource may be understood as that the another terminal device sends a reference signal on a physical resource other than a physical resource occupied by the DMRS port of the terminal device. That no terminal device other than the terminal device performs data or signal transmission on the physical resource may be understood as that no another terminal device sends a reference signal on a physical resource other than a physical resource occupied by the DMRS port of the terminal device. Based on the indication, the terminal device can determine whether the another terminal device sends the reference signal on the physical resource other than the physical resource occupied by the DMRS port, to determine a quantity of orthogonal DMRS ports that currently need to be distinguished, and use a more proper filter to obtain a better channel estimation effect.

S920: The network device sends the reference signal to the terminal device.

It should be understood that, in this embodiment of this application, the network device may send the reference signal to the terminal device on all or a part of a reference signal resource. Further, the network device may send the reference signal on the reference signal resource through a reference signal port.

For example, if the reference signal is the DMRS, the network device may send the reference signal to the terminal device on all or a part of the resource of the DMRS through the DMRS port.

S930: After receiving the DCI, the terminal device receives, based on the DCI, the reference signal on the port corresponding to the port number of the reference signal.

For example, the reference signal may be a downlink DMRS or an uplink DMRS. If the reference signal is the downlink DMRS, the terminal device receives the reference signal. If the reference signal is the uplink DMRS, the terminal device sends the reference signal.

In a possible implementation, the terminal device may determine a value (value) of the antenna port field based on the antenna port field in the DCI sent by the network device, to determine the DMRS port number and the physical resource corresponding to the DMRS port that are indicated by the field. The physical resource may be the quantity of CDM groups. In this way, the DMRS is received on the physical resource corresponding to the DMRS port through the DMRS port. Further, it is determined, based on the fifth field, that the another terminal device other the terminal device or no terminal device other than the terminal device performs data or signal transmission on the physical resource, so that the terminal device can determine the quantity of orthogonal DMRS ports that currently need to be distinguished, to use the more proper filter to obtain the better channel estimation effect.

Optionally, in some implementations, the fifth field is further used to determine a code length of a first mask, the code length of the first mask is included in a first value set, and the first value set includes one or more of the following values: 2, 3, 4, 6, and 8.

In some possible implementations, the first mask may be an orthogonal code or a non-orthogonal code. For example, the first mask may be a time domain and/or frequency domain mask. For example, the first mask is a TD-OCC, or the first mask is an FD-OCC, or the first mask is a superposition of the TD-OCC and the FD-OCC. The code length of the first mask may be a code length of the orthogonal code or a code length of the non-orthogonal code.

In some implementations, the code length of the first mask may be any one of 2, 3, 4, 6, and 8.

The first value set is a value set including one or more integers. For example, if the first value set is {2, 4}, a candidate value of the code length of the first mask may be 2 or 4. The first information indicates that the code length of the first mask is a value in the first value set.

For example, if the code length of the first mask is any one of 2, 3, 4, 6, and 8, different bit states of a bit of the fifth field indicate different code lengths and whether the paired user exists on the physical resource.

In some implementations, the code length of the first mask may be 2 or 4. In this case, a length of the fifth field may be 2 bits. For example, a correspondence between the bit state of the fifth field, a code length of the FD-OCC, and whether the paired user exists on the physical resource may be shown in Table 33.

**Table 33**

| Bit state of the fifth field | Length of the FD-OCC | Whether the paired user exists |
|---|---|---|
| 00 | 2 | Yes |
| 01 | 2 | Yes |
| 10 | 4 | No |
| 11 | 4 | No |

For example, assuming that the bit state of the fifth field in the DCI sent by the network device is "10", the terminal device may determine that the length of the FD-OCC corresponding to the reference signal is 4, and no paired user exists on the physical resource indicated by the antenna port field. Further, the terminal device may determine the DMRS port number and the corresponding physical resource (a CDM group) based on the value (value) of the antenna port field, to receive the DMRS on the physical resource corresponding to the DMRS port.

Based on the signal transmission method provided in this application, the fifth field indicates whether the paired user exists on the physical resource indicated by the antenna port field, so that the terminal device can determine the quantity of orthogonal reference signal ports that currently need to be distinguished, to use the more appropriate filter to obtain the better channel estimation effect. In addition, the code length of the mask corresponding to the reference signal can further be indicated to the terminal device, to ensure that the terminal device is definite about the length of the mask used for the reference signal, so that the terminal device can use a proper hardware implementation method (for example, a reference signal decoding or filtering method), to obtain a better demodulation effect when different reference signal ports are multiplexed, and improve reference signal transmission efficiency.

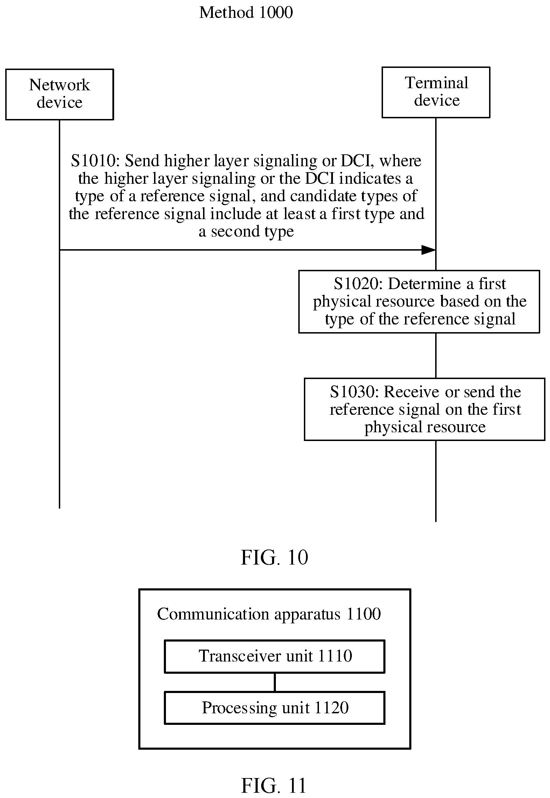

FIG. 10 is a schematic interaction diagram of a signal transmission method 1000 according to another embodiment of this application. The method 1000 may be used in the scenario shown in FIG. 5, and certainly may also be used in another communication scenario. This is not limited in embodiments of this application.

As shown in FIG. 10, the method 1000 shown in FIG. 10 may include S1010 to S1030. The following describes steps in the method 1000 in detail with reference to FIG. 10.

S1010: A network device sends higher layer signaling or DCI to a terminal device, where the higher layer signaling or the DCI indicates a type of a reference signal, and candidate types of the reference signal include at least a first type and a second type.

On a same physical resource, the first type and the second type correspond to a same reference signal sequence value.

For example, the reference signal may be a DMRS.

S1020: The terminal device determines a first physical resource based on the type of the reference signal.

That the terminal device determines a first physical resource based on the type of the reference signal may be understood as: determining, based on the type of the reference signal, a subcarrier for transmission of the reference signal. On a subcarrier, values of the first-type reference signal sequence and the second-type reference signal sequence are the same.

S1030: The terminal device receives or sends the reference signal on the first physical resource.

In a possible implementation, the first-type reference signal may be an enhanced DMRS. In frequency domain, a DMRS sequence is mapped to one subcarrier at an interval of three subcarriers (or the DMRS sequence is mapped to one of every four subcarriers), namely, comb-4 DMRS mapping. The second-type reference signal may be a type-1 DMRS. The type of the reference signal is the second type, a mapping relationship between the DMRS sequence and the subcarrier is determined based on Formula 2 and type-1, and the DMRS is transmitted on one subcarrier at an interval of one subcarrier. The type of the reference signal is the first type, a mapping relationship between the DMRS sequence and the subcarrier is determined based on Formula 2 and type-1, and the DMRS is transmitted on one subcarrier at an interval of three subcarriers.

In a possible implementation, both the first type and the second type are type-1 DMRSs, and a maximum quantity of DMRS ports supported by the first type is greater than a quantity of DMRS ports supported by the second type.

For example, for the first-type reference signal, a mapping relationship between a first-type DMRS sequence and the subcarrier may be determined based on Formula 2 and the mapping relationship between the type-1 DMRS sequence and the subcarrier. Port mapping parameters of a first-type downlink DMRS may be shown in Table 34. In Table 34, $p$ represents a downlink DMRS port number.

**Table 34: Port mapping parameters of the first-type downlink DMRS**

| $p$ | $w_f(k')$ | | $w_t(l')$ | |
|---|---|---|---|---|
| | $k'=0$ | $k'=1$ | $l'=0$ | $l'=1$ |
| 1008 | +1 | +1 | +1 | +1 |
| 1009 | +1 | -1 | +1 | +1 |
| 1010 | +1 | +1 | +1 | +1 |
| 1011 | +1 | -1 | +1 | +1 |
| 1012 | +1 | +1 | +1 | -1 |
| 1013 | +1 | -1 | +1 | -1 |
| 1014 | +1 | +1 | +1 | -1 |
| 1015 | +1 | -1 | +1 | -1 |

It should be understood that the foregoing descriptions are merely intended to help a person skilled in the art better understand embodiments of this application, but are not intended to limit the scope of embodiments of this application. It is clear that a person skilled in the art may make various equivalent modifications or changes based on the foregoing examples. For example, some steps in the foregoing method embodiments may be unnecessary, or some steps may be added. Alternatively, any two or more of the foregoing embodiments are combined. A modified, changed, or combined solution also falls within the scope of embodiments of this application.

It should be further understood that each table in the foregoing examples may alternatively include only one or more rows in the corresponding table. To be specific, in embodiments of this application, each antenna port indication table, a table of a mapping relationship between a bit state of each field (for example, the first field, the fourth field, or the fifth field) and a code length of a mask, a table of a mapping relationship between a bit state of each field, a code length of a mask, and an offset value of a port number, or a table of a mapping relationship between a bit state of each field, a code length of a mask, and a value set to which a port number of a DMRS belongs may alternatively include a part of rows (for example, one or more rows) instead of all rows in the corresponding table.

It should be further understood that division of manners, cases, categories, and embodiments in embodiments of this application is merely intended for ease of description, and should not constitute a particular limitation. The features in the manners, categories, cases, and embodiments may be combined without contradiction.

It should be further understood that various numbers used in embodiments of this application are merely distinguished for ease of description, but are not intended to limit the scope of embodiments of this application. The sequence numbers of the foregoing processes do not mean execution sequences. The execution sequences of the processes should be determined based on functions and internal logic of the processes, and should not constitute any limitation on implementation processes of embodiments of this application.

It should be further understood that the foregoing descriptions of embodiments of this application emphasize differences between the embodiments. For same or similar parts that are not mentioned, refer to these embodiments. For brevity, details are not described herein again.

It should be further understood that in embodiments of this application, "predefine" or "preset" may be implemented by pre-storing corresponding code, a table, or another manner for indicating related information in a device. A specific implementation thereof is not limited in this application.

The foregoing describes in detail the signal transmission method in embodiments of this application with reference to FIG. 1 to FIG. 10. The following describes in detail the communication apparatuses in embodiments of this application with reference to FIG. 11 to FIG. 16.

In this embodiment, a terminal device and a network device may be divided into functional modules based on the foregoing method. For example, each functional module may be obtained through division based on each corresponding function, or two or more functions may be integrated into one processing module. The integrated module may be implemented in a form of hardware. It should be noted that the module division in this embodiment is an example and is merely logical function division. During actual implementation, there may be another division manner.

It should be noted that related content of the steps in the foregoing method embodiments may be referenced to function descriptions of corresponding functional modules, and details are not described herein again.

The terminal device and the network device provided in embodiments of this application are configured to perform any signal transmission method provided in the foregoing method embodiments. Therefore, effects that are the same as those of the foregoing implementation method can be achieved. When an integrated unit is used, the terminal device or the network device may include a processing module, a storage module, and a communication module. The processing module may be configured to control and manage an action of the terminal device or the network device. For example, the processing unit may be configured to support the terminal device or the network device in performing a step performed by the processing unit. The storage module may be configured to support storage of program code, data, and the like. The communication module may be configured to support the terminal device or the network device in communicating with another device.

The processing module may be a processor or a controller. The processor may implement or execute various example logical blocks, modules, and circuits described with reference to content disclosed in this application. The processor may alternatively be a combination implementing a computing function, for example, including a combination of one or more microprocessors, or a combination of a digital signal processor (digital signal processor, DSP) and a microprocessor. The storage module may be a memory. The communication module may be specifically a device that interacts with another electronic device, for example, a radio frequency circuit, a Bluetooth chip, or a Wi-Fi chip.

For example, FIG. 11 is a schematic block diagram of a communication apparatus 1100 according to an embodiment of this application. The communication apparatus 1100 may correspond to the terminal device described in the method 600 to the method 1000, or may be a chip or a component used in the terminal device. In addition, modules or units in the communication apparatus 1000 are separately configured to perform actions or processing processes performed by the terminal device in any one of the method 600 to the method 1000.

As shown in FIG. 11, the communication apparatus 1100 includes a transceiver unit 1110 and a processing unit 1120. The transceiver unit 1110 is configured to send or receive a specific signal under driving of the processing unit 1120.

In some embodiments:

The transceiver unit 1110 is configured to receive first information. The first information includes a first field, the first field is used to determine a code length of a first mask, the code length of the first mask is included in a first value set, and the first value set includes one or more of the following values: 2, 3, 4, 6, and 8.

The processing unit 1120 is configured to determine a reference signal based on the first mask.

The transceiver unit 1110 is further configured to receive the reference signal.

For example, the reference signal may be a DMRS, and the first mask may be an orthogonal code or a non-orthogonal code. For example, the first mask may be a time domain and/or frequency domain mask. For example, the first mask is a TD-OCC, or the first mask is an FD-OCC.

The communication apparatus provided in this application receives the first information indicating the code length of the mask corresponding to the reference signal, to ensure that the communication apparatus is definite about the length of the mask used for the reference signal when supporting masks with different code lengths, so that a receive device may use a proper hardware implementation method (for example, a reference signal decoding or filtering method), to obtain a better demodulation effect when different reference signal ports are multiplexed, and improve reference signal transmission efficiency.

In some implementations, the code length of the first mask is any one of 2, 3, 4, 6, and 8.

For example, if the code length of the first mask is any one of 2, 3, 4, 6, and 8, the first field needs at least 3 bits, and different bit states of the first field represent different code lengths, or different decimal values corresponding to the bits of the first field represent different code lengths.

In some implementations, if the first value set may be {2, 4}, the code length of the first mask may be 2 or 4.

In some possible implementations, the first field is further used to determine a reference signal port number; or the first information further includes a second field, and the second field is used to determine a reference signal port number.

The processing unit 1120 is further configured to determine the reference signal port number based on the first field or the second field. In this implementation, the network device does not need to use additional signaling to indicate an offset value of a port number of the reference signal, so that the communication apparatus can be definite about the length of the mask used for the reference signal, to use a proper hardware implementation method (for example, a reference signal decoding or filtering method), so as to obtain a better demodulation effect when different reference signal ports are multiplexed, and improve reference signal transmission efficiency. In addition, dynamic signaling is saved, and utilization of communication resources is improved.

In some possible implementations, the first field or the second field indicates an offset value of the reference signal port number, where the offset value belongs to a second value set, and the second value set includes one or more of the following values: 0, 4, 6, 8, and 12; or a value set to which a port number of the reference signal belongs.

In some possible implementations, offset values of reference signal port numbers corresponding to at least two bit states in a bit status of the first field are the same; or port numbers of reference signals corresponding to at least two bit states in a bit status of the first field belong to a same value set.

In some possible implementations, the bit status of the first field includes at least one of the following bit states: a first bit state, indicating that the code length of the first mask is a first code length, and the offset value of the reference signal port number is a first offset value; a second bit state, indicating that the code length of the first mask is a second code length, and the offset value of the reference signal port number is a first offset value; or a third bit state, indicating that the code length of the first mask is a second code length, and the offset value of the reference signal port number is a second offset value.

In some possible implementations, the bit status of the first field includes at least one of the following bit states: a first bit state, indicating that the code length of the first mask is a first code length, and the port number of the reference signal belongs to a third value set; a second bit state, indicating that the code length of the first mask is a second code length, and the port number of the reference signal belongs to a third value set; or a third bit state, indicating that the code length of the first mask is a second code length, and the port number of the reference signal belongs to a fourth value set.

In some possible implementations, the third value set and the fourth value set satisfy at least one of the following: A quantity of number values included in the third value set is the same as a quantity of number values included in the fourth value set.

A number value in the fourth value set is determined based on a number value in the third value set and a first value, where the first value belongs to a fifth value set.

A configuration type of a reference signal corresponding to the third value set is the same as a configuration type of a reference signal corresponding to the fourth value set.

In some possible implementations, the fifth value set includes one or more of the following values: 4, 8, 6, and 12.

In some possible implementations, when the configuration type of the reference signal is a first configuration type, the fifth value set includes 8; or when the configuration type of the reference signal is a second configuration type, the fifth value set includes 12.

In some possible implementations, the first information further includes an antenna port field, and the antenna port field indicates a first physical resource. The bit status of the first field further includes a fourth bit state. The fourth bit state indicates: No terminal device other than the communication apparatus performs data or signal transmission on the first physical resource.

In some possible implementations, at least one of the first bit state, the second bit state, or the third bit state further indicates: Another terminal device other than the communication apparatus performs data or signal transmission on the first physical resource.

In some possible implementations, the bit status of the first field further includes a fifth bit state, and the fifth bit state indicates: A quantity of data streams corresponding to the reference signal is 3 or 4, and the code length of the first mask is the first code length or the second code length.

In some possible implementations, at least one of the first bit state, the second bit state, and the third bit state further indicates: A quantity of data streams corresponding to the reference signal is 1 or 2.

In some possible implementations, the first information further includes an antenna port field. When the bit status of the first field is the fifth bit state, a length of the antenna port field is m; or when the bit status of the first field is the first bit state, the second bit state, or the third bit state, a length of the antenna port field is n, where m and n are positive integers, and m is less than n.

In some possible implementations, the first information further indicates a first physical resource, and a bit status of the first field further includes a sixth bit state and/or a seventh bit state. The sixth bit state indicates that the code length of the first mask is a first code length or a second code length, and no terminal device other than the communication apparatus performs data or signal transmission on the first physical resource. The seventh bit state indicates that the code length of the first mask is the first code length or the second code length, and another terminal device other than the communication apparatus performs data or signal transmission on the first physical resource.

In some possible implementations, a bit status of the first field further includes an eighth bit state and/or a ninth bit state. The eighth bit state indicates that a quantity of data streams corresponding to the reference signal is 3, and the code length of the first mask is a second code length. The ninth bit state indicates that the quantity of data streams corresponding to the reference signal is 4, and the code length of the first mask is the second code length.

In some possible implementations, the bit status of the first field further includes a tenth bit state and/or an eleventh bit state. The tenth bit state indicates that the code length of the first mask is the first code length, a quantity of ports of the reference signal is 3 or 4, and time and/or frequency positions of reference signal resources corresponding to the ports of the reference signal are different. The eleventh bit state indicates that the code length of the first mask is the second code length, a quantity of ports of the reference signal is 3 or 4, and time and frequency positions of reference signal resources corresponding to the ports of the reference signal are the same.

In some possible implementations, the bit status of the first field further includes a twelfth bit state and/or a thirteenth bit state. The twelfth bit state indicates that the code length of the first mask is the first code length, a quantity of ports of the reference signal greater than 4, and time and/or frequency positions of reference signal resources corresponding to the ports of the reference signal are different. The thirteenth bit state indicates that the code length of the first mask is the second code length, the quantity of ports of the reference signal is greater than 4, and the time and frequency positions of the reference signal resources corresponding to the ports of the reference signal are the same.

Further, the communication apparatus 1100 may further include a storage unit. The transceiver unit 1110 may be a transceiver, an input/output interface, or an interface circuit. The storage unit is configured to store instructions executed by the transceiver unit 1110 and the processing unit 1120. The transceiver unit 1110, the processing unit 1120, and the storage unit are coupled to each other. The storage unit stores the instructions. The processing unit 1120 is configured to execute the instructions stored in the storage unit. The transceiver unit 1110 is configured to send or receive the specific signal under driving of the processing unit 1120.

It should be understood that for a specific process in which the units in the communication apparatus 1100 perform the foregoing corresponding steps, refer to the foregoing descriptions related to the terminal device with reference to the method 600 to the method 1000 and the related embodiments in FIG. 6 to FIG. 10. For brevity, details are not described herein again.

Optionally, the transceiver unit 1110 may include a receiving unit (module) and a sending unit (module), configured to perform the steps of receiving information and sending information by the terminal device in the embodiments of the method 600 to the method 1000.

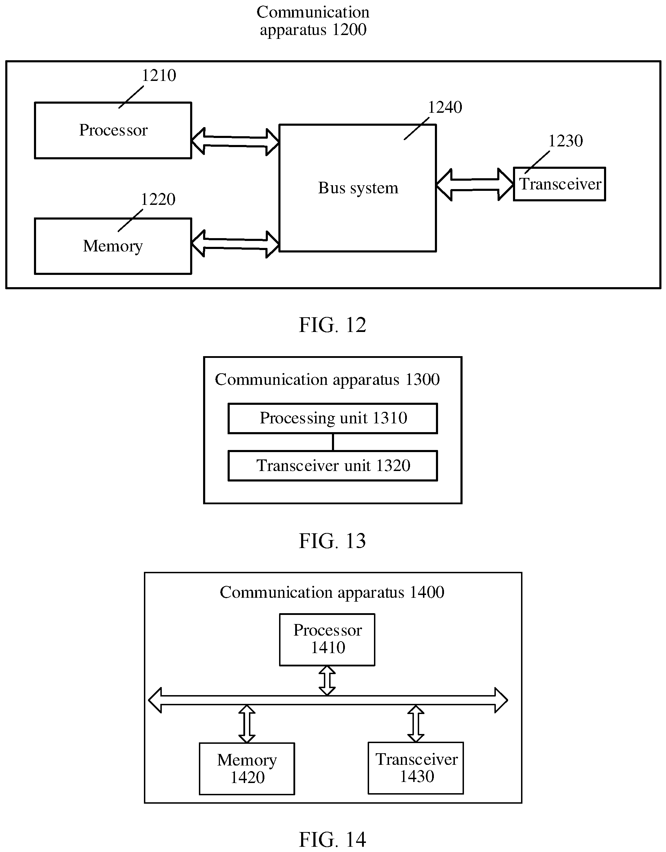

It should be understood that the transceiver unit 1110 may be the transceiver, the input/output interface, or the interface circuit. The storage unit may be a memory. The processing unit 1120 may be implemented by a processor. As shown in FIG. 12, a communication apparatus 1200 may include a processor 1210, a memory 1220, a transceiver 1230, and a bus system 1240. Components of the communication apparatus 1200 are coupled together through the bus system 1240. In addition to a data bus, the bus system 1240 may further include a power bus, a control bus, a status signal bus, and the like. However, for clarity of description, various buses are marked as the bus system 1240 in FIG. 12. For ease of illustration, FIG. 12 merely shows only an example of the bus system 1204.

The communication apparatus 1100 shown in FIG. 11 or the communication apparatus 1200 shown in FIG. 12 can implement the steps performed by the terminal device in the embodiments of the method 600 to the method 1000. For similar descriptions, refer to the descriptions in the foregoing corresponding methods. To avoid repetition, details are not described herein again.

The communication apparatus 1100 shown in FIG. 11 or the communication apparatus 1200 shown in FIG. 12 may be a terminal device.

FIG. 13 is a schematic block diagram of a communication apparatus 1300 according to an embodiment of this application. The communication apparatus 1300 may correspond to the network device described in the method 600 to the method 1000, or may be a chip or a component used in the network device. In addition, modules or units in the communication apparatus 1300 are separately configured to perform actions or processing processes performed by the network device in any one of the method 600 to the method 1000.

As shown in FIG. 13, the communication apparatus 1300 may include a processing unit 1310 and a transceiver unit 1320. The transceiver unit 1320 is configured to send or receive a specific signal under driving of the processing unit 1310.

In some embodiments:

The transceiver unit 1320 is configured to send first information. The first information includes a first field, the first field is used to determine a code length of a first mask, the code length of the first mask is included in a first value set, and the first value set includes one or more of the following values: 2, 3, 4, 6, and 8.

The processing unit 1310 is configured to determine a reference signal based on the first mask.

The transceiver unit 1320 is further configured to send the reference signal.

The communication apparatus provided in this application indicates, to a receive device, the code length of the mask corresponding to the reference signal, to ensure that the receive device is definite about the length of the mask used for the reference signal when supporting masks with different code lengths, so that the receive device can use a proper hardware implementation method (for example, the reference signal decoding or filtering method), to obtain a better demodulation effect when different reference signal ports are multiplexed, and improve reference signal transmission efficiency.

For example, the reference signal may be a DMRS, and the first mask may be an orthogonal code or a non-orthogonal code. For example, the first mask may be a time domain and/or frequency domain mask. For example, the first mask is a TD-OCC, or the first mask is an FD-OCC.

In some implementations, the code length of the first mask is any one of 2, 3, 4, 6, and 8.

For example, if the code length of the first mask is any one of 2, 3, 4, 6, and 8, the first field needs at least 3 bits, and different bit states of the first field represent different code lengths, or different decimal values corresponding to the bits of the first field represent different code lengths.

In some implementations, if the first value set may be {2, 4}, the code length of the first mask may be 2 or 4.

In some possible implementations, the first field is further used to determine a reference signal port number; or the first information further includes a second field, and the second field is used to determine a reference signal port number.

The processing unit 1310 is further configured to determine the reference signal port number based on the first field or the second field. In this implementation, the communication apparatus does not need to use additional signaling to indicate an offset value of a port number of the reference signal, so that the receive device can be definite about the length of the mask used for the reference signal, to use a proper hardware implementation method (for example, a reference signal decoding or filtering method), so as to obtain a better demodulation effect when different reference signal ports are multiplexed, and improve reference signal transmission efficiency. In addition, dynamic signaling is saved, and utilization of communication resources is improved.

In some possible implementations, the first field or the second field indicates an offset value of the reference signal port number, where the offset value belongs to a second value set, and the second value set includes one or more of the following values: 0, 4, 6, 8, and 12; or a value set to which a port number of the reference signal belongs.

In some possible implementations, offset values of reference signal port numbers corresponding to at least two bit states in a bit status of the first field are the same; or port numbers of reference signals corresponding to at least two bit states in a bit status of the first field belong to a same value set.

In some possible implementations, the bit status of the first field includes at least one of the following bit states: a first bit state, indicating that the code length of the first mask is a first code length, and the offset value of the reference signal port number is a first offset value; a second bit state, indicating that the code length of the first mask is a second code length, and the offset value of the reference signal port number is a first offset value; or a third bit state, indicating that the code length of the first mask is a second code length, and the offset value of the reference signal port number is a second offset value.

In some possible implementations, the bit status of the first field includes at least one of the following bit states: a first bit state, indicating that the code length of the first mask is a first code length, and the port number of the reference signal belongs to a third value set; a second bit state, indicating that the code length of the first mask is a second code length, and the port number of the reference signal belongs to a third value set; or a third bit state, indicating that the code length of the first mask is a second code length, and the port number of the reference signal belongs to a fourth value set.

In some possible implementations, the third value set and the fourth value set satisfy at least one of the following: A quantity of number values included in the third value set is the same as a quantity of number values included in the fourth value set.

A number value in the fourth value set is determined based on a number value in the third value set and a first value, where the first value belongs to a fifth value set.

A configuration type of a reference signal corresponding to the third value set is the same as a configuration type of a reference signal corresponding to the fourth value set.

In some possible implementations, the fifth value set includes one or more of the following values: 4, 8, 6, and 12.

In some possible implementations, when the configuration type of the reference signal is a first configuration type, the fifth value set includes 8; or when the configuration type of the reference signal is a second configuration type, the fifth value set includes 12.

In some possible implementations, the first information further includes an antenna port field, and the antenna port field indicates a first physical resource. The bit status of the first field further includes a fourth bit state. The fourth bit state indicates: No terminal device other than the terminal device performs data or signal transmission on the first physical resource.

In some possible implementations, at least one of the first bit state, the second bit state, or the third bit state further indicates: Another terminal device other than the terminal device performs data or signal transmission on the first physical resource.

In some possible implementations, the bit status of the first field further includes a fifth bit state, and the fifth bit state indicates: A quantity of data streams corresponding to the reference signal is 3 or 4, and the code length of the first mask is the first code length or the second code length.

In some possible implementations, at least one of the first bit state, the second bit state, and the third bit state further indicates: A quantity of data streams corresponding to the reference signal is 1 or 2.

In some possible implementations, the first information further includes an antenna port field. When the bit status of the first field is the fifth bit state, a length of the antenna port field is m; or when the bit status of the first field is the first bit state, the second bit state, or the third bit state, a length of the antenna port field is n, where m and n are positive integers, and m is less than n.

In some possible implementations, the first information further indicates a first physical resource, and a bit status of the first field further includes a sixth bit state and/or a seventh bit state. The sixth bit state indicates that the code length of the first mask is a first code length or a second code length, and no terminal device other than the terminal device performs data or signal transmission on the first physical resource. The seventh bit state indicates that the code length of the first mask is the first code length or the second code length, and another terminal device other than the terminal device performs data or signal transmission on the first physical resource.

In some possible implementations, a bit status of the first field further includes an eighth bit state and/or a ninth bit state. The eighth bit state indicates that a quantity of data streams corresponding to the reference signal is 3, and the code length of the first mask is a second code length. The ninth bit state indicates that the quantity of data streams corresponding to the reference signal is 4, and the code length of the first mask is the second code length.

In some possible implementations, the bit status of the first field further includes a tenth bit state and/or an eleventh bit state. The tenth bit state indicates that the code length of the first mask is the first code length, a quantity of ports of the reference signal is 3 or 4, and time and/or frequency positions of reference signal resources corresponding to the ports of the reference signal are different. The eleventh bit state indicates that the code length of the first mask is the second code length, a quantity of ports of the reference signal is 3 or 4, and time and frequency positions of reference signal resources corresponding to the ports of the reference signal are the same.

In some possible implementations, the bit status of the first field further includes a twelfth bit state and/or a thirteenth bit state. The twelfth bit state indicates that the code length of the first mask is the first code length, a quantity of ports of the reference signal greater than 4, and time and/or frequency positions of reference signal resources corresponding to the ports of the reference signal are different. The thirteenth bit state indicates that the code length of the first mask is the second code length, the quantity of ports of the reference signal is greater than 4, and the time and frequency positions of the reference signal resources corresponding to the ports of the reference signal are the same.

It should be understood that for a specific process in which the units in the communication apparatus 1300 perform the foregoing corresponding steps, refer to the foregoing descriptions related to the network device with reference to the method 600 to the method 1000 and the related embodiments in FIG. 6 to FIG. 10. For brevity, details are not described herein again.

Optionally, the transceiver unit 1320 may include a receiving unit (module) and a sending unit (module), configured to perform the steps of receiving information and sending information by the network device in the embodiments of the method 600 to the method 1000.

Further, the communication apparatus 1300 may further include a storage unit. The transceiver unit 1320 may be a transceiver, an input/output interface, or an interface circuit. The storage unit is configured to store instructions executed by the transceiver unit 1320 and the processing unit 1310. The transceiver unit 1320, the processing unit 1310, and the storage unit are coupled to each other. The storage unit stores the instructions. The processing unit 1310 is configured to execute the instructions stored in the storage unit. The transceiver unit 1320 is configured to send or receive the specific signal under driving of the processing unit 1310.

It should be understood that the transceiver unit 1320 may be the transceiver, the input/output interface, or the interface circuit. The storage unit may be a memory. The processing unit 1310 may be implemented by a processor. As shown in FIG. 14, a communication apparatus 1400 may include a processor 1410, a memory 1420, and a transceiver 1430.

The communication apparatus 1300 shown in FIG. 13 or the communication apparatus 1400 shown in FIG. 14 can implement the steps performed by the network device in the embodiments of the method 600 to the method 1000. For similar descriptions, refer to the descriptions in the foregoing corresponding methods. To avoid repetition, details are not described herein again.

It should be further understood that the communication apparatus 1300 shown in FIG. 13 or the communication apparatus 1400 shown in FIG. 14 may be the network device.

It should be further understood that division into the units in the apparatus is merely logical function division. During actual implementation, all or some of the units may be integrated into one physical entity, or may be physically separated. In addition, all the units in the apparatus may be implemented in a form of software invoked by a processing element, or may be implemented in a form of hardware; or some units may be implemented in a form of software invoked by a processing element, and some units may be implemented in a form of hardware. For example, each unit may be a separately disposed processing element, or may be integrated into a chip of the apparatus for implementation. In addition, each unit may alternatively be stored in a memory in a form of a program to be invoked by a processing element of the apparatus to perform a function of the unit. The processing element herein may also be referred to as a processor, and may be an integrated circuit having a signal processing capability. In an implementation process, the steps in the foregoing methods or the foregoing units may be implemented by using a hardware integrated logic circuit in a processor element, or may be implemented in the form of software invoked by the processing element.

In an example, the units in any one of the foregoing apparatuses may be configured as one or more integrated circuits implementing the foregoing methods, for example, one or more application-specific integrated circuits (application-specific integrated circuits, ASICs), or one or digital signal processors (digital signal processors, DSPs), or one or more field programmable gate arrays (field programmable gate arrays, FPGAs). Alternatively, at least two of the integrated circuits are combined. For another example, when the unit in the apparatus is implemented in a form of scheduling a program by the processing element, the processing element may be a general-purpose processor, for example, a central processing unit (central processing unit, CPU) or another processor that may invoke the program. For still another example, the units may be integrated and implemented in a form of a system-on-a-chip (system-on-a-chip, SoC).

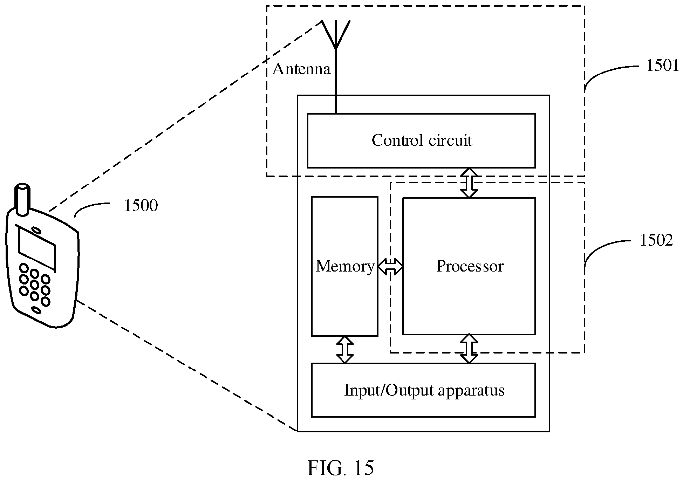

FIG. 15 is a diagram of a structure of a terminal device 1500 according to this application. The communication apparatus 1100 or the communication apparatus 1200 may be configured in the terminal device 1500. Alternatively, the communication apparatus 1000 or the communication apparatus 1100 may be the terminal device 1500. In other words, the terminal device 1500 may perform actions performed by the terminal device in the method 600 to the method 900. Optionally, for ease of description, FIG. 15 shows only main components of the terminal device. As shown in FIG. 15, the terminal device 1500 includes a processor, a memory, a control circuit, an antenna, and an input/output apparatus.

The processor is mainly configured to: process a communication protocol and communication data; control the entire terminal device; execute a software program; and process data of the software program. For example, the processor is configured to support the terminal device in performing an action described in the foregoing method embodiments for data transmission. The memory is mainly configured to store the software program and the data, for example, store the antenna port indication table described in the foregoing embodiments. The control circuit is mainly configured to: convert a baseband signal and a radio frequency signal, and process the radio frequency signal. The control circuit and the antenna together may also be referred to as a transceiver, and are mainly configured to receive or send a radio frequency signal in an electromagnetic wave form. The input/output apparatus, such as a touchscreen, a display, or a keyboard, is mainly configured to: receive data input by a user and output data to the user.

After the terminal device is powered on, the processor may read the software program in the storage unit, interpret and execute instructions of the software program, and process the data of the software program. When data needs to be sent wirelessly, the processor performs baseband processing on the to-be-sent data, and outputs a baseband signal to a radio frequency circuit. The radio frequency circuit performs radio frequency processing on the baseband signal, and sends, through the antenna, a radio frequency signal in an electromagnetic wave form. When data (for example, the foregoing first information) is sent to the terminal device, the radio frequency circuit receives the radio frequency signal through the antenna, converts the radio frequency signal into a baseband signal, and outputs the baseband signal to the processor. The processor converts the baseband signal into data, and processes the data.

A person skilled in the art may understand that for ease of description, FIG. 15 shows only one memory and one processor. In an actual terminal device, there may be a plurality of processors and memories. The memory may also be referred to as a storage medium, a storage device, or the like. This is not limited in embodiments of this application.

For example, the processor may include a baseband processor and a central processing unit. The baseband processor is mainly configured to process a communication protocol and communication data. The central processing unit is mainly configured to: control an entire terminal device, execute a software program, and process data of the software program. Functions of the baseband processor and the central processing unit are integrated into the processor in FIG. 15. A person skilled in the art may understand that the baseband processor and the central processing unit may be independent processors, and are interconnected by using a technology such as a bus. A person skilled in the art may understand that the terminal device may include a plurality of baseband processors to adapt to different network standards, and the terminal device may include a plurality of central processing units to enhance a processing capability of the terminal device, and components of the terminal device may be connected through various buses. The baseband processor may also be expressed as a baseband processing circuit or a baseband processing chip. The central processing unit may also be expressed as a central processing circuit or a central processing chip. A function of processing the communication protocol and the communication data may be built in the processor, or may be stored in the storage unit in a form of a software program, and the processor executes the software program to implement a baseband processing function.

For example, in this embodiment of this application, an antenna having receiving and sending functions and a control circuit may be considered as a transceiver unit 1501 of the terminal device 1500, and a processor having a processing function may be considered as a processing unit 1502 of the terminal device 1500. As shown in FIG. 15, the terminal device 1500 includes the transceiver unit 1501 and the processing unit 1502. The transceiver unit may also be referred to as a transceiver, a transceiver machine, a transceiver apparatus, or the like. Optionally, a component that is in the transceiver unit 1501 and that is configured to implement a receiving function may be considered as a receiving unit, and a component that is in the transceiver unit 1501 and that is configured to implement a sending function may be considered as a sending unit. In other words, the transceiver unit 1501 includes the receiving unit and the sending unit. For example, the receiving unit may also be referred to as a receiver, a receive machine, a receiving circuit, or the like, and the sending unit may also be referred to as a transmitter, a transmit machine, a transmitting circuit, or the like.

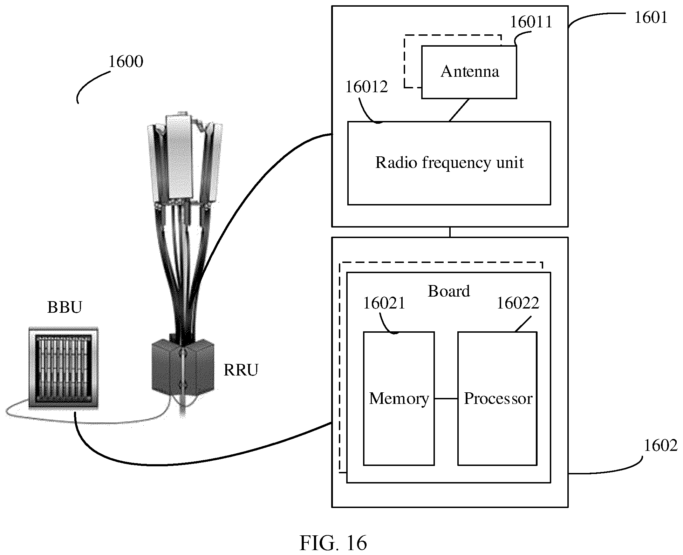

FIG. 16 is a diagram of a structure of a network device 1600 according to an embodiment of this application. The network device 1600 may be configured to implement functions of the network device in the foregoing methods. The network device 1600 includes one or more radio units, such as a remote radio unit (remote radio unit, RRU) 1601, and one or more baseband units (baseband units, BBUs) (which may also be referred to as a digital unit, (digital unit, DU)) 1602. The RRU 1601 may be referred to as a transceiver unit, a transceiver machine, a transceiver circuit, a transceiver, or the like, and may include at least one antenna 16011 and a radio frequency unit 16012. The RRU 1601 is mainly configured to: receive or send a radio frequency signal, and perform conversion between a radio frequency signal and a baseband signal, for example, send a signaling message in the foregoing embodiments to a terminal device. The BBU 1602 is mainly configured to perform baseband processing, control a base station, and the like. The RRU 1601 and the BBU 1602 may be physically disposed together, or may be physically disposed separately, namely, a distributed base station.

The BBU 1602 is a control center of the base station, may also be referred to as a processing unit, and is mainly configured to perform baseband processing functions such as channel coding, multiplexing, modulation, or spreading. For example, the BBU (processing unit) 1602 may be configured to control the base station to perform an operation procedure related to the network device in the foregoing method embodiments.

In an example, the BBU 1602 may include one or more boards. A plurality of boards may jointly support a radio access network (for example, an LTE system or a 5G system) of a single access standard, or may respectively support radio access networks of different access standards. The BBU 1602 further includes a memory 16021 and a processor 16022. The memory 16021 is configured to store instructions and data that are necessary. For example, the memory 16021 stores the antenna port indication table and the like in the foregoing embodiments. The processor 16022 is configured to control the base station to perform a necessary action, for example, configured to control the base station to perform an operation procedure related to the network device in the foregoing method embodiments. The memory 16021 and the processor 16022 may serve one or more boards. In other words, a memory and a processor may be disposed on each board. Alternatively, a plurality of boards may share a same memory and a same processor. In addition, a necessary circuit may further be disposed on each board.

In a possible implementation, with development of a system-on-chip (system-on-chip, SoC) technology, all or some functions of the part 1602 and the part 1601 may be implemented by using the SoC technology, for example, implemented by a base station function chip. The base station function chip integrates components such as a processor, a memory, and an antenna interface. A program of a related function of the base station is stored in the memory, and the processor executes the program to implement the related function of the base station. Optionally, the base station function chip can also read from an external memory of the chip, to implement the related function of the base station.

It should be understood that the structure of the network device shown in FIG. 16 is merely a possible form, but should not constitute any limitation on embodiments of this application. In this application, a possibility that there may be a base station structure in another form in the future is not excluded.

It should be understood that, the processor in this embodiment of this application may be a central processing unit (central processing unit, CPU), or the processor may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor or the like.

It may be understood that the memory in this embodiment of this application may be a volatile memory or a non-volatile memory, or may include the volatile memory and the non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which is used as an external cache. By way of example but not limitative description, many forms of random access memories (random access memories, RAMs) may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

All or some of the foregoing embodiments may be implemented using software, hardware, firmware, or any combination thereof. When the software is used to implement the foregoing embodiments, the embodiments may be implemented completely or partially in a form of a computer program product. The computer program product includes one or more computer instructions or computer programs. When the computer instructions or the computer programs are loaded and executed on a computer, the procedure or function according to embodiments of this application is all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), or a semiconductor medium. The semiconductor medium may be a solid-state drive.

An embodiment of this application further provides a communication system. The communication system includes the foregoing terminal device and the foregoing network device.

An embodiment of this application further provides a computer-readable medium, configured to store computer program code. The computer program includes instructions used to perform the signal transmission method in the method 600 to the method 1000. The readable medium may be a read-only memory (read-only memory, ROM) or a random access memory (random access memory, RAM). This is not limited in embodiments of this application.

This application further provides a computer program product. The computer program product includes instructions. When the instructions are executed, a terminal device is enabled to perform an operation of the terminal device corresponding to the foregoing method, or a network device is enabled to perform an operation of the network device corresponding to the foregoing method.

An embodiment of this application further provides a system chip. The system chip includes a processing unit and a communication unit. The processing unit may be, for example, a processor, and the communication unit may be, for example, an input/output interface, a pin, a circuit, or the like. The processing unit may execute computer instructions, so that the chip in a communication apparatus performs any signal transmission method provided in the foregoing embodiments of this application.

Optionally, any communication apparatus provided in the foregoing embodiments of this application may include the system chip.

Optionally, the computer instructions are stored in a storage unit.

Optionally, the storage unit is a storage unit in the chip, for example, a register or a cache. Alternatively, the storage unit may be a storage unit that is in a terminal and that is located outside the chip, for example, a ROM or another type of static storage device that can store static information and instructions, or a RAM. The processor described above may be a CPU, a microprocessor, an ASIC, or one or more integrated circuits configured to control execution of a program for the foregoing master system information transmission method. The processing unit and the storage unit may be decoupled, are disposed on different physical devices separately, and are connected in a wired or wireless manner, to implement respective functions of the processing unit and the storage unit, to support the system chip in implementing various functions in the foregoing embodiments. Alternatively, the processing unit and the memory may be coupled to a same device.

It may be understood that the memory in embodiments of this application may be a volatile memory or a non-volatile memory, or may include the volatile memory and the non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which is used as an external cache. By way of example but not limitative description, many forms of random access memories (random access memories, RAMs) may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The terms "system" and "network" may be used interchangeably in this specification. The term "and/or" in this specification describes only an association relationship between associated objects and represents that three relationships may exist. For example, A and/or B may represent the following three cases: Only A exists, both A and B exist, and only B exists. In addition, the character "/" in this specification usually represents an "or" relationship between the associated objects.

The terms "uplink" and "downlink" in this application are used to describe data/information transmission directions in a specific scenario. For example, an "uplink" direction is usually a direction in which data/information is transmitted from a terminal to a network side, or a direction in which data/information is transmitted from a distributed unit to a central unit; and a "downlink" direction is usually a direction in which data/information is transmitted from a network side to a terminal, or a direction in which data/information is transmitted from a central unit to a distributed unit. It can be understood that "uplink" and "downlink" are merely used to describe the data/information transmission directions, without limiting specific starting and ending devices of data/information transmission.

In this application, names may be assigned to various objects such as messages/information/devices/network elements/systems/apparatuses/actions/operations/procedures/concepts. It may be understood that the specific names do not constitute a limitation on the related objects. The assigned names may vary with factors such as scenarios, contexts, or usage habits. Understanding of technical meanings of technical terms in this application should be determined mainly based on functions and technical effects embodied/performed by the technical terms in the technical solutions.

A person of ordinary skill in the art may be aware that all or some of the methods in embodiments of this application may be implemented by using software, hardware, firmware, or any combination thereof. When the software is used to implement the methods, all or some of the methods may be implemented in a form of a computer program product. The computer program product includes one or more computer programs or instructions. When the computer programs or the instructions are loaded and executed on a computer, the procedures or functions in embodiments of this application are all or partially executed. The computer may be a general-purpose computer, a dedicated computer, a computer network, or another programmable apparatus. The computer programs or the instructions may be stored in a computer-readable storage medium, or may be transmitted through the computer-readable storage medium. The computer-readable storage medium may be any usable medium accessible by the computer, or a data storage device, for example, a server, integrating one or more usable media.

It may be clearly understood by a person skilled in the art that, for convenient and brief description, for detailed working processes of the foregoing system, apparatus, and unit, refer to the corresponding processes in the foregoing method embodiments. Details are not described herein again.

In the several embodiments provided in this application, it should be understood that the disclosed systems, apparatuses, and methods may be implemented in other manners. For example, the foregoing apparatus embodiments are merely examples. For example, the unit division is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic form, a mechanical form, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, the functional units in embodiments of this application may be integrated into one processing unit, each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to an existing technology, or a part of the technical solutions may be implemented in a form of a software product. The computer software product is stored in a storage medium and includes several instructions for instructing a computer device (which may be a personal computer, a server, a network device, or the like) to perform all or some of the steps of the methods in embodiments of this application. The foregoing storage medium includes a USB flash drive, a removable hard disk, a read-only memory (read-only memory, ROM), or random access.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A signal transmission method, wherein the method comprises:

   receiving, by a terminal device, first information, wherein the first information comprises a first field, the first field is used to determine a code length of a first mask, the code length of the first mask is comprised in a first value set, and the first value set comprises one or more of the following values: 2, 3, 4, 6, and 8;
   determining, by the terminal device, a reference signal based on the first mask; and
   receiving or sending, by the terminal device, the reference signal.

2. The method according to claim 1, wherein the first field is further used to determine a reference signal port number; or

the first information further comprises a second field, and the second field is used to determine a reference signal port number; and the method further comprises:
determining, by the terminal device, the reference signal port number based on the first field or the second field.

3. The method according to claim 2, wherein the first field or the second field indicates:

an offset value of the reference signal port number, wherein the offset value belongs to a second value set, and the second value set comprises one or more of the following values: 0, 4, 6, 8, and 12; or
a value set to which a port number of the reference signal belongs.

4. The method according to claim 3, wherein offset values of reference signal port numbers corresponding to at least two bit states in a bit status of the first field are the same; or
port numbers of reference signals corresponding to at least two bit states in a bit status of the first field belong to a same value set.

5. The method according to any one of claims 2 to 4, wherein the bit status of the first field comprises at least one of the following bit states:

a first bit state, indicating that the code length of the first mask is a first code length, and the offset value of the reference signal port number is a first offset value;
a second bit state, indicating that the code length of the first mask is a second code length, and the offset value of the reference signal port number is a first offset value; or
a third bit state, indicating that the code length of the first mask is a second code length, and the offset value of the reference signal port number is a second offset value.

6. The method according to any one of claims 2 to 4, wherein the bit status of the first field comprises at least one of the following bit states:

a first bit state, indicating that the code length of the first mask is a first code length, and the port number of the reference signal belongs to a third value set;
a second bit state, indicating that the code length of the first mask is a second code length, and the port number of the reference signal belongs to a third value set; or
a third bit state, indicating that the code length of the first mask is a second code length, and the port number of the reference signal belongs to a fourth value set.

7. The method according to claim 6, wherein the third value set and the fourth value set satisfy at least one of the following:

a quantity of number values comprised in the third value set is the same as a quantity of number values comprised in the fourth value set;
a number value in the fourth value set is determined based on a number value in the third value set and a first value, wherein the first value belongs to a fifth value set; or
a configuration type of a reference signal corresponding to the third value set is the same as a configuration type of a reference signal corresponding to the fourth value set.

8. The method according to claim 7, wherein the fifth value set comprises one or more of the following values: 4, 8, 6, and 12.

9. The method according to claim 8, wherein

when the configuration type of the reference signal is a first configuration type, the fifth value set comprises 8; or
when the configuration type of the reference signal is a second configuration type, the fifth value set comprises 12.

10. The method according to claim 5 or 6, wherein

the first information further comprises an antenna port field, and the antenna port field indicates a first physical resource; and
the bit status of the first field further comprises a fourth bit state, and the fourth bit state indicates:

no terminal device other than the terminal device performs data or signal transmission on the first physical resource.

11. The method according to claim 10, wherein at least one of the first bit state, the second bit state, or the third bit state further indicates: another terminal device other than the terminal device performs data or signal transmission on the first physical resource.

12. The method according to claim 5 or 6, wherein the bit status of the first field further comprises a fifth bit state, and the fifth bit state indicates:
a quantity of data streams corresponding to the reference signal is 3 or 4, and the code length of the first mask is the first code length or the second code length.

13. The method according to claim 12, wherein
at least one of the first bit state, the second bit state, or the third bit state further indicates: a quantity of data streams corresponding to the reference signal is 1 or 2.

14. The method according to claim 12 or 13, wherein the first information further comprises an antenna port field; and

when the bit status of the first field is the fifth bit state, a length of the antenna port field is m; or
when the bit status of the first field is the first bit state, the second bit state, or the third bit state, a length of the antenna port field is n, wherein
m and n are positive integers, and m is less than n.

15. The method according to claim 1, wherein the first information further indicates a first physical resource, and a bit status of the first field further comprises a sixth bit state and/or a seventh bit state, wherein

the sixth bit state indicates that the code length of the first mask is a first code length or a second code length, and no terminal device other than the terminal device performs data or signal transmission on the first physical resource; and
the seventh bit state indicates that the code length of the first mask is the first code length or the second code length, and another terminal device other than the terminal device performs data or signal transmission on the first physical resource.

16. The method according to claim 1, wherein a bit status of the first field further comprises an eighth bit state and/or a ninth bit state, wherein

the eighth bit state indicates that a quantity of data streams corresponding to the reference signal is 3, and the code length of the first mask is a second code length; and
the ninth bit state indicates that the quantity of data streams corresponding to the reference signal is 4, and the code length of the first mask is the second code length.

17. The method according to any one of claims 1 to 16, wherein the bit status of the first field further comprises a tenth bit state and/or an eleventh bit state, wherein

the tenth bit state indicates that the code length of the first mask is the first code length, a quantity of ports of the reference signal is 3 or 4, and time and/or frequency positions of reference signal resources corresponding to the ports of the reference signal are different; and
the eleventh bit state indicates that the code length of the first mask is the second code length, the quantity of ports of the reference signal is 3 or 4, and the time and/or frequency positions of the reference signal resources corresponding to the ports of the reference signal are the same.

18. The method according to any one of claims 1 to 16, wherein the bit status of the first field further comprises a twelfth bit state and/or a thirteenth bit state, wherein

the twelfth bit state indicates that the code length of the first mask is the first code length, a quantity of ports of the reference signal is greater than 4, and time and/or frequency positions of reference signal resources corresponding to the ports of the reference signal are different; and
the thirteenth bit state indicates that the code length of the first mask is the second code length, the quantity of ports of the reference signal is greater than 4, and the time and/or frequency positions of the reference signal resources corresponding to the ports of the reference signal are the same.

19. The method according to any one of claims 1 to 18, wherein the first code length is 2, and the second code length is 4.

20. The method according to any one of claims 1 to 19, wherein the reference signal comprises: an uplink DMRS and/or a downlink DMRS.

21. A signal transmission method, wherein the method comprises:

sending, by a network device, first information, wherein the first information comprises a first field, the first field is used to determine a code length of a first mask, the code length of the first mask is comprised in a first value set, and the first value set comprises one or more of the following values: 2, 3, 4, 6, and 8;
determining, by the network device, a reference signal based on the first mask; and
sending or receiving, by the network device, the reference signal.

22. The method according to claim 21, wherein the first field is further used to determine a reference signal port number; or

the first information further comprises a second field, and the second field is used to determine a reference signal port number; and
the method further comprises: determining, by the network device, the reference signal port number based on the first field or the second field.

23. The method according to claim 22, wherein the first field or the second field indicates:

an offset value of the reference signal port number, wherein the offset value belongs to a second value set, and the second value set comprises one or more of the following values: 0, 4, 6, 8, and 12; or
a value set to which a port number of the reference signal belongs.

24. The method according to claim 23, wherein

offset values of reference signal port numbers corresponding to at least two bit states in a bit status of the first field are the same; or
port numbers of reference signals corresponding to at least two bit states in a bit status of the first field belong to a same value set.

25. The method according to any one of claims 22 to 24, wherein the bit status of the first field comprises at least one of the following bit states:

a first bit state, indicating that the code length of the first mask is a first code length, and the offset value of the reference signal port number is a first offset value;
a second bit state, indicating that the code length of the first mask is a second code length, and the offset value of the reference signal port number is a first offset value; or
a third bit state, indicating that the code length of the first mask is a second code length, and the offset value of the reference signal port number is a second offset value.

26. The method according to any one of claims 22 to 24, wherein the bit status of the first field comprises at least one of the following bit states:

a first bit state, indicating that the code length of the first mask is a first code length, and the port number of the reference signal belongs to a third value set;
a second bit state, indicating that the code length of the first mask is a second code length, and the port number of the reference signal belongs to a third value set; or
a third bit state, indicating that the code length of the first mask is a second code length, and the port number of the reference signal belongs to a fourth value set.

27. The method according to claim 26, wherein the third value set and the fourth value set satisfy at least one of the following:

a quantity of number values comprised in the third value set is the same as a quantity of number values comprised in the fourth value set;

a number value in the fourth value set is determined based on a number value in the third value set and a first value, wherein the first value belongs to a fifth value set; or

a configuration type of a reference signal corresponding to the third value set is the same as a configuration type of a reference signal corresponding to the fourth value set.

28. The method according to claim 27, wherein the fifth value set comprises one or more of the following values: 4, 8, 6, and 12.

29. The method according to claim 28, wherein

when the configuration type of the reference signal is a first configuration type, the fifth value set comprises 8; or
when the configuration type of the reference signal is a second configuration type, the fifth value set comprises 12.

30. The method according to claim 25 or 26, wherein

the first information further comprises an antenna port field, and the antenna port field indicates a first physical resource; and
the bit status of the first field further comprises a fourth bit state, and the fourth bit state indicates:
no terminal device other than the terminal device performs data or signal transmission on the first physical resource.

31. The method according to claim 30, wherein
at least one of the first bit state, the second bit state, or the third bit state further indicates: another terminal device other than the terminal device performs data or signal transmission on the first physical resource.

32. The method according to claim 25 or 26, wherein the bit status of the first field further comprises a fifth bit state, and the fifth bit state indicates:
a quantity of data streams corresponding to the reference signal is 3 or 4, and the code length of the first mask is the first code length or the second code length.

33. The method according to claim 32, wherein
at least one of the first bit state, the second bit state, or the third bit state further indicates: a quantity of data streams corresponding to the reference signal is 1 or 2.

34. The method according to claim 32 or 33, wherein the first information further comprises an antenna port field; and

when the bit status of the first field is the fifth bit state, a length of the antenna port field is m; or
when the bit status of the first field is the first bit state, the second bit state, or the third bit state, a length of the antenna port field is n, wherein
m and n are positive integers, and m is less than n.

35. The method according to claim 21, wherein the first information further indicates a first physical resource, and a bit status of the first field further comprises a sixth bit state and/or a seventh bit state, wherein

the sixth bit state indicates that the code length of the first mask is a first code length or a second code length, and no terminal device other than the terminal device performs data or signal transmission on the first physical resource; and
the seventh bit state indicates that the code length of the first mask is the first code length or the second code length, and another terminal device other than the terminal device performs data or signal transmission on the first physical resource.

36. The method according to claim 21, wherein a bit status of the first field further comprises an eighth bit state and/or a ninth bit state, wherein

the eighth bit state indicates that a quantity of data streams corresponding to the reference signal is 3, and the code length of the first mask is a second code length; and

the ninth bit state indicates that the quantity of data streams corresponding to the reference signal is 4, and the code length of the first mask is the second code length.

37. The method according to any one of claims 21 to 36, wherein the bit status of the first field further comprises a tenth bit state and/or an eleventh bit state, wherein

the tenth bit state indicates that the code length of the first mask is the first code length, a quantity of ports of the reference signal is 3 or 4, and time and/or frequency positions of reference signal resources corresponding to the ports of the reference signal are different; and

the eleventh bit state indicates that the code length of the first mask is the second code length, the quantity of ports of the reference signal is 3 or 4, and the time and frequency positions of the reference signal resources corresponding to the ports of the reference signal are the same.

38. The method according to any one of claims 21 to 36, wherein the bit status of the first field further comprises a twelfth bit state and/or a thirteenth bit state, wherein

the twelfth bit state indicates that the code length of the first mask is the first code length, a quantity of ports of the reference signal is greater than 4, and time and/or frequency positions of reference signal resources corresponding to the ports of the reference signal are different; and

the thirteenth bit state indicates that the code length of the first mask is the second code length, the quantity of ports of the reference signal is greater than 4, and the time and frequency positions of the reference signal resources corresponding to the ports of the reference signal are the same.

39. The method according to any one of claims 21 to 38, wherein
the first code length is 2, and the second code length is 4.

40. The method according to any one of claims 21 to 39, wherein the reference signal comprises: an uplink DMRS and/or a downlink DMRS.

41. A communication apparatus, comprising a unit configured to perform steps of the method according to any one of claims 1 to 20 or claims 21 to 40.

42. A communication apparatus, comprising at least one processor and an interface circuit, wherein the at least one processor is configured to perform the method according to any one of claims 1 to 20 or claims 21 to 40.

43. A terminal device, comprising the communication apparatus according to claim 41 or 42.

44. A network device, comprising the communication apparatus according to claim 41 or 42.

45. A computer-readable storage medium, wherein the computer-readable storage medium stores a computer program or instructions, and when a computer reads and executes the computer program or the instructions, the computer is enabled to perform the method according to any one of claims 1 to 20 or the method according to any one of claims 21 to 40.

46. A chip, comprising a processor, configured to invoke a computer program from a memory and run the computer program, to enable a communication device mounted with the chip to perform the method according to any one of claims 1 to 20 or the method according to any one of claims 21 to 40.

RB

RE

Subcarrier
(frequency
domain)

OCC with a
length of 2 in
frequency
domain

1000

CDM
group 0

1001

1002

CDM
group 1

1003

Symbol (time domain)

RE to which a DMRS
sequence is mapped

FIG. 1

FIG. 2

RE to which a DMRS
sequence is mapped

FIG. 3

FIG. 4

Transmit device                    Receive device

FIG. 5

Method 600

| Network device | | Terminal device |
| --- | --- | --- |

S610: Send first information, where the first information includes a first field, the first field is used to determine a code length of a first mask, the code length of the first mask is included in a first value set, and the first value set includes one or more of the following values: 2, 3, 4, 6, and 8

S620: Determine a reference signal based on the first mask

S630: Send the reference signal

S640: Receive, based on the code length of the first mask used for the reference signal, the reference signal on a port corresponding to a port number of the reference signal

FIG. 6

Method 700

Network device | Terminal device

S710: Send second information, where the second information includes a third field, and the third field indicates a quantity of ports of a reference signal and a reference signal resource corresponding to the port of the reference signal, where when the quantity of ports of the reference signal is 3 or 4, time and frequency positions of the reference signal resources corresponding to the ports of the reference signal are the same; or when the quantity of ports of the reference signal is greater than 4, time and frequency positions of the reference signal resources corresponding to the ports of the reference signal are the same

S720: Determine, based on the second information, the quantity of ports of the reference signal and the reference signal resource corresponding to the port of the reference signal

S730: Send the reference signal

S740: Receive, based on the second information, the reference signal on a port corresponding to a port number of the reference signal

FIG. 7

Method 800

```
┌─────────────┐                                      ┌─────────────┐
│  Network    │                                      │  Terminal   │
│  device     │                                      │  device     │
└──────┬──────┘                                      └──────┬──────┘
       │                                                    │
       │  S810: Send DCI, where the DCI includes a fourth field
       │  and an antenna port field, the fourth field indicates that
       │  a quantity of data streams corresponding to a reference
       │   signal is 3 or 4, and the antenna port field indicates a
       │    port number of the reference signal used when the
       │         quantity of data streams is 3 or 4
       │ ─────────────────────────────────────────────────▶│
       │                                                    │
       │                                                    │
       │       S820: Send the reference signal              │
       │ ─────────────────────────────────────────────────▶│
       │                                                    │
       │                                    ┌───────────────┴──────────┐
       │                                    │ S830: Receive, based on the DCI,│
       │                                    │  the reference signal on a port │
       │                                    │ corresponding to the port number│
       │                                    │    of the reference signal      │
       │                                    └───────────────┬──────────┘
       │                                                    │
```

FIG. 8

Method 900

```
┌─────────────┐                                          ┌─────────────┐
│  Network    │                                          │  Terminal   │
│  device     │                                          │  device     │
└─────────────┘                                          └─────────────┘
```

S910: Send DCI, where the DCI includes a fifth field
and an antenna port field, the antenna port field
indicates a reference signal port number and a physical
resource, and the fifth field indicates that no terminal
device other than the terminal device or another
terminal device other than the terminal device
performs data or signal transmission on the physical
resource

S920: Send the reference signal

┌───────────────────────────────┐
│ S930: Receive, based on the DCI,│
│ the reference signal on a port  │
│ corresponding to the port number│
│ of the reference signal         │
└───────────────────────────────┘

FIG. 9

Method 1000

```
┌──────────┐                                                    ┌──────────┐
│ Network  │                                                    │ Terminal │
│ device   │                                                    │ device   │
└────┬─────┘                                                    └────┬─────┘
     │                                                               │
     │   S1010: Send higher layer signaling or DCI, where            │
     │      the higher layer signaling or the DCI indicates a        │
     │      type of a reference signal, and candidate types of       │
     │   the reference signal include at least a first type and      │
     │                    a second type                              │
     │ ─────────────────────────────────────────────────────────►   │
     │                                               ┌───────────────┴────────────┐
     │                                               │  S1020: Determine a first   │
     │                                               │ physical resource based on the│
     │                                               │  type of the reference signal │
     │                                               └───────────────┬────────────┘
     │                                               ┌───────────────┴────────────┐
     │                                               │  S1030: Receive or send the │
     │                                               │  reference signal on the first│
     │                                               │      physical resource       │
     │                                               └───────────────┬────────────┘
     │                                                               │
```

FIG. 10

```
┌─────────────────────────────────────────────┐
│ Communication apparatus 1100                │
│  ┌────────────────────────────────────────┐ │
│  │      Transceiver unit 1110             │ │
│  └────────────────────────────────────────┘ │
│  ┌────────────────────────────────────────┐ │
│  │      Processing unit 1120              │ │
│  └────────────────────────────────────────┘ │
└─────────────────────────────────────────────┘
```

FIG. 11

Communication
apparatus 1200

FIG. 12

FIG. 13

FIG. 14

Antenna

1501

Control circuit

1500

Memory

Processor

1502

Input/Output apparatus

FIG. 15

FIG. 16

## INTERNATIONAL SEARCH REPORT

| International application No. |
|---|
| **PCT/CN2023/103235** |

**A.    CLASSIFICATION OF SUBJECT MATTER**

H04L1/00(2006.01)i

According to International Patent Classification (IPC) or to both national classification and IPC

**B.    FIELDS SEARCHED**

Minimum documentation searched (classification system followed by classification symbols)

IPC: H04W H04L

Documentation searched other than minimum documentation to the extent that such documents are included in the fields searched

Electronic data base consulted during the international search (name of data base and, where practicable, search terms used)

CNTXT, ENTXT, DWPI, CNKI, 3GPP: 参考信号, 码分复用, 掩码, 覆盖码, 正交, 长度, 端口, 编号, 偏移, DMRS, CDM, code, OCC, orthogonal, length, port, number, shift, offset

**C.    DOCUMENTS CONSIDERED TO BE RELEVANT**

| Category* | Citation of document, with indication, where appropriate, of the relevant passages | Relevant to claim No. |
|---|---|---|
| X | CN 107925500 A (SAMSUNG ELECTRONICS CO., LTD.) 17 April 2018 (2018-04-17) description, paragraphs 172-178 | 1, 20-21, 40-46 |
| Y | CN 107925500 A (SAMSUNG ELECTRONICS CO., LTD.) 17 April 2018 (2018-04-17) description, paragraphs 172-178 | 2-3, 22-23 |
| Y | CN 108631998 A (HUAWEI TECHNOLOGIES CO., LTD.) 09 October 2018 (2018-10-09) description, paragraphs 168-177, 278, and 296 | 2-3, 22-23 |
| A | CN 106470087 A (CHINA MOBILE COMMUNICATIONS CORP.) 01 March 2017 (2017-03-01) entire document | 1-46 |
| A | US 2018026684 A1 (WEI, Chao et al) 25 January 2018 (2018-01-25) entire document | 1-46 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **11 September 2023** | **07 October 2023** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

INTERNATIONAL SEARCH REPORT
Information on patent family members

International application No.

**PCT/CN2023/103235**

| Patent document cited in search report | | | Publication date (day/month/year) | Patent family member(s) | | | Publication date (day/month/year) |
|---|---|---|---|---|---|---|---|
| CN | 107925500 | A | 17 April 2018 | WO | 2017039400 | A1 | 09 March 2017 |
| | | | | US | 2019207732 | A1 | 04 July 2019 |
| | | | | EP | 3346624 | A1 | 11 July 2018 |
| | | | | US | 2017201360 | A1 | 13 July 2017 |
| CN | 108631998 | A | 09 October 2018 | | None | | |
| CN | 106470087 | A | 01 March 2017 | US | 2019013916 | A1 | 10 January 2019 |
| | | | | EP | 3340515 | A1 | 27 June 2018 |
| | | | | WO | 2017028750 | A1 | 23 February 2017 |
| | | | | IN | 201817008512 | A | 01 June 2018 |
| US | 2018026684 | A1 | 25 January 2018 | JP | 2018510547 | A | 12 April 2018 |
| | | | | WO | 2016127309 | A1 | 18 August 2016 |
| | | | | EP | 3257210 | A1 | 20 December 2017 |
| | | | | WO | 2016127939 | A1 | 18 August 2016 |
| | | | | KR | 20170117051 | A | 20 October 2017 |
| | | | | IN | 201747023764 | A | 14 July 2017 |
| | | | | CN | 107431682 | A | 01 December 2017 |

Form PCT/ISA/210 (patent family annex) (July 2022)

**REFERENCES CITED IN THE DESCRIPTION**

**Patent documents cited in the description**

- CN 202210806852